# EUROPEAN PATENT APPLICATION

(11) **EP 4 648 590 A1**
(43) Date of publication of application: **12.11.2025**
(21) Application number: 23914978.4
(22) Date of filing: 19.12.2023
(51) Int. Cl.: H10K 59/131, H10K 59/88, H10K 59/126, H10K 71/00

(54) **DISPLAY DEVICE**

(30) Priority: 03.01.2023 KR 20230000667
(71) Applicant: Samsung Display Co., Ltd., Yongin-si, Gyeonggi-do 17113 (KR)
(72) Inventor: KIM, Su Jin, Yongin-Si Gyeonggi-do 17113 (KR); KA, Ji Hyun, Yongin-Si Gyeonggi-do 17113 (KR); HWANG, Sung Chan, Yongin-si Gyeonggi-do 17113 (KR); KANG, Chul Kyu, Yongin-si Gyeonggi-do 17113 (KR); KIM, Dong Hyun, Yongin-si Gyeonggi-do 17113 (KR); KIM, Min Joo, Yongin-Si Gyeonggi-do 17113 (KR); MOK, Seon Kyoon, Yongin-si Gyeonggi-do 17113 (KR)
(74) Representative: Marks & Clerk LLP
(86) International application number: PCT/KR2023/020967
(87) International publication number: WO 2024/147518

(57) **Abstract**

The present disclosure relates to a display device, and more particularly, to a display device capable of improving image quality by minimizing a parasitic capacitance between a repair line and a pixel electrode. According to an embodiment of the disclosure, a pixel electrode (PE3); a pixel circuit (PC3) connected to the pixel electrode; a repair line (RPL) overlapping at least a part of the pixel circuit; and a shielding line (SHL) overlapping at least a part of the repair line (RPL) and connected to a constant power source.

## Description

### [Technical Field]

The present invention relates to a display device which is especially capable of improving image quality by minimizing a parasitic capacitance between a repair line and a pixel electrode.

### [Background Art]

An organic light emitting display device includes a display element of which luminance is changed by current, for example, an organic light emitting diode.
Such an organic light emitting display device includes a plurality of pixels providing light of different colors.

### [Detailed Description of the Invention]

### [Technical Problem]

The problem to be solved by the present invention is to provide a display device which is especially capable of improving image quality by minimizing a parasitic capacitance between a repair line and a pixel electrode.

Additional features of embodiments will be set forth in the description which follows, and in part may be apparent from the description, or may be learned by practice of an embodiment or embodiments herein.

### [Technical Solution]

A display device according to one embodiment of the present invention for achieving the above objectives comprises: a pixel electrode (PE3); a pixel circuit (PC3) connected to the pixel electrode; a repair line (RPL) overlapping at least a part of the pixel circuit; and a shielding line (SHL) overlapping at least a part of the repair line (RPL) and connected to a constant power source.

In an embodiment, the shielding line overlaps at least a part of a remaining portion of the repair line (RPL) except for a repair short portion (RSP) of the repair line (RPL).

In an embodiment, the shielding line overlaps all remaining portions of the repair line (RPL) except for the repair short portion (RSP).

In an embodiment, the shielding line comprises: a line portion extending along a first direction; and at least one protrusion extending in a second direction crossing the first direction and overlapping at least a part of the repair line.

In an embodiment, the protrusion is provided in plurality, and a repair short portion of the repair line is disposed between adjacent protrusions (PP) of the shielding line.

In an embodiment, at least a part of the shielding line further overlaps the pixel electrode.

In an embodiment, at least a part of the shielding line is disposed between the repair line (RPL) and the pixel electrode.

In an embodiment, at least a part of the shielding line is disposed between the repair line (RPL) and the pixel electrode in an overlapping area between the repair line (RPL) and the pixel electrode.

In an embodiment, the shielding line and the repair line (RPL) are disposed on different layers.

In an embodiment, the display device further comprises at least one of a data line or a power line connected to the pixel circuit, wherein at least a part of the shielding line further overlaps at least one of the data line or the power line.

In an embodiment, the shielding line extends in a direction crossing at least one of the data line or the power line.

In an embodiment, the constant power source provides one of a reference voltage, an initialization voltage, a first driving voltage, and a second driving voltage.

In an embodiment, the shielding line is connected to the pixel circuit.

In an embodiment, the pixel circuit comprises a pixel connection electrode (PCE) connected to the pixel electrode, and the repair line at least partially overlaps the pixel connection electrode of the pixel circuit.

In an embodiment, the repair line is connected to the pixel connection electrode of the pixel circuit.

According to an embodiment of the disclosure, a display device comprises: a pixel electrode (PE3); a pixel circuit (PC3) connected to the pixel electrode; and a repair line (RPL) overlapping at least a part of the pixel circuit, wherein the repair line surrounds a part of the pixel electrode so as not to overlap the pixel electrode.

In an embodiment, the repair line has a concavo-convex shape in plan view.

In an embodiment, the repair line comprises: a concave portion (RG) defining a groove (140) in which the pixel electrode is disposed in plan view; and a convex portion (RP) in which the repair short portion (RSP) of the repair line is disposed in plan view.

In an embodiment, the concave portion surrounds a part of a first side surface of the pixel electrode, a part of a second side surface facing the first side surface, and a lower side surface of the pixel electrode in plan view.

In an embodiment, the groove has a U shape in plan view.

In an embodiment, each convex portion (RP) of the repair line (RPL) is disposed between adjacent pixel electrodes (PE1 to PE3), and each concave portion (RG) of the repair line (RPL) has a curved shape to bypass the pixel electrode and connect adjacent convex portions (RP) to each other in plan view.

According to an embodiment of the disclosure, a display device comprises: first and second pixel electrodes (PE1 and PE2); a repair line (RPL) overlapping the second pixel electrode without overlapping the first pixel electrode; and a shielding line (SHL) overlapping at least a part of the repair line and at least a part of the second pixel electrode and disposed between the repair line and the second pixel electrode.

In an embodiment, the shielding line (SHL) is connected to a constant power source.

In an embodiment, the constant power source provides one of a reference voltage, an initialization voltage, a first driving voltage, and a second driving voltage.

In an embodiment, the display device further comprises: a pixel circuit connected to one of the first and second pixel electrodes; and a data line and a power line connected to the pixel circuit, wherein at least a part of the shielding line further overlaps the data line and the power line.

In an embodiment, the shielding line extends in a direction crossing the data line and the power line.

In an embodiment, the shielding line comprises: a line portion extending along a first direction; and at least one protrusion extending in a second direction crossing the first direction and overlapping at least a part of the repair line and at least a part of the second pixel electrode.

In an embodiment, the protrusion of the shielding line is disposed between the repair line and the second pixel electrode in an overlapping area between the repair line and the second pixel electrode.

In an embodiment, the repair line surrounds a part of the first pixel electrode so as not to overlap the first pixel electrode.

In an embodiment, the repair line comprises: a concave portion defining a groove in which the first pixel electrode is disposed in plan view; and a convex portion in which a repair short portion of the repair line is disposed in plan view.

In an embodiment, each convex portion (RP) of the repair line (RPL) is disposed between a plurality of pixel electrodes comprising the first and second pixel electrodes in plan view, and each concave portion (RG) of the repair line (RPL) has a curved shape to bypass the first pixel electrode and connect adjacent convex portions (RP) to each other in plan view.

In an embodiment, the second pixel electrode overlaps the convex portion of the repair line.

Other features and embodiments may be apparent from the following detailed description, the drawings, and the claims.

### [Effects of the Invention]

The display device according to the present disclosure may improve image quality by minimizing the parasitic capacitance between the repair line and the pixel electrode.
Meanwhile, the effects obtainable from the present invention are not limited to the effects mentioned above, and other effects not mentioned can be clearly understood by a person having ordinary skill in the technical field to which the present invention belongs from the description below.

### [Brief Description of the Drawings]

FIG. 1 is a plan view schematically illustrating a part of a display device according to one embodiment of the present disclosure;
FIG. 2 is a schematic diagram of a display device according to one embodiment of the present disclosure;
FIG. 3 is a diagram illustrating a pixel circuit and a light emitting element of a pixel according to one embodiment of the present disclosure;
FIG. 4 is a view illustrating three pixels included in one unit pixel of a display device according to one embodiment of the present disclosure;
FIG. 5A is a plan view of a pixel array of a display device according to one embodiment of the present disclosure including the pixel circuit of FIG. 3;
FIG. 5B is a plan view of FIG. 5A in which pixel electrodes and emission areas are removed;
FIG. 5C is a plan view of FIG. 5A in which except for the reference numerals of the transistors and the reference numerals of the capacitors, the remaining reference numerals are removed;
FIG. 6 is an enlarged view of part A of FIG. 5A;
FIG. 7 is a plan view selectively showing only the first conductive layer among the components of FIG. 6;
FIG. 8 is a plan view selectively showing only the second conductive layer among the components of FIG. 6;
FIG. 9 is a plan view selectively showing only the third conductive layer among the components of FIG. 6;
FIG. 10 is a plan view selectively showing only the fourth conductive layer among the components of FIG. 6;
FIG. 11 is a plan view selectively showing only the fifth conductive layer among the components of FIG. 6;
FIG. 12 is a plan view selectively showing only the second and third conductive layers among the components of FIG. 6;
FIG. 13 is a plan view selectively showing only the first, third and fifth conductive layers among the components of FIG. 6;
FIG. 14 is a cross-sectional view taken along line I-I' of FIG. 6;
FIG. 15 is a cross-sectional view taken along line II-II' of FIG. 6;
FIG. 16 is a cross-sectional view taken along line III-III' of FIG. 6;
FIG. 17 is a cross-sectional view taken along line IV-IV' of FIG. 6;
FIG. 18 is a cross-sectional view taken along line V-V' of FIG. 6;
FIG. 19 is a cross-sectional view taken along line VI-VI' of FIG. 6;
FIG. 20 is a plan view of an array in which a plurality of unit pixels of FIG. 5A are disposed;
FIG. 21 is a diagram illustrating a pixel circuit and a light emitting element of a pixel according to one embodiment of the present disclosure;
FIG. 22A is a plan view of a pixel array of a display device according to one embodiment of the present disclosure including the pixel circuit of FIG. 21;
FIG. 22B is a plan view of FIG. 22A in which pixel electrodes and emission areas are removed;
FIG. 22C is a plan view of FIG. 22A in which except for the reference numerals of the transistors and the reference numerals of the capacitors, the remaining reference numerals are removed;
FIG. 23 is an enlarged view of part B of FIG. 22A;
FIG. 24 is a plan view selectively showing only the first conductive layer among the components of FIG. 23;
FIG. 25 is a plan view selectively showing only the second conductive layer among the components of FIG. 23;
FIG. 26 is a plan view selectively showing only the third conductive layer among the components of FIG. 23;
FIG. 27 is a plan view selectively showing only the fourth conductive layer among the components of FIG. 23;
FIG. 28 is a plan view selectively showing only the fifth conductive layer among the components of FIG. 23;
FIG. 29 is a plan view selectively showing only the sixth conductive layer among the components of FIG. 23;
FIG. 30 is a plan view selectively showing only the seventh conductive layer among the components of FIG. 23;
FIG. 31 is a plan view selectively showing only the third and fourth conductive layers among the components of FIG. 23;
FIG. 32 is a plan view selectively illustrating only the first, third, and seventh conductive layers among the components of FIG. 23;
FIG. 33 is a cross-sectional view taken along line I-I' of FIG. 23;
FIG. 34 is a cross-sectional view taken along line II-II' of FIG. 23;
FIG. 35 is a cross-sectional view taken along line III-III' of FIG. 23;
FIG. 36 is a cross-sectional view taken along line IV-IV' of FIG. 23;
FIG. 37 is a cross-sectional view taken along line V-V' of FIG. 23;
FIG. 38 is a cross-sectional view taken along line VI-VI' of FIG. 23;
FIG. 39 is a plan view of an array in which a plurality of unit pixels of FIG. 22A are disposed;
FIG. 40 is a diagram illustrating a pixel circuit and a light emitting element of a pixel according to one embodiment of the present disclosure;
FIG. 41A is a plan view of a pixel array of a display device according to one embodiment of the present disclosure including the pixel circuit of FIG. 40;
FIG. 41B is a plan view of FIG. 41A in which pixel electrodes and emission areas are removed;
FIG. 41C is a plan view of FIG. 41A in which except for the reference numerals of the transistors and the reference numerals of the capacitors, the remaining reference numerals are removed;
FIG. 42 is an enlarged view of part C of FIG. 41A;
FIG. 43 is a plan view selectively showing only the first conductive layer among the components of FIG. 42;
FIG. 44 is a plan view selectively showing only the second conductive layer among the components of FIG. 42;
FIG. 45 is a plan view selectively showing only the third conductive layer among the components of FIG. 42;
FIG. 46 is a plan view selectively showing only the fourth conductive layer among the components of FIG. 42;
FIG. 47 is a plan view selectively showing only the fifth conductive layer among the components of FIG. 42;
FIG. 48 is a plan view selectively showing only the sixth conductive layer among the components of FIG. 42;
FIG. 49 is a plan view selectively showing only the seventh conductive layer among the components of FIG. 42;
FIG. 50 is a plan view selectively showing only the third and fourth conductive layers among the components of FIG. 42;
FIG. 51 is a plan view selectively illustrating only the first, third, and seventh conductive layers among the components of FIG. 42;
FIG. 52 is a cross-sectional view taken along line I-I' of FIG. 42;
FIG. 53 is a cross-sectional view taken along line II-II' of FIG. 42;
FIG. 54 is a cross-sectional view taken along line III-III' of FIG. 42;
FIG. 55 is a plan view of an array in which a plurality of unit pixels of FIG. 41A are disposed;
FIG. 56 is a view illustrating three pixels included in one unit pixel of a display device according to one embodiment of the present disclosure;
FIG. 57 is a view illustrating three pixels included in one unit pixel of a display device according to one embodiment of the present disclosure;
FIG. 58 is a cross-sectional view illustrating a structure of a display element according to one embodiment of the present disclosure;
FIGS. 59 to 62 are cross-sectional views illustrating a structure of a light emitting element according to one embodiment;
FIG. 63 is a cross-sectional view illustrating an example of the organic light emitting diode of FIG. 61;
FIG. 64 is a cross-sectional view illustrating an example of the organic light emitting diode of FIG. 62;
FIG. 65 is a cross-sectional view illustrating a structure of a pixel of a display device according to one embodiment of the present disclosure; and
FIGS. 66 to 68 are diagrams for explaining the effects of the present disclosure.

### [Mode for Carrying Out the Invention]

The advantages and features of the present invention, as well as the methods for achieving them, will become clear by referring to the embodiments described in detail below in conjunction with the accompanying drawings. However, the present invention is not limited to the embodiments disclosed herein and can be implemented in various forms. The embodiments are merely provided to ensure a complete understanding of the disclosure and to fully convey the scope of the invention to those skilled in the art, and the invention is defined only by the claims.

The reference to an element or layer being "on" another element or layer includes both cases where it is directly on the other element and where another layer or element is interposed in between. Throughout the specification, the same reference numerals denote the same components. The shapes, sizes, ratios, angles, numbers, etc., disclosed in the drawings for explaining the embodiments are exemplary and do not limit the invention to what is illustrated.

Although terms such as "first" and "second" are used to describe various components, these components are not limited by these terms. These terms are merely used to distinguish one component from another. Accordingly, the first component referred to below may also be the second component within the technical scope of the present invention.

The respective features of the various embodiments of the present invention may be partially or entirely combined or integrated, and technically diverse interactions and operations are possible. Each embodiment may be implemented independently of or in association with one another.

Hereinafter, specific embodiments will be described with reference to the accompanying drawings.

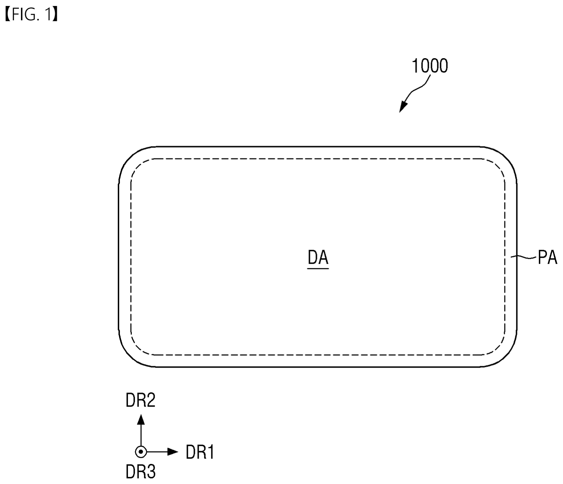

FIG. 1 is a plan view schematically illustrating a part of a display device according to one embodiment of the present disclosure.

The display device according to one embodiment of the present disclosure may include a display panel 1000 as illustrated in FIG. 1. Any display device including the display panel 1000 may be used as the display device. For example, the display device may be various products such as a smart phone, a tablet, a laptop, a television, or a billboard. The display panel 1000 may include a display area DA and a peripheral area PA (or non-display area) outside the display area DA.

The display area DA may be a portion for displaying an image, and a plurality of pixels may be disposed in the display area DA. When viewed in a direction (e.g., a third direction DR3) substantially perpendicular to the display panel 1000, the display area DA may have various shapes, such as an elliptical shape, a polygonal shape, or a shape of a specific figure. FIG. 1 illustrates that the display area DA has a substantially rectangular shape with rounded corners. The display panel 1000 included in the display device according to the present embodiment has the display area DA with a shape in which the length in a first direction DR1 that is a horizontal direction is longer than the length in a second direction DR2 that is a vertical direction. The fact that the display panel 1000 has the display area DA of such a shape may be understood as the substrate included in the display panel 1000 having the display area DA of such a shape. Various driving circuits may be positioned in the peripheral area PA of the display panel 1000.

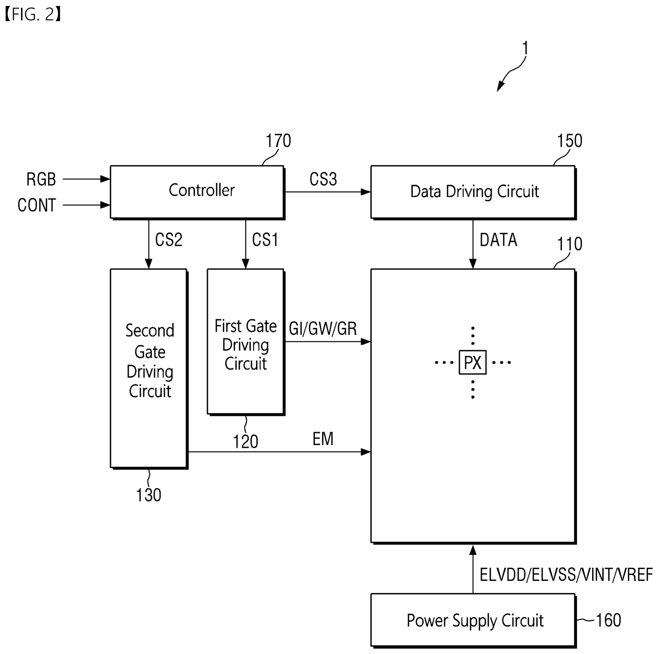

FIG. 2 is a schematic diagram of a display device according to one embodiment of the present disclosure.

Referring to FIG. 2, a display device 1 according to one embodiment may include a pixel unit 110, a first gate driving circuit 120, a second gate driving circuit 130, a data driving circuit 150, and a power supply circuit 160, and a controller 170.

The pixel unit 110 of the display device 1 may be provided in the display area DA (see FIG. 1). The first gate driving circuit 120, the second gate driving circuit 130, the data driving circuit 150, the power supply circuit 160, and the controller 170 may be provided in the peripheral area PA (see FIG. 1) of the display device 1.

A plurality of pixels PX may be disposed in the pixel unit 110. The plurality of pixels PX may be disposed in various shapes such as a stripe arrangement, a pentile arrangement, and a mosaic arrangement to implement an image. The pixel unit 110 may be disposed in the display area of the substrate. Each of the pixels PX may include a light emitting element LEL as a display element, and an organic light emitting diode (OLED) may be used as an example of the light emitting element. The light emitting element LEL may be connected to the pixel circuit. Each of the pixels PX may emit, for example, light of a red, green, blue, or white color through the light emitting element LEL.

In the pixel unit 110, a plurality of first scan lines GWL, second scan lines GIL, third scan lines GRL, and a plurality of emission control lines EML may be arranged in rows to be spaced apart from each other at regular intervals. Each of the first scan lines GWL, the second scan lines GIL, the third scan lines GRL, and the emission control lines EML may extend in the first direction DR1 (e.g., a row direction) to be connected to the pixels PX positioned in the same row. Each of the first scan lines GWL may transmit a first scan signal GW to the pixels PX in the same row. Each of the second scan lines GIL may transmit a second scan signal GI to the pixels PX in the same row. Each of the third scan lines GRL may transmit a third scan signal GR to the pixels PX in the same row. Each of the emission control lines EML may transmit an emission control signal EM to the pixels PX in the same row. In the pixel unit 110, a plurality of data lines may be arranged in columns to be spaced apart from each other at regular intervals. Each of the data lines may extend in the second direction DR2 (e.g., a column direction) to be connected to pixels PX positioned in the same column. Each of the data lines may transmit a data signal DATA to the pixels PX in the same column.

The display device 1 may support a variable refresh rate (VRR). The display device 1 may operate by changing a driving frequency within a range of a maximum driving frequency and a minimum driving frequency. Hereinafter, a mode in which the display device 1 operates at the maximum driving frequency is referred to as a normal mode (first driving mode), and a mode in which the display device 1 operates at a driving frequency lower than the maximum driving frequency (first driving frequency) is referred to as a low-speed driving mode (second driving mode). The display device 1 may operate in a low-speed driving mode to reduce power consumption. Each of the pixels PX may be driven in the first driving mode or the second driving mode.

The first gate driving circuit 120 may be connected to the first scan lines GWL, the second scan lines GIL, and the third scan lines GRL of the pixel unit 110, and may apply the first scan signal GW, the second scan signal GI, and the third scan signal GR to the first scan lines GWL, the second scan lines GIL, and the third scan lines GRL, respectively according to a first control signal CS1. When the first scan signal GW, the second scan signal GI, and the third scan signal GR have on-voltages, the transistor of the pixel PX connected to the corresponding scan line is turned on. In the second driving mode, the first gate driving circuit 120 may supply the first scan signal GW and the third scan signal GR to the pixel unit 110 according to the first driving frequency, and may supply the second scan signal GI to the pixel unit 110 according to the maximum driving frequency.

The second gate driving circuit 130 may be connected to the plurality of emission control lines EML of the pixel unit 110, and may apply the emission control signal EM to the emission control lines EML according to a second control signal CS2. In the second driving mode, the second gate driving circuit 130 may supply the emission control signal EM to the pixel unit 110 according to the maximum driving frequency.

The data driving circuit 150 may be connected to a plurality of data lines of the pixel unit 110, and may apply the data signal DATA indicating a grayscale to the data lines according to a third control signal CS3. The data driving circuit 150 may convert input image data having a grayscale inputted from the controller 170 into a data signal in the form of voltage or current.

The power supply circuit 160 may generate voltages necessary for driving the pixel PX. For example, the power supply circuit 160 may generate a first driving voltage ELVDD, a second driving voltage ELVSS, a reference voltage VREF, and an initialization voltage VINT. The power supply circuit 160 may apply the first driving voltage ELVDD, the second driving voltage ELVSS, the reference voltage VREF, and the initialization voltage VINT to the pixels PX of the pixel unit 110.

A level of the first driving voltage ELVDD may be higher than a level of the second driving voltage ELVSS. The level of the reference voltage VREF may be lower than the level of the first driving voltage ELVDD. The initialization voltage VINT may be a voltage at which the light emitting element LEL (e.g., an organic light emitting diode) may be turned off. In one embodiment, the level of the initialization voltage VINT may be less than or equal to the level of the second driving voltage ELVSS. In another embodiment, the level of the initialization voltage VINT may be higher than the level of the second driving voltage ELVSS, and the level difference between the initialization voltage VINT and the second driving voltage ELVSS may be smaller than the threshold voltage required for the display element of the pixel PX to emit light.

The controller 170 may control the pixel unit 110 by controlling operation timings of the first gate driving circuit 120, the second gate driving circuit 130, and the data driving circuit 150. The controller 170 may receive image data RGB and a control signal CONT for controlling the display of the image data RGB from an external graphic controller (not illustrated). The control signal CONT may include, for example, at least one of a vertical synchronization signal Vsync, a horizontal synchronization signal Hsync, a data enable signal DE, or a clock signal CLK. The controller 170 may generate the first to third the control signals CS1, CS2, and CS3 according to the control signal CONT to be respectively transmitted to the first gate driving circuit 120, the second gate driving circuit 130, and the data driving circuit 150. The image data RGB includes luminance information of the pixels PX. The luminance may have a predetermined number of gray scales, for example, 1024 (= 2¹⁰), 256 (= 2⁸), or 64 (= 2⁶).

Although the first gate driving circuit 120 and the second gate driving circuit 130 are illustrated separately in FIG. 1, in another embodiment, the first gate driving circuit 120 and the second gate driving circuit 130 may be implemented as one gate driving circuit to output the first scan signal GW, the second scan signal GI, the third scan signal GR, and the emission control signal EM.

The first gate driving circuit 120, the second gate driving circuit 130, the data driving circuit 150, the power supply circuit 160, and the controller 170 may be formed in the form of respective separate integrated circuit chips or one integrated circuit chip, and may be directly mounted on a substrate on which the pixel unit 110 is formed, be mounted on a flexible printed circuit film, be attached to a substrate in the form of a tape carrier package (TCP), or be directly formed on a substrate.

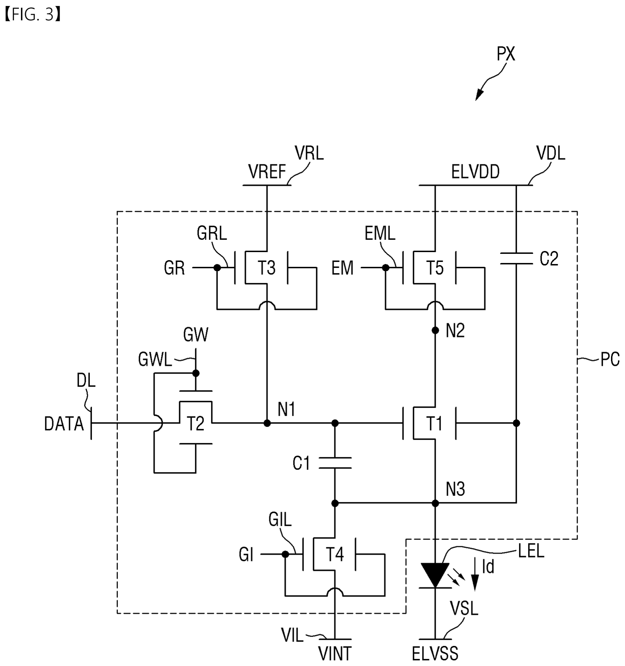

FIG. 3 is a diagram illustrating a pixel circuit and a light emitting element of a pixel according to one embodiment of the present disclosure.

Referring to FIG. 3, the pixel PX may include the light emitting element LEL (e.g., an organic light emitting diode) as a display element and a pixel circuit PC connected to the light emitting element LEL. The pixel circuit PC may include first to fifth transistors T1 to T5 and first and second capacitors C1 and C2. The first transistor T1 may be a driving transistor in which a size of a source-drain current is determined according to a gate-source voltage, and the second to fifth transistors T2 to T5 may be a switching transistor that is turned on/off according to the gate-source voltage, substantially a gate voltage. The first to fifth transistors T1 to T5 may be implemented as thin film transistors. According to the type (p-type or n-type) and/or the operating condition of the transistor, the first electrode of each of the first to fifth transistors T1 to T5 may be a source electrode or a drain electrode, and the second electrode may be an electrode different from the first electrode. For example, when the first electrode is the source electrode, the second electrode may be the drain electrode.

The pixel PX may be connected to the first scan line GWL that transmits the first scan signal GW, the second scan line GIL that transmits the second scan signal GI, the third scan line GRL that transmits the third scan signal GR, the emission control line EML that transmits the emission control signal EM, and a data line DL that transmits the data signal DATA. A first driving voltage line VDL may transmit the first driving voltage ELVDD to the first transistor T1. The initialization voltage line VIL may transmit the initialization voltage VINT to the light emitting element LEL (e.g., an organic light emitting diode). A reference voltage line VRL may transmit the reference voltage VREF to the gate electrode of the first transistor T1. Meanwhile, depending on the pixel structure, the initialization voltage line VIL described above may include a plurality of initialization voltage lines (e.g., a first initialization voltage line and a second initialization voltage line) that transmit initialization voltages of different sizes.

A plurality of first to fifth transistors T1 to T5 may include an oxide semiconductor material. Since the oxide semiconductor has high carrier mobility and low leakage current, the voltage drop is not large although the driving time is long. That is, in the case of an oxide semiconductor, since a color change of an image due to a voltage drop is not large even during low-frequency driving, low-frequency driving is possible. Accordingly, a display device preventing the generation of leakage current and having reduced power consumption may be implemented by the plurality of first to fifth transistors T1 to T5 including an oxide semiconductor material. In addition, in the case of using an oxide semiconductor transistor, a crystallization process by excimer laser annealing (ELA) is not required to form a low-temperature polycrystalline silicon (LTPS) semiconductor transistor, and thus the manufacturing cost of the display panel 1000 may be reduced, so that it is advantageous for implementation of a large-area display device.

The oxide semiconductor is sensitive to light, so that a fluctuation in current amount and the like may occur due to light from the outside. Accordingly, it may be considered to absorb or reflect light from the outside by positioning a metal layer under the oxide semiconductor. The metal layer positioned below the oxide semiconductor of each of the first to fifth transistors T1 to T5 may function as an opposite gate electrode (e.g., a counter gate electrode). That is, the first to fifth transistors T1 to T5 may be double gate transistors having two gate electrodes (e.g., a first gate electrode GE1 and a second gate electrode GE2, or a gate electrode and a counter gate electrode). The first gate electrode GE1 and the second gate electrode GE2 may be disposed to face each other on different layers. For example, each of the first to fifth transistors T1 to T5 may be an N-channel oxide semiconductor transistor, and the first gate electrode GE1 and the second gate electrode GE2 of each of the first to fifth transistors T1 to T5 may be positioned to face each other with an oxide semiconductor interposed therebetween.

The first transistor T1 includes the first gate electrode GE1 connected to a first node N1 (or gate node), the second gate electrode GE2 connected to a third node N3, a first electrode connected to a second node N2, and a second electrode connected to the third node N3. The second gate electrode GE2 of the first transistor T1 may be connected to the second electrode of the first transistor T1 to be controlled by a voltage applied to the second electrode of the first transistor T1, and may improve the output saturation characteristics of the first transistor T1. The first electrode of the first transistor T1 may be connected to the first driving voltage line VDL via the fifth transistor T5, and the second electrode may be connected to the pixel electrode of the light emitting element LEL. The first transistor T1 may serve as a driving transistor, and may control the magnitude (e.g., current amount) of a driving current Id flowing to the light emitting element LEL by receiving the data signal DATA according to the switching operation of the second transistor T2.

The second transistor T2 (e.g., data writing transistor) includes the first gate electrode GE1 and the second gate electrode GE2 connected to the first scan line GWL, a first electrode connected to the data line DL, and a second electrode connected to the first node N1 (or the gate electrode of the first transistor T1). The second transistor T2 may be turned on according to the first scan signal GW transmitted to the first scan line GWL to electrically connect the data line DL to the first node N1, and may transmit the data signal DATA transmitted to the data line DL to the first node N1.

The third transistor T3 (e.g., a first initialization transistor) includes the first gate electrode GE1 and the second gate electrode GE2 connected to the third scan line GRL, a first electrode connected to the reference voltage line VRL, and a second electrode connected to the first node N1 (or the gate electrode of the first transistor T1). The third transistor T3 may be turned on according to the third scan signal GR transmitted to the third scan line GRL and transmit the reference voltage VREF transmitted to the reference voltage line VRL to the first node N1.

The fourth transistor T4 (e.g., the second initialization transistor) includes the first gate electrode GE1 and the second gate electrode GE2 connected to the second scan line GIL, a first electrode connected to the third node N3 (or the second electrode of the first transistor T1), and a second electrode connected to the initialization voltage line VIL. The fourth transistor T4 may be turned on according to the second scan signal GI transmitted to the second scan line GIL and transmit the initialization voltage VINT transmitted to the initialization voltage line VIL to the third node N3.

The fifth transistor T5 (e.g., an emission control transistor) includes the first gate electrode GE1 and the second gate electrode GE2 connected to the emission control line EML, a first electrode connected to the first driving voltage line VDL, and a second electrode connected to the second node (or the first electrode of the first transistor T1). The fifth transistor T5 may be turned on or off according to the emission control signal EM transmitted to the emission control line EML.

The first capacitor C1 may be connected between the first node N1 and the third node N3. The first electrode of the first capacitor C1 may be connected to the gate electrode of the first transistor T1, and the second terminal thereof may be connected to the second gate electrode GE2 and the second electrode of the first transistor T1, the first electrode of the fourth transistor T4, and the pixel electrode (e.g., anode electrode) of the light emitting element LEL. The first capacitor C1 may be a storage capacitor and may store a voltage corresponding to a threshold voltage and a data signal of the first transistor T1.

The second capacitor C2 may be connected between the third node N3 and the first driving voltage line VDL. The first electrode of the second capacitor C2 may be connected to the first driving voltage line VDL, and the second electrode thereof may be connected to the second gate electrode GE2 and the second electrode of the first transistor T1, the second electrode of the first capacitor C1, the first electrode of the fourth transistor T4, and the pixel electrode of the light emitting element LEL. The capacitance of the first capacitor C1 may be greater than the capacitance of the second capacitor C2.

The light emitting element LEL may include a pixel electrode (e.g., an anode electrode) and a counter electrode (e.g., a cathode electrode) facing the pixel electrode, and the counter electrode may be applied with the second driving voltage ELVSS. The counter electrode may be connected to a second driving voltage line VSL transmitting a second driving voltage. The counter electrode may be a common electrode CM commonly shared by the plurality of pixels PX.

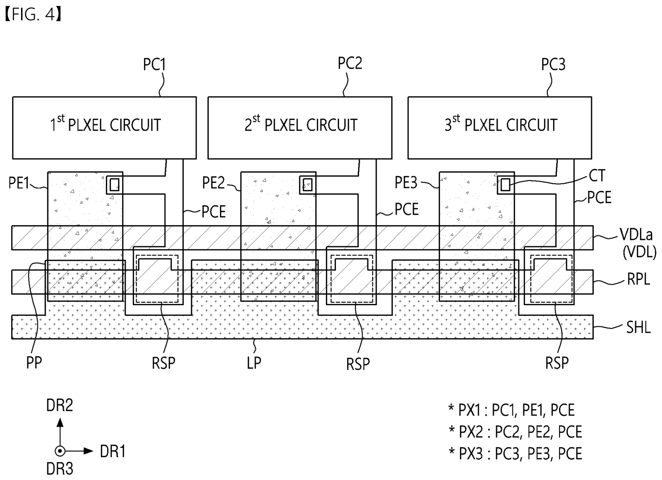

FIG. 4 is a view illustrating three pixels included in one unit pixel of a display device according to one embodiment of the present disclosure.

One unit pixel may include, for example, a first sub-pixel PX1 (hereinafter referred to as a first pixel), a second sub-pixel PX2 (hereinafter referred to as a second pixel), and a third sub-pixel PX3 (hereinafter referred to as a third pixel).

Each of the pixels PX1 to PX3 may include a light emitting element and a pixel circuit connected to the light emitting element (e.g., an anode electrode of the light emitting element corresponding to a pixel electrode). For example, the first pixel PX1 may include a first pixel circuit PC1 and a first pixel electrode PE1 of a first light emitting element connected to the first pixel circuit PC1, the second pixel PX2 may include a second pixel circuit PC2 and a second pixel electrode PE2 of a second light emitting element connected to the second pixel circuit PC2, and the third pixel PX3 may include a third pixel circuit PC3 and a third pixel electrode PE3 of a third light emitting element connected to the third pixel circuit PC3.

The pixel electrodes PE1 to PE3 may be connected to the pixel circuits PC1 to PC3, respectively. For example, the pixel electrodes PE1 to PE3 may be connected to the pixel circuits PC1 to PC3 through the pixel connection electrodes PCE of the pixel circuits PC1 to PC3, respectively. For example, the first pixel electrode PE1 may be connected to the first pixel circuit PC1 through the pixel connection electrode PCE of the first pixel circuit PC1, the second pixel electrode PE2 may be connected to the second pixel circuit PC2 through the pixel connection electrode PCE of the second pixel circuit PC2, and the third pixel electrode PE3 may be connected to the third pixel circuit PC3 through the pixel connection electrode PCE of the third pixel circuit PC3. In this case, each of the pixel electrodes PE1 to PE3 may be connected to the corresponding pixel circuit through a corresponding contact hole CT.

A repair line RPL may be used to repair a defective pixel, for example. The repair line RPL may overlap at least a part of each of the pixel circuits PC1 to PC3. For example, at least a part of the pixel connection electrode PCE of each of the pixel circuits PC1 to PC3 may overlap at least a part of the repair line RPL described above.

One side (or one end) of each of the pixel connection electrodes PCE may be connected to some components (e.g., the first transistor T1 and/or the fourth transistor T4) of each of the pixel circuits PC1 to PC3 and be connected to each of the pixel electrodes PE1 to PE3 through the corresponding contact hole CT, and the other side (or the other end) of each of the pixel connection electrodes PCE may be disposed on a corresponding repair short portion RSP to overlap the corresponding repair short portion RSP of the repair line RPL. For example, one side (or one end) of the pixel connection electrode PCE provided in the first pixel circuit PC1 may be connected to some components (e.g., the first transistor T1 and/or the fourth transistor T4) of the first pixel circuit PC1 and be connected to the first pixel electrode PE1 through the corresponding contact hole CT, and the other side (or the other end) of the pixel connection electrode PCE provided in the first pixel circuit PC1 may be disposed on the corresponding repair short portion RSP to overlap the corresponding repair short portion RSP of the repair line RPL.

Each of the pixel electrodes PE1 to PE3 may overlap the repair line RPL. For example, the first, second, and third pixel electrodes PE1 to PE3 may be disposed on the repair line RPL to overlap the repair line RPL in plan view.

At least a part of a shielding line SHL may be disposed on the repair line RPL to overlap at least a part of the repair line RPL in plan view, for example. As an example, at least a part of the shielding line SHL may be disposed between the repair line RPL and each of the pixel electrodes PE1 to PE3. In other words, at least a part of the shielding line SHL may be disposed between the repair line RPL and each of the pixel electrodes PE1 to PE3 to be positioned in an area in which the repair line RPL and each of the pixel electrodes PE1 to PE3 overlap (hereinafter, an overlapping area).

The shielding line SHL may include, for example, a line portion LP extending along the first direction DR1 (or the extension direction of the first scan line GWL) and at least one protrusion PP protruding from the line portion LP in the second direction DR2 (or an extension direction of the data line DL). The second direction DR2 may be a direction that crosses (or perpendicularly crosses) the first direction DR1. At this time, the protrusion PP of the shielding line SHL may be disposed between the repair line RPL and each of the pixel electrodes PE1 to PE3 to be positioned in an overlapping area between the repair line RPL and each of the pixel electrodes PE1 to PE3. As an example, the protrusion PP of the shielding line SHL may be disposed between the repair line RPL therebelow and the first pixel electrode PE1 thereabove in an overlapping area thereof (e.g., an area in which the first pixel electrode PE1 and the repair line RPL overlap each other).

The shielding line SHL may be connected to, for example, a constant power source. In other words, the shielding line SHL may receive a constant voltage and/or constant current of a constant level from the constant power source. For example, the shielding line SHL may be applied with any one of the first driving voltage ELVDD, the second driving voltage ELVSS, the initialization voltage VINT, and the reference voltage VREF described above.

Meanwhile, as another embodiment, the shielding line SHL may be formed by utilizing any one of the first driving voltage line VDL, the second driving voltage line VSL, the initialization voltage line VIL, and the reference voltage line VRL. For example, the reference voltage line VRL may be utilized as the shielding line SHL. However, in this case, at least a part of the reference voltage line VRL may be extended to overlap at least a part of the repair line RPL on the repair line RPL described above.

When a plurality of shielding lines SHL are provided, the first driving voltage line VDL, the second driving voltage line VSL, the initialization voltage line VIL, and the reference voltage line VRL described above may be utilized for the first shielding line, the second shielding line, the third shielding line, and the fourth shielding line, respectively.

As such, the shielding line SHL may be disposed on the repair line RPL to overlap the repair line RPL. For example, the shielding line SHL may be disposed between the repair line RPL and the pixel electrode to shield the repair line RPL. Accordingly, for example, the parasitic capacitance between the repair line RPL and the pixel electrode may be minimized, so that a voltage fluctuation of the repair line RPL may be reduced. For example, when a light emitting element of a pixel is turned on or off, the voltage of a pixel electrode of the pixel may fluctuate, and thus when the voltage of the pixel electrode fluctuates, the voltage of the repair line RPL may fluctuate due to a parasitic capacitor between the pixel electrode and the repair line RPL. Then, a fluctuation in the voltage of the repair line RPL may affect the voltage of a pixel electrode (e.g., a pixel electrode of a normal pixel) overlapping the repair line RPL. For example, the voltage of a pixel electrode of a normal pixel may fluctuate. However, the shielding line SHL disposed between the repair line RPL and the pixel electrodes PE1 to PE3 minimizes the effect of the parasitic capacitor, and thus the voltage fluctuation of the normal pixel may be minimized, so that image quality defects such as line stains may be prevented.

Meanwhile, the shielding line SHL may not overlap the repair short portion RSP of the repair line RPL. The repair short portion RSP of the repair line RPL is a portion to which laser and the like is irradiated during a repair process of a defective pixel (e.g., an unlit pixel), and the pixel connection electrode PCE of the defective pixel and the repair line RPL may be connected by the laser irradiation. Meanwhile, in the repair process, prior to the above laser irradiation, for example, a step of separating a connection between one side of the pixel connection electrode PCE of a defective pixel and the corresponding pixel circuit may be first performed. After the repair process, the pixel electrode of the defective pixel may be applied with a driving voltage through the repair line RPL instead of the pixel circuit. The repair line RPL may be connected to a separate dummy pixel, so that the dummy pixel may apply the aforementioned driving voltage to the repair line RPL.

Meanwhile, each of the pixel electrodes PE1 to PE3 may overlap a power line (e.g., a first lower driving voltage line VDLa of the first driving voltage line VDL).

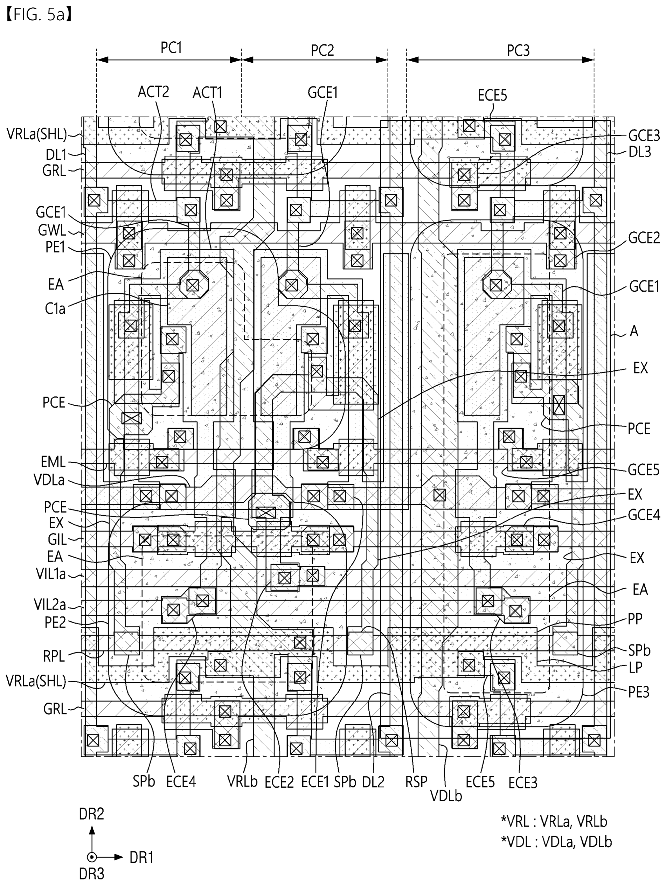

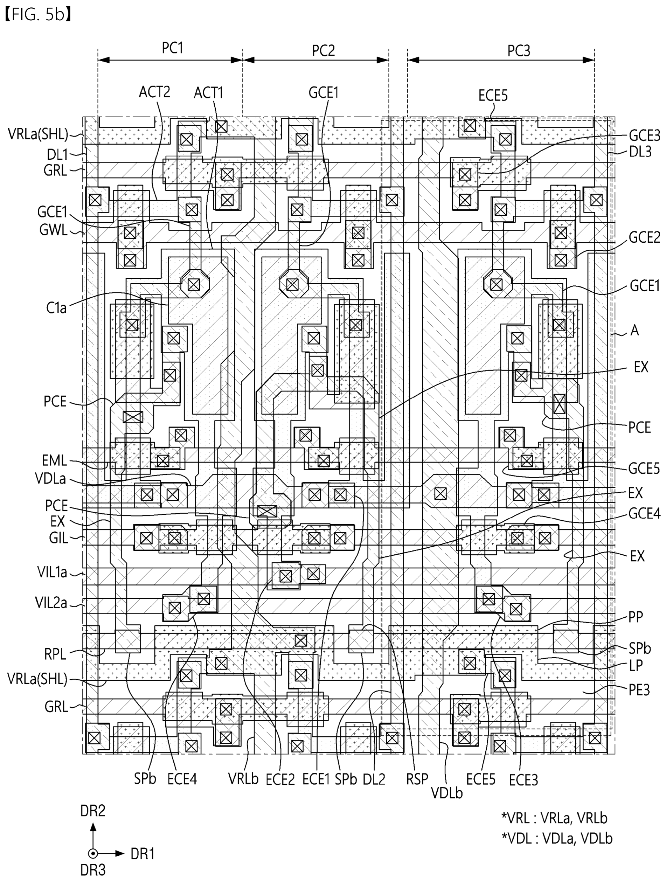

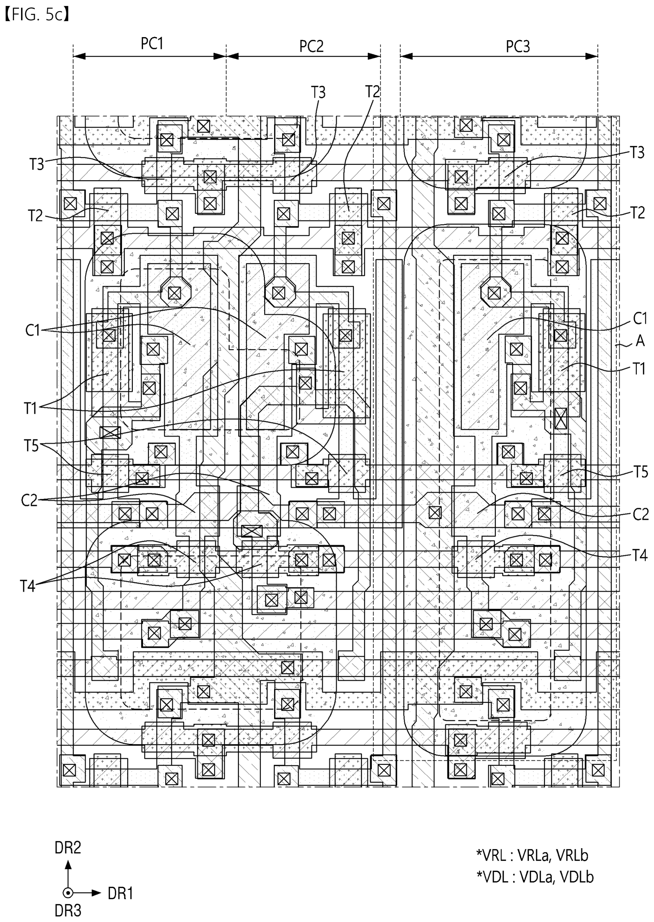

Hereinafter, various examples of the shielding line will be described in more detail with reference to FIGS. 5 to 57.

FIG. 5A is a plan view of a pixel array of a display device according to one embodiment of the present disclosure including the pixel circuit of FIG. 3, FIG. 5B is a plan view of FIG. 5A in which pixel electrodes and emission areas are removed, and FIG. 5C is a plan view of FIG. 5A in which except for the reference numerals of the transistors and the reference numerals of the capacitors, the remaining reference numerals are removed.

As illustrated in FIGS. 5A to 5C, the display device 1 according to one embodiment of the present disclosure may include the first to third pixel circuits PC1 to PC3 and the first to third pixel electrodes PE1 to PE3 respectively connected to the first to third pixel circuits PC1 to PC3.

Here, the first pixel circuit PC1 and the first pixel electrode PE1 may be the pixel circuit and the pixel electrode of the first pixel PX1, the second pixel circuit PC2 and the second pixel electrode PE2 may be the pixel circuit and the pixel electrode of the second pixel PX2, and the third pixel circuit PC3 and the third pixel electrode PE3 may be the pixel circuit and the pixel electrode of the third pixel PX3. Meanwhile, the first to third pixels PX1 to PX3 may form one unit pixel.

The first to third pixels PX1 to PX3 of the unit pixel may include light emitting layers providing light of different wavelengths. For example, the first pixel PX1 may include a light emitting layer that provides light of a first wavelength (e.g., light of a red wavelength), the second pixel PX2 may include a light emitting layer that provides light of a second wavelength (e.g., light of a green wavelength), and the third pixel PX3 may include a light emitting layer that provides light of a third wavelength (e.g., light of a blue wavelength).

The first wavelength may correspond to a red wavelength, the second wavelength may correspond to a green wavelength, and the third wavelength may correspond to a blue wavelength. However, the present disclosure is not limited thereto, and for example, the first wavelength may correspond to a green wavelength, the second wavelength may correspond to a red wavelength, and the third wavelength may correspond to a blue wavelength. For yet another example, the first wavelength may correspond to a green wavelength, the second wavelength may correspond to a blue wavelength, and the third wavelength may correspond to a red wavelength. For yet another example, the first wavelength may correspond to a blue wavelength, the second wavelength may correspond to a red wavelength, and the third wavelength may correspond to a green wavelength. For yet another example, the first wavelength may correspond to a blue wavelength, the second wavelength may correspond to a green wavelength, and the third wavelength may correspond to a red wavelength.

Each of the pixel circuits PC1 to PC3 of the pixels PX1 to PX3 may include the first to fifth transistors T1 to T5, the first capacitor C1, and the second capacitor C2. For example, each of the pixel circuits PC1 to PC3 of the first to third pixels PX1 to PX3 will be described in detail.

The first pixel circuit PC1 may include, for example, the first to fifth transistors T1 to T5, the first capacitor C1, and the second capacitor C2 disposed in a defined area surrounded by a first data line DL1, an upper reference voltage line VRLb, and two lower reference voltage lines VRLa adjacent in the second direction DR2. The first pixel circuit PC1 may be connected to, for example, the first pixel electrode PE1, the first data line DL1, the first scan line GWL, the second scan line GIL, the third scan line GRL, the first driving voltage line VDL, the reference voltage line VRL, and a second lower initialization voltage line VIL2a.

The second pixel circuit PC2 may include, for example, the first to fifth transistors T1 to T5, the first capacitor C1, and the second capacitor C2 disposed in a defined area surrounded by the upper reference voltage line VRLb, a second data line DL2, and the two lower reference voltage lines VRLa adjacent in the second direction DR2. The second pixel circuit PC2 may be connected to, for example, the second pixel electrode PE2, the second data line DL2, the first scan line GWL, the second scan line GIL, the third scan line GRL, the first driving voltage line VDL, the reference voltage line VRL, and a first lower initialization voltage line VIL1a.

The third pixel circuit PC3 may include, for example, the first to fifth transistors T1 to T5, the first capacitor C1, and the second capacitor C2 disposed in a defined area surrounded by a first upper driving voltage line VDLb, a third data line DL3, and the two lower reference voltage lines VRLa adjacent in the second direction DR2. The third pixel circuit PC3 may be connected to, for example, the third pixel electrode PE3, the third data line DL3, the first scan line GWL, the second scan line GIL, the third scan line GRL, the first driving voltage line VDL, the reference voltage line, and the second lower initialization voltage line VIL2a.

The reference voltage line VRL may include the lower reference voltage line VRLa and the upper reference voltage line VRLb connected to each other through a contact hole of an insulating layer. The lower reference voltage line VRLa (e.g., a shielding line) may extend along the first direction DR1. The lower reference voltage line VRLa may be connected to the third transistor T3 of each of the pixel circuits PC1 to PC3. For example, the lower reference voltage line VRLa may be connected to the first electrode (source electrode or drain electrode) of the third transistor T3 through a fifth line connection electrode ECE5. Meanwhile, depending on the pixel, the upper reference voltage line VRLb instead of the lower reference voltage line VRLa may be directly connected to the first electrode (source electrode or drain electrode) of the third transistor T3 without going through a separate line connection electrode. Meanwhile, the lower reference voltage line VRLa may perform a function as a shielding line as well as performing a function of transmitting a reference voltage. The upper reference voltage line VRLb may extend along the second direction DR2 crossing the first direction DR1. Accordingly, the reference voltage line VRL including the lower reference voltage line VRLa and the upper reference voltage line VRLb described above may have a mesh shape.

The first driving voltage line VDL may include the first lower driving voltage line VDLa and the first upper driving voltage line VDLb connected to each other through the contact hole of the insulating layer. The first lower driving voltage line VDLa may extend along the first direction DR1. The first lower driving voltage line VDLa may be connected to the fifth transistor T5 of each of the pixel circuits. For example, the first lower driving voltage line VDLa may be connected to the first electrode (e.g., a source electrode or a drain electrode) of the fifth transistor T5 through each first line connection electrode ECE1. The first upper driving voltage line VDLb may extend along the second direction DR2 crossing the first direction DR1. Accordingly, the first driving voltage line VDL including the first lower driving voltage line VDLa and the first upper driving voltage line VDLb described above may have a mesh shape.

The first lower initialization voltage line VIL1a may be connected to a first upper initialization voltage line through the contact hole of the insulating layer. The first lower initialization voltage line VIL1a and the first upper initialization voltage line may be disposed in directions crossing each other. Accordingly, the first initialization voltage line including the first lower initialization voltage line VIL1a and the first upper initialization voltage line may have a mesh shape. The first initialization voltage line configured as described above may transmit a first initialization voltage. The first lower initialization voltage line VILa may be connected to a pixel of any one color among the three pixels. For example, the first lower initialization voltage line VIL1a may be connected to the fourth transistor T4 of a green pixel (e.g., a second pixel including the second pixel circuit PC2) providing light corresponding to a green wavelength.

The second lower initialization voltage line VIL2a may be connected to a second upper initialization voltage line through the contact hole of the insulating layer. The second lower initialization voltage line VIL2a and the second upper initialization voltage line may be disposed in directions crossing each other. Accordingly, the second initialization voltage line including the second lower initialization voltage line VIL2a and the second upper initialization voltage line may have a mesh shape. The second initialization voltage line configured as described above may transmit a second initialization voltage. The second initialization voltage may be, for example, the same as the first initialization voltage described above, and differently, the second initialization voltage may be smaller or greater than the second initialization voltage. The second lower initialization voltage line VIL2a may be connected to pixels of two or more colors among the three pixels. For example, the second lower initialization voltage line VIL2a may be connected to the fourth transistor T4 of a red pixel (e.g., a first pixel including the first pixel circuit PC1) providing light corresponding to a red wavelength and to the fourth transistor T4 of a blue pixel (e.g., a third pixel including the third pixel circuit PC3) providing light corresponding to a blue wavelength.

The first scan line GWL may extend along the first direction DR1. The first scan line GWL may be connected to the second transistor T2 of each of the pixel circuits PC1 to PC3. For example, the first scan line GWL may be connected to the gate electrode of each second transistor T2 through each second gate connection electrode GCE2.

The second scan line GIL may extend along the first direction DR1. The second scan line GIL may be connected to the fourth transistor T4 of each of the pixel circuits. For example, the second scan line GIL may be connected to the gate electrode of each fourth transistor T4 through each fourth gate connection electrode GCE4.

The third scan line GRL may extend along the first direction DR1. The third scan line GRL may be connected to the third transistor T3 of each of the pixel circuits PC1 to PC3. For example, the third scan line GRL may be connected to the gate electrode of each third transistor T3 through each third gate connection electrode GCE3.

The emission control line EML may extend along the first direction DR1. The emission control line EML may be connected to the fifth transistor T5 of each of the pixel circuits PC1 to PC3. For example, the emission control line EML may be connected to the gate electrode of each fifth transistor T5 through each fifth gate connection electrode GCE5.

The first data line DL1 may extend along the second direction DR2. The first data line DL1 may be connected to the second transistor T2 of the first pixel circuit PC1. For example, the first data line DL1 may be connected to a first electrode (e.g., a source electrode or a drain electrode) of the second transistor T2 through the contact hole of the insulating layer.

The second data line DL2 may extend along the second direction DR2. The second data line DL2 may be connected to the second transistor T2 of the second pixel circuit PC2. For example, the second data line DL2 may be connected to a first electrode (e.g., a source electrode or a drain electrode) of the second transistor T2 through the contact hole of the insulating layer.

The third data line DL3 may extend along the second direction DR2. The third data line DL3 may be connected to the second transistor T2 of the third pixel circuit PC3. For example, the third data line DL3 may be connected to a first electrode (e.g., a source electrode or a drain electrode) of the second transistor T2 through the contact hole of the insulating layer.

The repair line RPL may extend along the first direction DR1. A detailed description of the repair line RPL will be described in more detail below.

A first lower capacitor electrode C1a together with a first semiconductor layer ACT1 may constitute the first capacitor C1. For example, a portion of the first semiconductor layer ACT1 overlapping the first lower capacitor electrode C1a may correspond to a first upper capacitor electrode C1b of the first capacitor C1.

A second lower capacitor electrode C2a together with the first semiconductor layer ACT1 may constitute the second capacitor C2. For example, a portion of the first semiconductor layer ACT1 overlapping the second lower capacitor electrode C2a may correspond to a second upper capacitor electrode C2b of the second capacitor C2.

Meanwhile, although not illustrated in FIG. 5A, a second driving voltage line extending along the second direction DR2 may be further disposed.

A part of each of the first pixel electrode PE1, the second pixel electrode PE2, and the third pixel electrode PE3 may be exposed by a bank to be described later. For example, the bank may include a first opening EA (hereinafter referred to as a first emission area) exposing a part of the first pixel electrode PE1, a second opening EA (hereinafter referred to as a second emission area) exposing a part of the second pixel electrode PE2, and a third opening EA (hereinafter referred to as a third emission area) exposing a part of the third pixel electrode PE3. Each of the emission areas EA may correspond to a portion excluding an edge of a corresponding pixel electrode.

Among the pixel electrodes PE1 to PE3 included in one unit pixel, the third pixel electrode PE3 may have the largest area. In other words, among the three pixels of one unit pixel, the third pixel (e.g., the pixel including the third pixel circuit PC3) may include the pixel electrode having the largest area (e.g., the third pixel electrode PE3).

One side surface of the first pixel electrode PE1 may have a stepped portion. For example, one side surface facing the third pixel electrode PE3 among the surfaces of the first pixel may include stepped surfaces having height differences. Accordingly, the first pixel electrode PE1 may not overlap a first gate connection electrode GCE1 of another pixel (e.g., the second pixel including the second pixel circuit PC2). In other words, the first pixel electrode PE1 may only overlap the first gate connection electrode GCE1 of the first pixel PX1 to which the first pixel electrode PE1 belongs, but may not overlap the first gate connection electrodes GCE1 of other pixels. In addition, the second pixel electrode PE2 does not overlap not only the first gate connection electrode GCE1 of the second pixel PX2 to which the second pixel electrode PE2 belongs but also the first gate connection electrodes GCE1 of other pixels, and the third pixel electrode PE3 only overlaps the first gate connection electrode GCE1 of the third pixel PX3 to which the third pixel electrode PE3 belongs but does not overlap the gate connection electrodes of other pixels. Accordingly, the parasitic capacitance among neighboring pixels due to the overlap between the gate connection electrode and the pixel electrode of other pixels may be minimized, so that the light emitting luminance of the pixel may be improved.

The pixel connection electrode PCE of each of the pixels PX1 to PX3 may include an extension portion EX extending in a reverse direction (hereinafter referred to as a second reverse direction) of the second direction DR2, so that each extension portion EX may overlap the repair line RPL. For example, an end of each of the extension portion EX of the pixel connection electrode PCE connected to the first pixel electrode PE1, the extension portion EX of the pixel connection electrode PCE connected to the second pixel electrode PE2, and the extension portion EX of the pixel connection electrode PCE connected to the third pixel electrode PE3 may include a counter short portion SPb, so that in order to overlap each of the repair short portions RSP of the repair line RPL, the counter short portion SPb of each of the extension portions EX may be disposed on the corresponding repair short portion RSP. As an example, the counter short portion SPb of each of the extension portions EX may be disposed on the corresponding repair short portion RSP of the repair line RPL.

The repair line RPL may extend along the first direction DR1. The repair line RPL may be overlapped by the lower reference voltage line VRLa adjacent thereto in the second direction DR2. For example, the lower reference voltage line VRLa may be disposed adjacent to the repair line RPL.

At least a part of the lower reference voltage line VRLa may be disposed on the repair line RPL to overlap at least a part of the repair line RPL in plan view, for example. As an example, at least a part of the lower reference voltage line VRLa may be disposed between the repair line RPL and the second and third pixel electrodes. In other words, at least a part of the lower reference voltage line VRLa may be disposed between the repair line RPL and the pixel electrodes to be positioned in an overlapping area between the repair line RPL and the pixel electrodes.

The lower reference voltage line VRLa may include, for example, the line portion LP extending along the first direction DR1 (e.g., the extension direction of the first scan line GWL) and at least one protrusion PP protruding from the line portion LP in the second direction DR2 (e.g., the extension direction of the first data line DL1). The second direction DR2 may be a direction that crosses (or perpendicularly crosses) the first direction DR1. In this case, the protrusion PP of the lower reference voltage line VRLa may be disposed between the repair line RPL and each of the pixel electrodes to be positioned in an overlapping area between the repair line RPL and each of the pixel electrodes. As an example, the protrusion PP of the lower reference voltage line VRLa may be disposed between the repair line RPL therebelow and the second pixel electrode PE2 thereabove in an overlapping area thereof (e.g., an overlapping area between the second pixel electrode PE2 and the repair line RPL), and the other protrusion PP of the lower reference voltage line VRLa may be disposed between the repair line RPL therebelow and the third pixel electrodes PE3 thereabove in an overlapping area thereof (e.g., an overlapping area between the third pixel electrode PE3 and the repair line RPL).

Meanwhile, the lower reference voltage line VRLa may transmit, for example, a constant power (e.g., a constant voltage). As an example, FIG. 5A illustrates an example in which the lower reference voltage line VRLa is used as a shielding line. However, the present disclosure is not limited thereto, and for example, the shielding line may include at least one of the first driving voltage line VDL, the second driving voltage line VSL, a first initialization voltage line (e.g., the first lower initialization voltage line VILla), or a second initialization voltage line (e.g., the second lower initialization voltage line VIL2a) described above. For example, the second lower initialization voltage line VIL2a immediately adjacent to the repair line RPL in the second direction DR2 may be used as a shielding line. However, in this case, the second lower initialization voltage line VIL2a may be disposed on a layer different from the repair line RPL (e.g., a layer on which the lower initialization voltage line is disposed). In this case, at least a part of the second lower initialization voltage line VIL2a may be disposed in an overlapping area of the repair line RPL and each of the pixel electrodes.

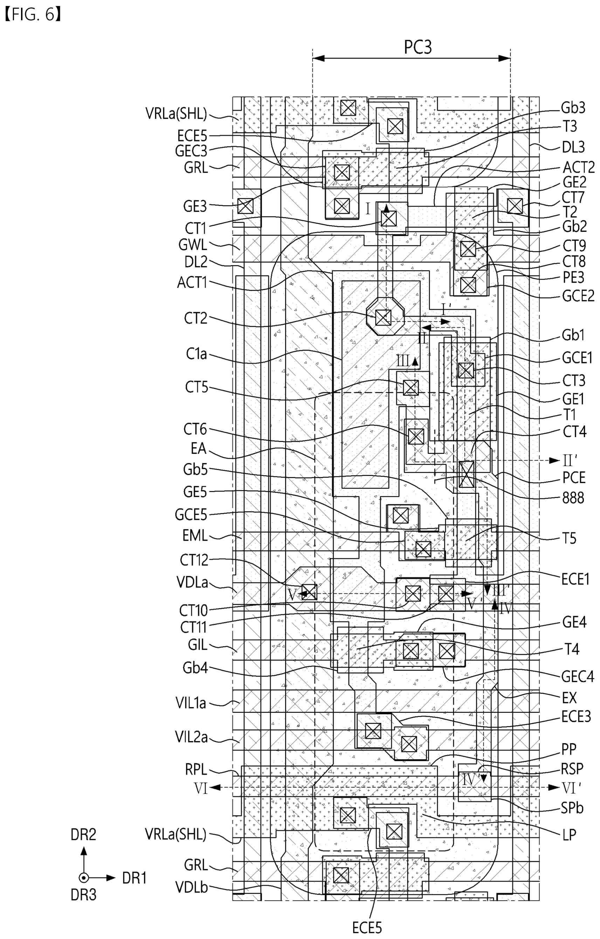

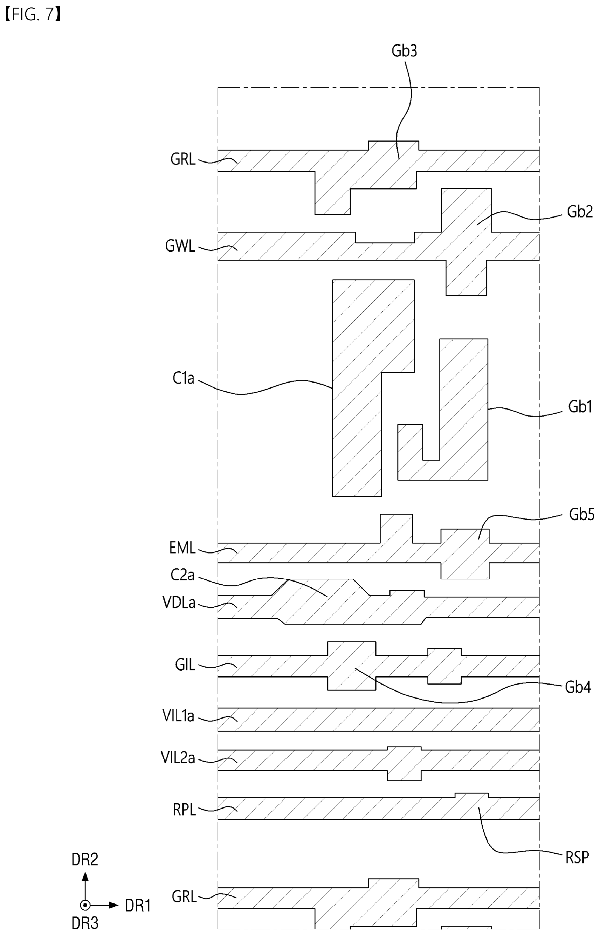

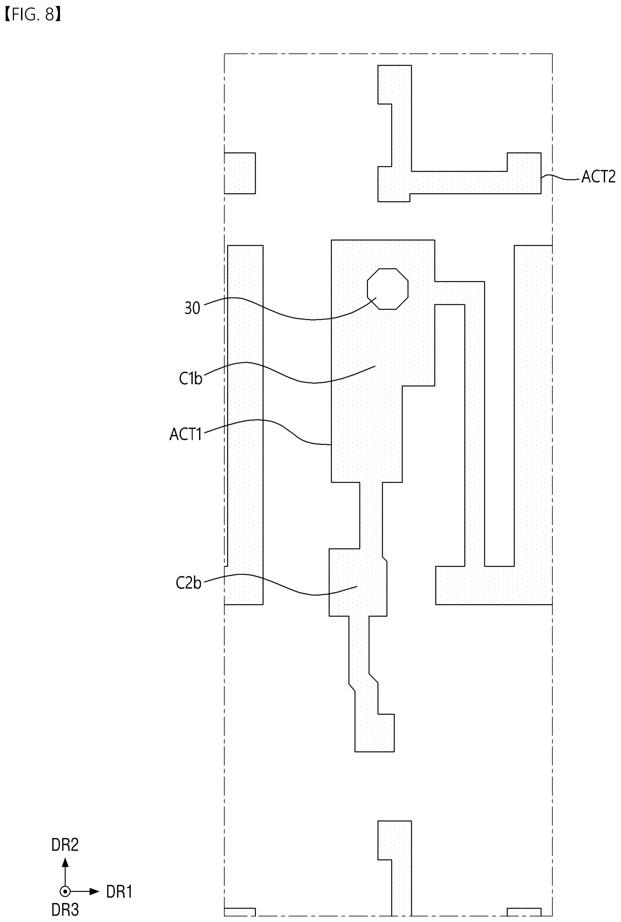

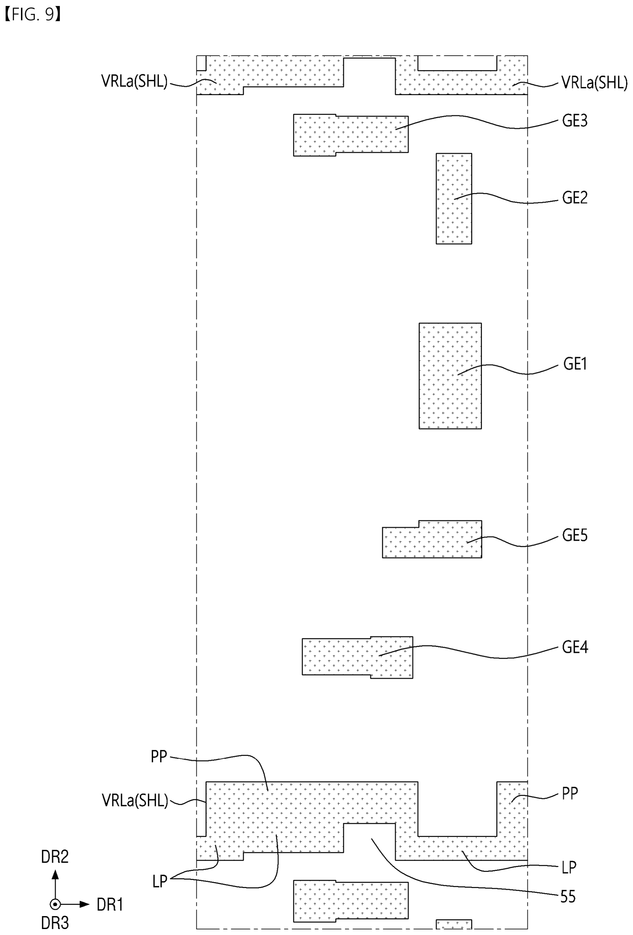

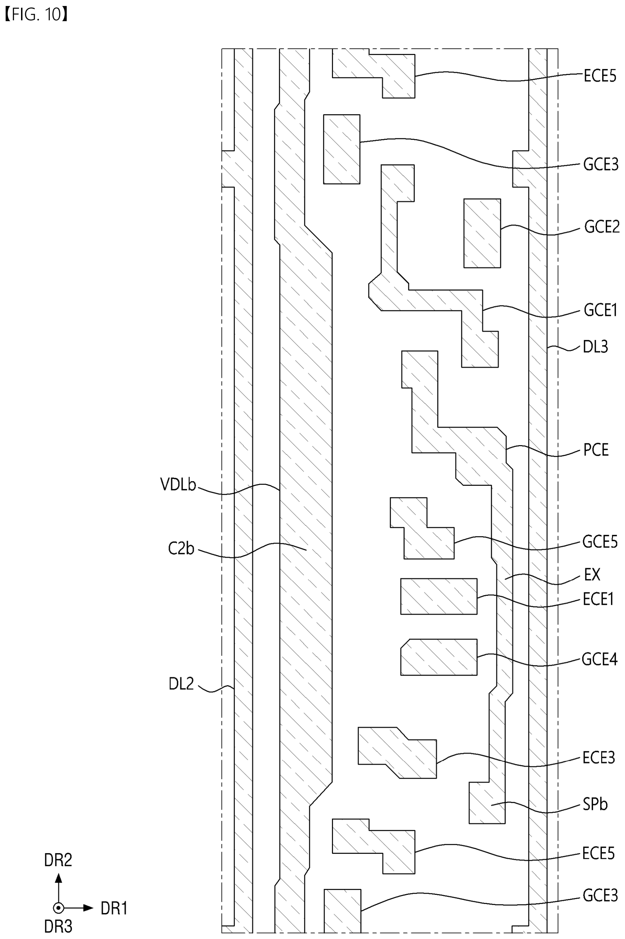

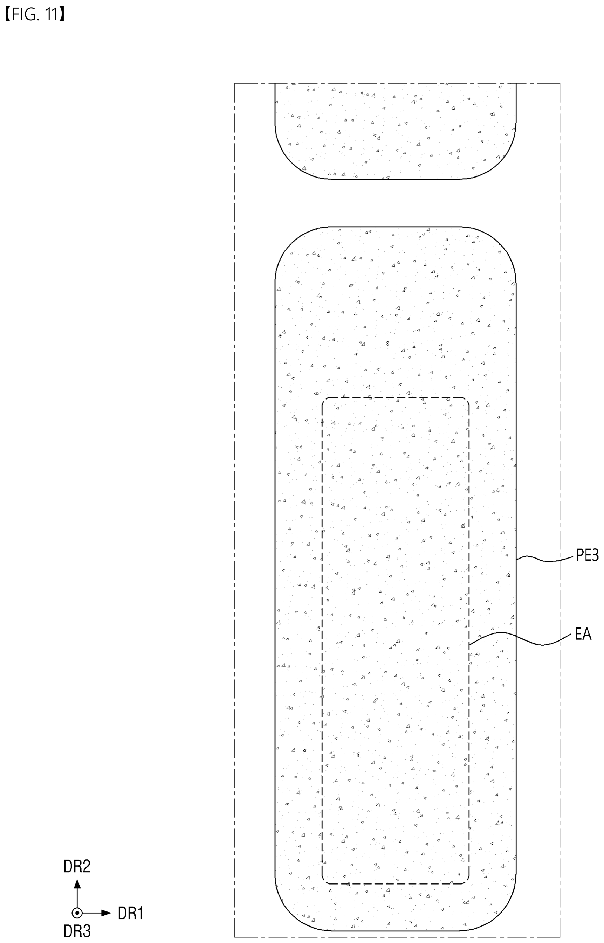

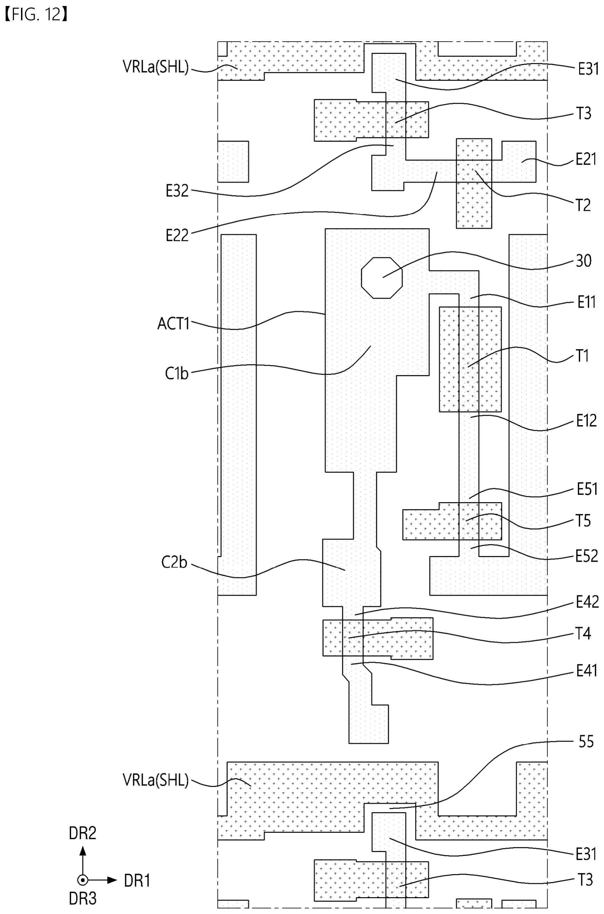

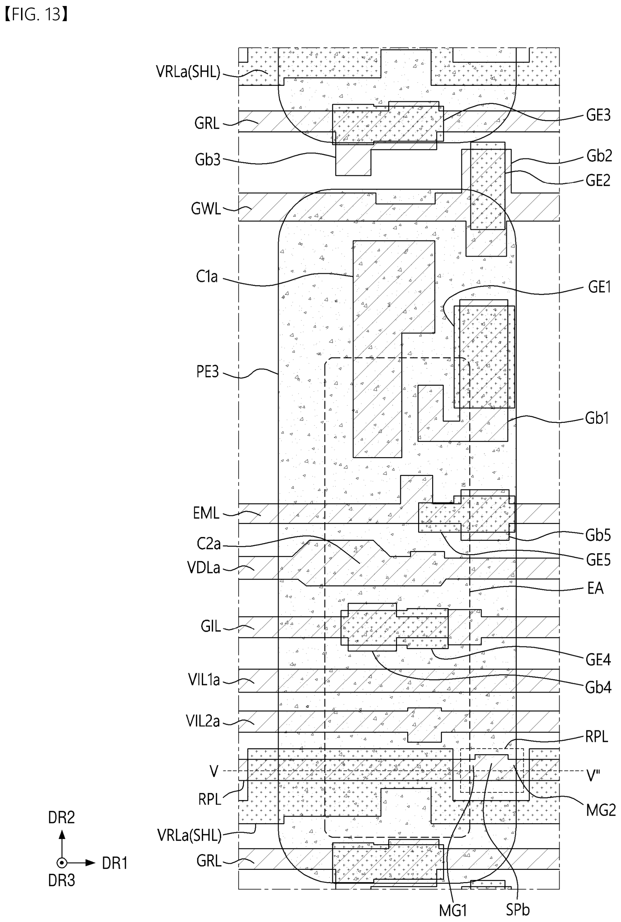

FIG. 6 is an enlarged view of part A of FIG. 5A. For example, FIG. 6 is an enlarged view of a third pixel including the third pixel circuit PC3 and the third pixel electrode PE3 of FIG. 5A. FIG. 7 is a plan view selectively showing only the first conductive layer among the components of FIG. 6, FIG. 8 is a plan view selectively showing only the second conductive layer among the components of FIG. 6, FIG. 9 is a plan view selectively showing only the third conductive layer among the components of FIG. 6, FIG. 10 is a plan view selectively showing only the fourth conductive layer among the components of FIG. 6, FIG. 11 is a plan view selectively showing only the fifth conductive layer among the components of FIG. 6, FIG. 12 is a plan view selectively showing only the second and third conductive layers among the components of FIG. 6, and FIG. 13 is a plan view selectively showing only the first, third and fifth conductive layers among the components of FIG. 6.

The first conductive layer illustrated in FIGS. 6 and 7 may be disposed on the substrate SUB along the third direction DR3. The first conductive layer may serve as a voltage line for transmitting various voltages, as the first lower capacitor electrode C1a, as the second lower capacitor electrode C2a, as a counter gate electrode of each of the transistors T1 to T5, and as a blocking layer for blocking light from being introduced into the channel region of each of the transistors T1 to T5. Meanwhile, among components included in the first conductive layer, the repair line RPL may be used to normalize a defective pixel.

As illustrated in FIGS. 6 and 7, the first conductive layer may include the third scan line GRL, the first scan line GWL, the first lower capacitor electrode C1a, a first counter gate electrode Gb1, the emission control line EML, the first lower driving voltage line VDLa, the second scan line GIL, the first lower initialization voltage line VIL1a, the second lower initialization voltage line VIL2a, and the repair line RPL. Here, each of the third scan line GRL, the first scan line GWL, the emission control line EML, the first lower driving voltage line VDLa, the second scan line GIL, the first lower initialization voltage line VIL1a, the second lower initialization voltage line VIL2a, and the repair line RPL may extend along the first direction DR1.

The third scan signal GR may be applied to the third scan line GRL, the first scan signal GW may be applied to the first scan line GWL, the emission control signal EM may be applied to the emission control line EML, the first driving voltage may be applied to the first lower driving voltage line VDLa, the second scan signal GI may be applied to the second scan line GIL, the first lower initialization voltage may be applied to the first lower initialization voltage line VIL1a, the second initialization voltage may be applied to the second lower initialization voltage line VIL2a, and the repair voltage may be applied to the repair line RPL.

The first lower capacitor electrode C1a may be disposed between, for example, the first scan line GWL and the emission control line EML. The first lower capacitor electrode C1a together with the first semiconductor layer ACT1 to be described later may constitute the first capacitor C1.

The second lower capacitor electrode C2a together with the first semiconductor layer ACT1 to be described later may constitute the second capacitor C2. Here, the second lower capacitor electrode C2a may be integrally formed with the first lower driving voltage line VDLa. The second lower capacitor electrode C2a may have a larger width (or line width) than other portions of the first lower driving voltage line VDLa. The aforementioned width may be, for example, the size in the second direction DR2.

A third counter gate electrode Gb3 may function as a counter gate electrode of the third transistor T3. Here, the third counter gate electrode Gb3 may be integrally formed with the third scan line GRL. The third counter gate electrode Gb3 may have a larger width (or line width) than other portions of the third scan line GRL. The aforementioned width may be, for example, the size in the second direction DR2.

A second counter gate electrode Gb2 may function as a counter gate electrode of the second transistor T2. Here, the second counter gate electrode Gb2 may be integrally formed with the first scan line GWL. The second counter gate electrode Gb2 may have a larger width (or line width) than other portions of the first scan line GWL. The aforementioned width may be, for example, the size in the second direction DR2.

A fifth counter gate electrode Gb5 may function as a counter gate electrode of the fifth transistor T5. Here, the fifth counter gate electrode Gb5 may be integrally formed with the emission control line EML. The fifth counter gate electrode Gb5 may have a larger width (or line width) than other portions of the emission control line EML. The aforementioned width may be, for example, the size in the second direction DR2.

A fourth counter gate electrode Gb4 may function as a counter gate electrode of the fourth transistor T4. In this case, the fourth counter gate electrode Gb4 may be integrally formed with the second scan line GIL. The fourth counter gate electrode Gb4 may have a larger width (or line width) than other portions of the second scan line GIL. The aforementioned width may be, for example, the size in the second direction DR2.

The first counter gate electrode Gb1 may function as a counter gate electrode of the first transistor T1. The first counter gate electrode Gb1 may be connected to the pixel electrode and the first semiconductor layer ACT1 through the pixel connection electrode PCE and the contact hole of the insulating layer. The first counter gate electrode Gb1 may be disposed, for example, between the first scan line GWL and the emission control line EML.

The repair line RPL may be disposed between, for example, the second lower initialization voltage line VIL2a and the third scan line GRL. The repair line RPL may include at least one repair short portion RSP in a part thereof. At least a part of the repair short portion RSP may have a larger width (e.g., line width) than other portions of the repair line RPL. The aforementioned width may mean, for example, the size in the second direction DR2.

The first conductive layer including the above-described components may be formed as a single layer or multiple layers made of any one of, for example, molybdenum (Mo), aluminium (Al), chromium (Cr), gold (Au), titanium (Ti), nickel (Ni), neodymium (Nd) and copper (Cu) or an alloy thereof. For another example, the light blocking layer BML may be an organic layer including a black pigment.

The second conductive layer illustrated in FIGS. 6 and 8 may be disposed on the first conductive layer along the third direction DR3, so that an insulating layer may be disposed between the first conductive layer and the second conductive layer.

The second conductive layer may be a semiconductor layer and may include the first semiconductor layer ACT1 and the second semiconductor layer ACT2 separated from each other, as illustrated in FIGS. 6 and 8.

As illustrated in FIG. 12, the first semiconductor layer ACT1 together with the gate electrodes to be described later may constitute the first transistor T1, the fourth transistor T4, and the fifth transistor T5. For example, the first semiconductor layer ACT1 may include a first electrode (e.g., one of a source electrode and a drain electrode) of the first transistor T1, a second electrode (e.g., the other of the source electrode and the drain electrode) of the first transistor T1, a channel region of the first transistor T1, a first electrode (e.g., one of a source electrode and a drain electrode) of the fourth transistor T4, a second electrode (e.g., the other of the source electrode and the drain electrode) of the fourth transistor T4, a channel region of the fourth transistor T4, a first electrode (e.g., one of a source electrode and a drain electrode) of the fifth transistor T5, a second electrode (e.g., the other of the source electrode and the drain electrode) of the fifth transistor T5, and a channel region of the fifth transistor T5.

In addition, the first semiconductor layer ACT1 may include the first upper capacitor electrode C1b and the second lower capacitor electrode C2a. The first upper capacitor electrode C1b together with the first lower capacitor electrode C1a described above may constitute the first capacitor C1. For example, the first capacitor C1 described above may be formed in an area in which the first lower capacitor electrode C1a and the first upper capacitor electrode C1b overlap.

In addition, the first semiconductor layer ACT1 may have at least one hole 30 penetrating the first semiconductor layer ACT1 along the third direction DR3. The inside of the hole 30 may be filled with an insulating layer (e.g., an interlayer insulating layer ITL) to be described later. The interlayer insulating layer ITL is disposed between the inner wall of the hole 30 and the outer wall of a contact hole, so that contact between the conductive layer passing through the contact hole of the interlayer insulating layer ITL and the first semiconductor layer ACT1 may be prevented.

The second semiconductor layer ACT2 together with gate electrodes to be described later may constitute the second transistor T2 and the third transistor T3. For example, the second semiconductor layer ACT2 may include a first electrode (e.g., one of a source electrode and a drain electrode) of the second transistor T2, a second electrode (e.g., the other of the source electrode and the drain electrode) of the second transistor T2, a channel region of the second transistor T2, a first electrode (e.g., one of a source electrode and a drain electrode) of the third transistor T3, a second electrode (e.g., the other of the source electrode and the drain electrode) of the third transistor T3, and a channel region of the third transistor T3.

The first and second semiconductor layers ACT1 and ACT2 may include polycrystalline silicon, monocrystalline silicon, low-temperature polycrystalline silicon, amorphous silicon, or an oxide semiconductor material. When the semiconductor layer includes polycrystalline silicon or an oxide semiconductor material, in the semiconductor layer, the first electrode (e.g., one of the source electrode and the drain electrode) and the second electrode (e.g., the other of the source electrode and the drain electrode described above) may be a conductive region (e.g., a source region and a drain region) that is doped with ions and has conductivity.

The third conductive layer illustrated in FIGS. 6 and 9 may be disposed on a second conductive layer along the third direction DR3, so that an insulating layer may be disposed between the second conductive layer and the third conductive layer.

The third conductive layer may include the lower reference voltage line VRLa and a plurality of gate electrodes GE1, GE2, GE3, GE4, and GE5 separated from each other. For example, the first gate electrode GE1 of the first transistor T1, the second gate electrode GE2 of the second transistor T2, the third gate electrode GE3 of the third transistor T3, the fourth gate electrode GE4 of the fourth transistor T4, and the fifth gate electrode GE5 of the fifth transistor T5 may be included.

As illustrated in FIGS. 6 and 12, the first gate electrode GE1 may be disposed to overlap the first counter gate electrode Gb1 with the first semiconductor layer ACT1 interposed therebetween, the second gate electrode GE2 may be disposed to overlap the second counter gate electrode Gb2 with the second semiconductor layer ACT2 interposed therebetween, the third gate electrode GE3 may be disposed to overlap the third counter gate electrode Gb3 with the second semiconductor layer ACT2 interposed therebetween, the fourth gate electrode GE4 may be disposed to overlap the fourth counter gate electrode Gb4 with the first semiconductor layer ACT1 interposed therebetween, and the fifth gate electrode GE5 may be disposed to overlap the fifth counter gate electrode Gb5 with the first semiconductor layer ACT1 interposed therebetween.

As described above, the lower reference voltage line VRLa may include the line portion LP and the protrusion PP. The line portion LP may extend along the first direction DR1, and the protrusion PP may extend from the line portion LP in the second direction DR2.

Meanwhile, the lower reference voltage line VRLa as a shielding line may have a groove 55 at a lower portion of the line portion LP thereof. For example, the first electrode E31 of the third transistor T3 may be disposed in the groove 55. Specifically, a connection portion (e.g., a contact hole) between the first electrode E31 of the third transistor T3 and the fifth line connection electrode ECE5 may be disposed in the groove 55.

The third conductive layer may be formed as a single layer or multiple layers made of any one of, for example, molybdenum (Mo), aluminium (Al), chromium (Cr), gold (Au), titanium (Ti), nickel (Ni), neodymium (Nd) and copper (Cu) or an alloy thereof.

The fourth conductive layer illustrated in FIGS. 6 and 10 may be disposed on the third conductive layer along the third direction DR3, so that an insulating layer may be disposed between the third conductive layer and the fourth conductive layer.

As illustrated in FIG. 10, the fourth conductive layer may include the second data line DL2, the first upper driving voltage line VDLb, and the third data line DL3 extending along the second direction DR2, and the pixel connection electrode PCE, the extension portion EX, the first gate connection electrode GCE1, the second gate connection electrode GCE2, the third gate connection electrode GCE3, the fourth gate connection electrode GCE4, the fifth gate connection electrode GCE5, the first line connection electrode ECE1, the third line connection electrode ECE3, the fifth line connection electrode ECE5, and the second upper capacitor electrode C2b.

The first data line DL1 may be applied with the first data signal, the third data line DL3 may be applied with the third data signal, and the first upper driving voltage line VDLb may be applied with the first driving voltage.

The second upper capacitor electrode C2b together with the second lower capacitor electrode C2a described above may constitute the second capacitor C2. For example, the second capacitor C2 may be formed in an area in which the second upper capacitor electrode C2b and the second lower capacitor electrode C2a overlap. Here, the second upper capacitor electrode C2b may be part of the first upper driving voltage line VDLb. For example, a portion of the first upper driving voltage line VDLb overlapping the second lower capacitor electrode C2a of the first semiconductor layer ACT1 described above may correspond to the second upper capacitor electrode C2b.

Meanwhile, although not illustrated, the fourth conductive layer may further include the first upper initialization voltage line, the second upper initialization voltage line, and the second driving voltage line VSL described above. Each of the first upper initialization voltage line, the second upper initialization voltage line, and the second driving voltage line VSL may extend along the second direction DR2. Here, a first initialization voltage may be applied to the first upper initialization voltage line, a second initialization voltage may be applied to the second upper initialization voltage line, and a second driving voltage may be applied to the second driving voltage line VSL.

The first to third data lines DL1 to DL3 may be respectively connected to the corresponding second semiconductor layer ACT2 through the contact holes of the insulating layer.

The first gate connection electrode GCE1 may connect the first gate electrode GE1 of the first transistor T1 to the second transistor T2, the third transistor T3 and the first lower capacitor electrode C1a through the contact hole of the insulating layer.

The second gate connection electrode GCE2 may connect the second gate electrode GE2 of the second transistor T2 to the first scan line GWL through the contact hole of the insulating layer.

The third gate connection electrode GCE3 may connect the third gate electrode GE3 of the third transistor T3 to the third scan line GRL through the contact hole of the insulating layer.

The fourth gate connection electrode GCE4 may connect the fourth gate electrode GE4 of the fourth transistor T4 to the second scan line GIL through the contact hole of the insulating layer.

The fifth gate connection electrode GCE5 may connect the fifth gate electrode GE5 of the fifth transistor T5 to the emission control line EML through the contact hole of the insulating layer.

The first line connection electrode ECE1 may connect a first electrode E51 (e.g., a source electrode or a drain electrode) of the fifth transistor T5 and the first lower driving voltage line VDLa to each other through the contact holes of the insulating layer.

The third line connection electrode ECE3 may connect a second electrode E42 (e.g., a source electrode or a drain electrode) of the fourth transistor T4 provided in the third pixel circuit PC3 (or the first pixel circuit PC1) and the second lower initialization voltage line VIL2a to each other through the contact holes of the insulating layer.

The fifth line connection electrode ECE5 may connect the first electrode E31 (e.g., a source electrode or a drain electrode) of the third transistor T3 and the second lower initialization voltage line VIL2a to each other through the contact holes of the insulating layer.

Meanwhile, the second line connection electrode ECE2 may connect the second electrode E42 (e.g., a source electrode or a drain electrode) of the fourth transistor T4 provided in the second pixel circuit PC2 and the first lower initialization voltage line VIL1a to each other through the contact holes of the insulating layer.

The pixel connection electrode PCE may include the extension portion EX. An end of the extension portion EX (e.g., the counter short portion SPb of the extension portion EX) may overlap the repair short portion RSP of the repair line RPL.

The fifth conductive layer illustrated in FIGS. 6 and 11 may be disposed on the fourth conductive layer along the third direction DR3, so that an insulating layer may be disposed between the fourth conductive layer and the fifth conductive layer.

The fifth conductive layer may include the first to third pixel electrodes PE1 to PE3. FIGS. 6 and 11 illustrate the third pixel electrode PE3 as an example of the fourth conductive layer.

Among the first to third pixel electrodes PE1 to PE3, the third pixel electrode PE3 may have the largest area.

Parts of the first pixel electrode PE1, the second pixel electrode PE2, and the third pixel electrode PE3 may be respectively exposed by the first emission area EA, the second emission area EA, and the third emission area of a bank to be described later.

Each of the first to third pixel electrodes PE1 to PE3 may be connected to the first counter gate electrode Gb1 of the first transistor T1 through the corresponding pixel connection electrode PCE and the corresponding contact hole of the insulating layer. For example, the third pixel electrode PE3 may be connected to the first counter gate electrode Gb1 of the first transistor T1 through the pixel connection electrode PCE and the contact hole of the insulating layer.

As illustrated in FIG. 13, in plan view, the repair line RPL, the lower reference voltage line VRLa above the repair line RPL, and the third pixel electrode PE3 above the repair line RPL may overlap each other. In this case, the repair line RPL, the lower reference voltage line VRLa, and the third pixel electrode PE3 may be sequentially disposed along the third direction DR3. In other words, the lower reference voltage line VRLa may be disposed between the repair line RPL and the third pixel electrode PE3. In particular, the lower reference voltage line VRLa may overlap most of the repair line RPL in the third emission area. Accordingly, most of the overlapping area between the repair line RPL and the third pixel electrode PE3 in the emission area may be covered by the lower reference voltage line VRLa. Meanwhile, as another embodiment, the lower reference voltage line VRLa may entirely overlap the repair line RPL positioned in the third emission area. In this case, the lower reference voltage line VRLa may entirely cover all the overlapping areas between the repair line RPL and the pixel electrode in the emission area.

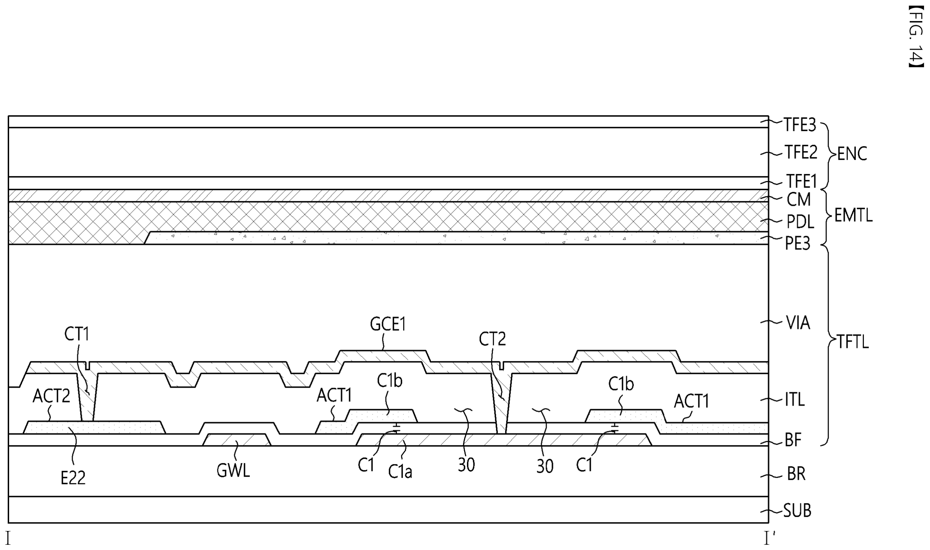

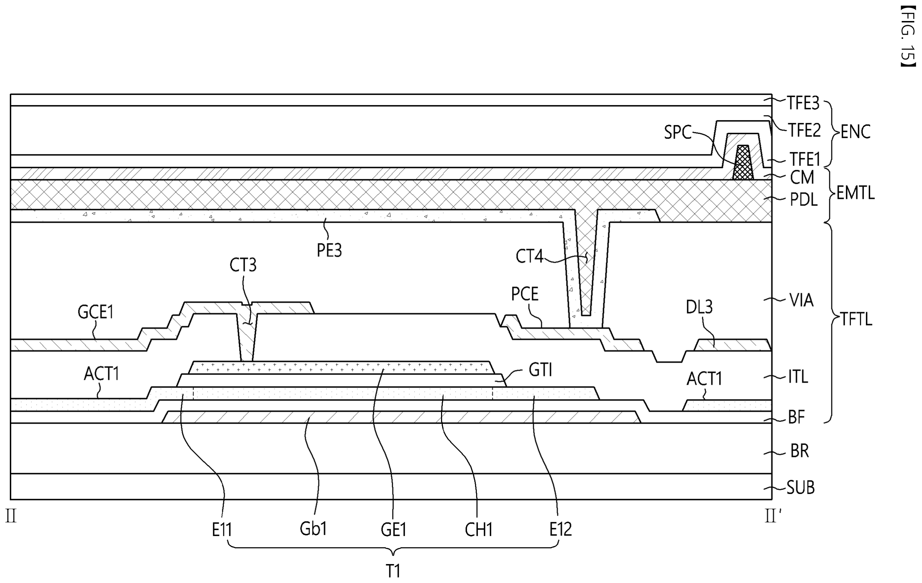

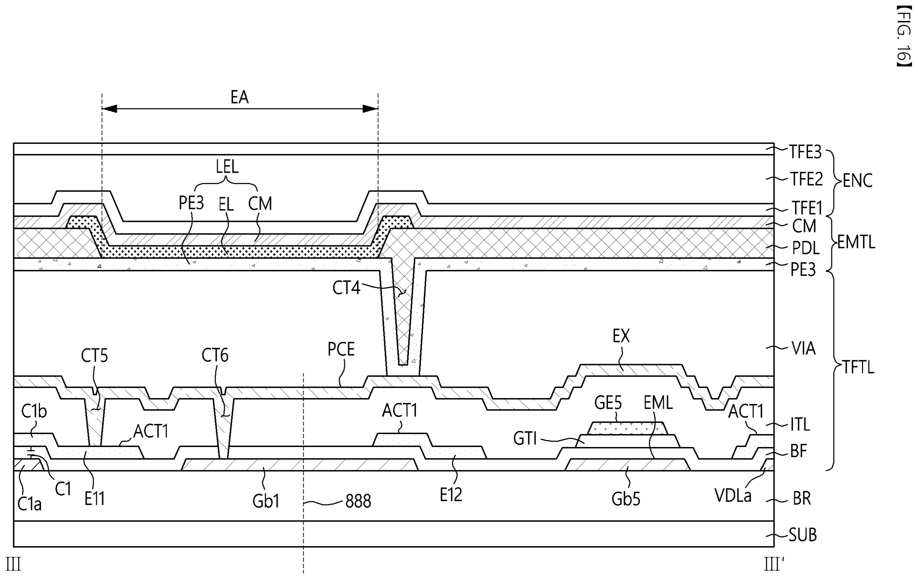

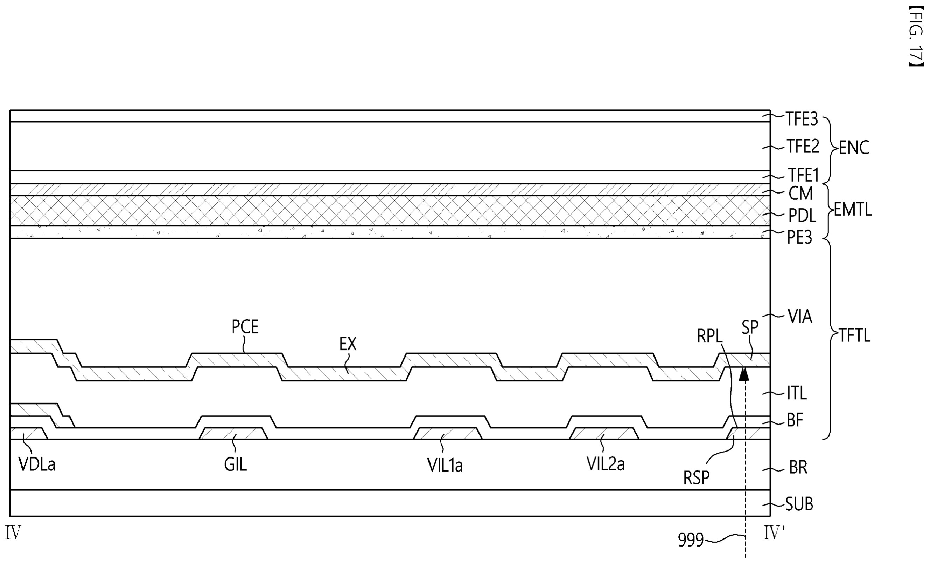

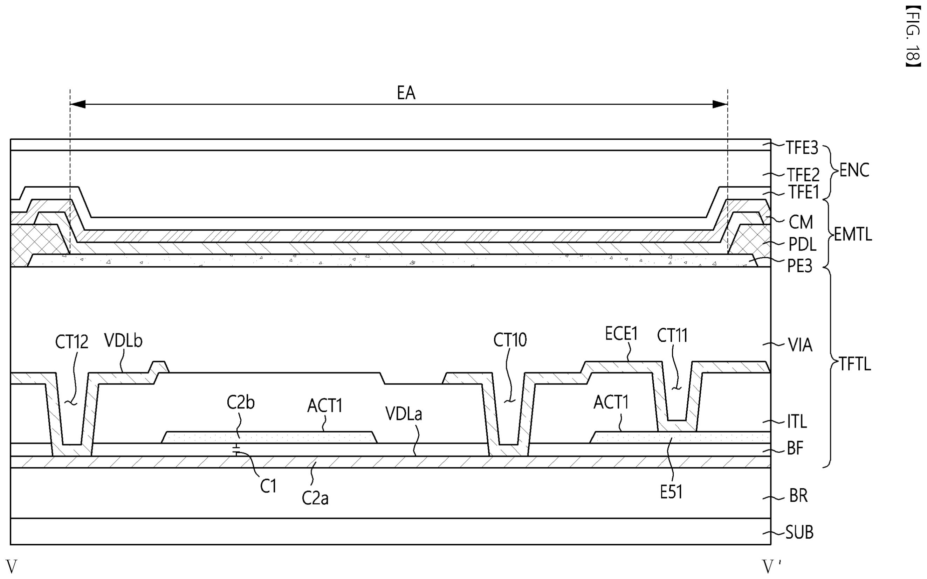

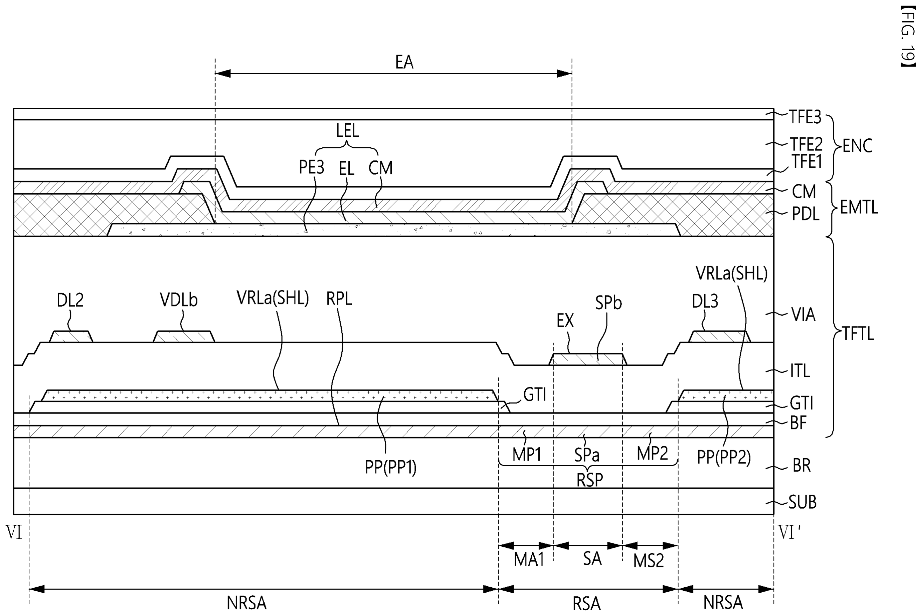

FIG. 14 is a cross-sectional view taken along line I-I' of FIG. 6, FIG. 15 is a cross-sectional view taken along line II-II' of FIG. 6, and FIG. 16 is a cross-sectional view taken along line III-III' of FIG. 6. FIG. 17 is a cross-sectional view taken along line IV-IV' of FIG. 6, FIG. 18 is a cross-sectional view taken along line V-V' of FIG. 6, and FIG. 19 is a cross-sectional view taken along line VI-VI' of FIG. 6.

As illustrated in FIGS. 14 to 19, the display device 1 may include the substrate SUB, a barrier layer BR, a thin film transistor layer TFTL, a light emitting element layer EMTL, and an encapsulation layer ENC. The barrier layer BR, the thin film transistor layer TFTL, the light emitting element layer EMTL, and the encapsulation layer ENC may be sequentially disposed on the substrate SUB along the third direction DR3. Here, the thin film transistor layer TFTL may include the aforementioned pixel circuit (e.g., the third pixel circuit PC3).

The substrate SUB may be a rigid substrate or a flexible substrate which can be bent, folded or rolled. The substrate SUB may be formed of an insulating material such as glass, quartz, or a polymer resin. Examples of a polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (TAC), cellulose acetate propionate (CAP), or a combination thereof. Alternatively, the substrate SUB may include a metal material.

A barrier layer BR may be disposed on the substrate SUB. The barrier layer BR may be a layer for protecting transistors of the thin film transistor layer TFTL and a light emitting layer EL of the light emitting element layer EMTL from moisture permeating through the substrate SUB which is susceptible to moisture permeation. The barrier layer BR may be formed as a plurality of inorganic layers that are alternately stacked. For example, the barrier layer BR may be formed of multiple layers in which one or more inorganic layers of a silicon nitride layer, a silicon oxynitride layer, a silicon oxide layer, a titanium oxide layer and an aluminum oxide layer are alternately stacked.

A first conductive layer (see FIG. 7) may be disposed on the barrier layer BR. For example, as illustrated in FIGS. 7 and 14 to 18, the third scan line GRL, the first scan line GWL, the first lower capacitor electrode C1a, a first counter gate electrode Gb1, the emission control line EML, the first lower driving voltage line VDLa, the second scan line GIL, the first lower initialization voltage line VIL1a, the second lower initialization voltage line VIL2a, and the repair line RPL may be disposed on the barrier layer BR. As an example, FIGS. 14 to 18 illustrate an example in which the third scan line GRL, the first scan line GWL, the emission control line EML, the first lower driving voltage line VDLa, the second scan line GIL, the first lower initialization voltage line VIL1a, the second lower initialization voltage line VIL2a, and the repair line RPL are disposed on the barrier layer BR.

A buffer layer BF may be disposed on the first conductive layer such as the third scan line GRL, the first scan line GWL, the emission control line EML, the first lower driving voltage line VDLa, the second scan line GIL, the first lower initialization voltage line VIL1a, the second lower initialization voltage line VIL2a, and the repair line RPL described above. The buffer layer BF may be a layer for protecting transistors of the thin film transistor layer TFTL and a light emitting layer EL of the light emitting element layer EMTL from moisture permeating through the substrate SUB which is susceptible to moisture permeation. The buffer layer BF may be formed of a plurality of inorganic layers that are alternately stacked. For example, the buffer layer BF may be formed of multiple layers in which one or more inorganic layers of a silicon nitride layer, a silicon oxynitride layer, a silicon oxide layer, a titanium oxide layer and an aluminium oxide layer are alternately stacked.

A second conductive layer (see FIG. 8) may be disposed on the buffer layer BF. For example, as illustrated in FIGS. 8 and 14 to 19, a semiconductor layer including the first semiconductor layer ACT1 and the second semiconductor layer ACT2 may be disposed on the buffer layer BF.

The first semiconductor layer ACT1 may provide the channel region (e.g., CH1 in FIG. 15), a first electrode (e.g., E11 in FIG. 15), and a second electrode (e.g., E12 in FIG. 15) of each of the first transistor T1, the fourth transistor T4, and the fifth transistor T5. For example, the first semiconductor layer ACT1 may include the first channel region CH1 of the first transistor T1, the fourth channel region of the fourth transistor T4, the fifth channel region of the fifth transistor T5, the first electrode E11 of the first transistor T1, the second electrode E12 of the first transistor T1, a first electrode E41 of the fourth transistor T4, the second electrode E42 of the fourth transistor T4, the first electrode E51 of the fifth transistor T5, and a second electrode E52 of the fifth transistor T5.

The second semiconductor layer ACT2 may provide the channel regions, the first electrodes (e.g., E21 and E31), and the second electrodes (e.g., E22 and E32) of the second transistor T2 and the third transistor T3. For example, the second semiconductor layer ACT2 may include the second channel region of the second transistor T2, the third channel region of the third transistor T3, the first electrode E21 of the second transistor T2, the second electrode E22 of the second transistor T2, the first electrode E31 of the third transistor T3, and the second electrode E32 of the third transistor T3.

The first channel region CH1 may overlap the first gate electrode GE1 and the first counter gate electrode Gb1, the second channel region may overlap the second gate electrode GE2 and the second counter gate electrode Gb2 of the first scan line GWL, the third channel region may overlap the third gate electrode GE3 and the third counter gate electrode Gb3 of the third scan line GRL, the fourth channel region may overlap the fourth gate electrode GE4 and the fourth counter gate electrode Gb4 of the second scan line GIL, and the fifth channel region CH5 may overlap the fifth gate electrode GE5 and the fifth counter gate electrode Gb5 of the emission control line EML.

As illustrated in FIG. 14, the first capacitor C1 may be disposed in an area in which the first lower capacitor electrode C1a and the first semiconductor layer ACT1 (e.g., the first upper capacitor electrode C1b of the first semiconductor layer ACT1) overlap. The first lower capacitor electrode C1a may correspond to the first electrode of the first capacitor C1, and a part (e.g., the first upper capacitor electrode C1b) of the first semiconductor layer ACT1 may correspond to the second electrode of the first capacitor C1.

As illustrated in FIG. 18, the second capacitor C2 may be disposed in an area in which the second lower capacitor electrode C2a and the first semiconductor layer ACT1 (e.g., the second upper capacitor electrode C2b of the first semiconductor layer ACT1) overlap. The second lower capacitor electrode C2a may correspond to the first electrode of the second capacitor C2, and a part (e.g., the second upper capacitor electrode C2b) of the first semiconductor layer ACT1 may correspond to the second electrode of the second capacitor C2.

As illustrated in FIGS. 15, 16, and 19, a gate insulating layer GTI may be disposed on the second conductive layer such as the first semiconductor layer ACT1 and the second semiconductor layer ACT2. Meanwhile, the gate insulating layer GTI may be patterned to have the same pattern as the third conductive layer to be described later. For example, the gate insulating layer GTI may be disposed between the buffer layer BF (and/or a semiconductor layer) and the third conductive layer to be described later. As a specific example, in order for the gate insulating layer GTI to be disposed between the first gate electrode GE1, the second gate electrode GE2, the third gate electrode GE3, the fourth gate electrode GE4, and the fifth gate electrode GE5 to be described later and the buffer layer BF (and/or a semiconductor layer), the gate insulating layer GTI may have substantially the same shape as the first gate electrode GE1, the second gate electrode GE2, the third gate electrode GE3, the fourth gate electrode GE4, and the fifth gate electrode GE5. Meanwhile, the gate insulating layer GTI may have the same shape as the third conductive layer and may have a larger area than the third conductive layer. The gate insulating layer GTI may include at least one of tetraethyl orthosilicate (TEOS), silicon nitride (SiNx), or silicon oxide (SiO₂). For example, the gate insulating layer GTI may have a double layer structure in which a silicon nitride layer having a thickness of 40 nm and a tetraethyl orthosilicate layer having a thickness of 80 nm are sequentially stacked.

A third conductive layer (see FIG. 9) may be disposed on the gate insulating layer GTI. For example, as illustrated in FIGS. 9 and 14 to 18, the first gate electrode GE1, the second gate electrode GE2, the third gate electrode GE3, the fourth gate electrode GE4, the fifth gate electrode GE5, and the lower reference voltage line VRLa may be disposed on the gate insulating layer GTI.

As illustrated in FIG. 15, the first gate electrode GE1 may be disposed on the gate insulating layer GTI to overlap the first semiconductor layer ACT1 and the first counter gate electrode Gb1. The first channel region CH1 may be disposed in one region of the first semiconductor layer ACT1 overlapping the first gate electrode GE1.

Meanwhile, descriptions related to the second gate electrode GE2, the third gate electrode GE3, the fourth gate electrode GE4, and the fifth gate electrode GE5 will be described with reference to FIG. 12.

As illustrated in FIG. 12, the second gate electrode GE2 may be disposed on the gate insulating layer GTI to overlap the second semiconductor layer ACT2 and the second counter gate electrode Gb2. A second channel region may be disposed in one region of the second semiconductor layer ACT2 overlapping the second gate electrode GE2.

As illustrated in FIG. 12, the third gate electrode GE3 may be disposed on the gate insulating layer GTI to overlap the second semiconductor layer ACT2 and the third counter gate electrode Gb3. A third channel region may be disposed in one region of the second semiconductor layer ACT2 overlapping the third gate electrode GE3.

As illustrated in FIG. 12, the fourth gate electrode GE4 may be disposed on the gate insulating layer GTI to overlap the first semiconductor layer ACT1 and the fourth counter gate electrode Gb4. A fourth channel region may be disposed in one region of the first semiconductor layer ACT1 overlapping the fourth gate electrode GE4.

As illustrated in FIG. 12, the fifth gate electrode GE5 may be disposed on the gate insulating layer GTI to overlap the first semiconductor layer ACT1 and the fifth counter gate electrode Gb5. A fifth channel region may be disposed in one region of the first semiconductor layer ACT1 overlapping the fifth gate electrode GE5.

As illustrated in FIGS. 15 and 12, the first transistor T1 may include the first gate electrode GE1, the first semiconductor layer ACT1, the first counter gate electrode Gb1, the first electrode E11, and the second electrode E12.

As illustrated in FIGS. 12 and 7, the second transistor T2 may include the second gate electrode GE2, the second semiconductor layer ACT2, the second counter gate electrode Gb2, the first electrode E21, and the second electrode E22.

As illustrated in FIGS. 12 and 7, the third transistor T3 may include the third gate electrode GE3, the second semiconductor layer ACT2, the third counter gate electrode Gb3, the first electrode E31, and the second electrode E32.

As illustrated in FIGS. 12 and 7, the fourth transistor T4 may include the fourth gate electrode GE4, the first semiconductor layer ACT1, the fourth counter gate electrode Gb4, the first electrode E41, and the second electrode E42.

As illustrated in FIGS. 12 and 7, the fifth transistor T5 may include the fifth gate electrode GE5, the first semiconductor layer ACT1, the fifth counter gate electrode Gb5, the first electrode E51, and the second electrode E52.

The lower reference voltage line VRLa may perform a function as a shielding line overlapping at least a part of the repair line RPL of the first conductive layer described above as well as transmitting the reference voltage VREF. To this end, as an example illustrated in FIGS. 13 and 18, the lower reference voltage line VRLa may include the line portion LP connected to a power and the protrusion PP extending from the line portion LP in the second direction DR2, so that the protrusion PP may overlap at least a part of the repair line RPL. This will be described in detail with reference to FIGS. 13 and 19.

As illustrated in FIGS. 13 and 19, the repair short portion RSP of the repair line RPL may be disposed between adjacent protrusions PP of the lower reference voltage line VRLa. In other words, in plan view (see FIG. 13), the repair short portion RSP may be disposed between adjacent first and second protrusions PP1 and PP2 of the lower reference voltage line VRLa.

At this time, as illustrated in FIGS. 13 and 19, the repair short portion RSP of the repair line RPL may include, for example, a short portion SPa, a first margin portion MP1, and a second margin portion MP2. In other words, the repair line RPL may include a repair short area RSA and a non-short area NRSA, so that the repair short area RSA may include a short area SA in which the short portion SPa described above is disposed, a first margin area MA1 in which the first margin portion MP1 described above is disposed, and a second margin area MA2 in which the second margin portion MP2 described above is disposed. However, the present disclosure is not limited thereto, and the repair short portion RSP of the repair line RPL may be disposed, for example, only in the short area SA described above. In this case, the lower reference voltage line VRLa may further extend to, for example, the first margin area MA1 and the second margin area MA2. As an example, the first protrusion PP1 of the lower reference voltage line VRLa may further extend into the first margin area MA1 to be further positioned within the first margin area MA1, and the second protrusion PP2 of the lower reference voltage line VRLa may further extend into the second margin area MA2 to be further positioned within the second margin area MA2. In this case, the gate insulating layer GTI may also be extended to be positioned in the first margin area MA1 and the second margin area MA2. Here, the first margin area MA1 and the second margin area MA2 may be spare areas for preventing the lower reference voltage line VRLa from being damaged by laser light irradiated to the short area SA during the repair process.

As illustrated in FIGS. 13 and 19, the lower reference voltage line VRLa may overlap, except for the repair short portion RSP of the repair line RPL, at least a part of the remaining portion of the repair line RPL. As an example, the lower reference voltage line VRLa may cover, except for the repair short portion RSP, the entire remaining portion of the repair line RPL. In other words, the lower reference voltage line VRLa may overlap, except for the repair short area RSA of the repair line RPL, all portions of the repair line RPL in the remaining area (e.g., the non-short area NRSA) of the repair line RPL. Accordingly, the lower reference voltage line VRLa may entirely shield all the overlapping areas between the repair line RPL and the pixel electrode (e.g., the third pixel electrode PE3).

Meanwhile, as illustrated in FIGS. 13 and 19, the lower reference voltage line VRLa may overlap most of the repair line RPL in the emission area (e.g., the third emission area EA). Accordingly, most of the overlapping area between the repair line RPL and the third pixel electrode PE3 in the third emission area EA may be covered by the lower reference voltage line VRLa. In other words, within the third emission area EA, the entire overlapping area between the repair line RPL and the third pixel electrode PE3 may include a shielding area and a non-shielding area, so that the shielding area may refer to an area in which the lower reference voltage line VRLa is disposed (e.g., an area overlapped by the third emission area EA in the non-short area NRSA described above), and the non-shielding area may refer to an area in which the lower reference voltage line VRLa is not disposed (e.g., a first margin area). For example, an area overlapped by the lower reference voltage line VRLa in an overlapping area between the repair line RPL and the third pixel electrode PE3 in the third emission area EA may be defined as the shielding area described above, and an area not overlapped by the lower reference voltage line VRLa in overlapping areas between the repair line RPL and the third pixel electrode PE3 in the third emission area EA may be defined as the non-shielding area described above, so that the shielding area may be larger than the non-shielding area. Meanwhile, as another embodiment, for example, the protrusion PP of the lower reference voltage line VRLa may further extend along the first direction DR1, so that the shielding area described above may entirely shield all the overlapping areas. In this case, the size of the shielding area and the size of the entire overlapping area may be the same (or substantially the same), and thus, the lower reference voltage line VRLa may entirely shield (or overlap) the entire overlapping area between the repair line RPL and the third pixel electrode PE3 in the emission area.

Meanwhile, as described above, when the lower reference voltage line VRLa overlaps all remaining portions of the repair line RPL except for the repair short portion RSP of the repair line RPL, all the lines that overlap (or intersect) the repair line RPL may be shielded by the lower reference voltage line VRLa described above in the overlapping areas therebetween. For example, all the lines that are disposed on a layer different from the repair line RPL (e.g., the layer on which the fourth conductive layer is disposed) in cross-sectional view and overlap (or intersect) the repair line RPL in plan view may be shielded by the lower reference voltage line VRLa described above in the overlapping areas therebetween. In other words, the lower reference voltage line VRLa described above may be disposed in overlapping areas between the repair line RPL and all the lines except for the area corresponding to the repair short portion RSP of the repair line RPL described above. As an example, as illustrated in FIGS. 6 and 19, the protrusion PP of the lower reference voltage line VRLa described above in an overlapping area between the repair line RPL and data lines (e.g., the second and third data lines DL2 and DL3) may be disposed, and the protrusion PP of the lower reference voltage line VRLa described above may be disposed in an overlapping area between the repair line RPL and the first upper driving voltage line VDLb. In addition, as illustrated in FIG. 5A, the protrusion PP of the lower reference voltage line VRLa described above may be disposed in an overlapping area between the repair line RPL and the upper reference voltage line VRLb.

Meanwhile, although not illustrated, the fourth conductive layer may include the first upper initialization voltage line VIL1b, the second upper initialization voltage line VIL2b, and the second driving voltage line VSL described above, so that the protrusion PP of the lower reference voltage line VRLa described above may be disposed in an overlapping area between the repair line RPL and the first upper initialization voltage line VIL1b, the protrusion PP of the lower reference voltage line VRLa described above may be disposed in an overlapping area between the repair line RPL and the second upper initialization voltage line VIL2b, and the protrusion PP of the lower reference voltage line VRLa described above may be disposed in the overlapping area between the repair line RPL and the second driving voltage line VSL. However, as in the examples illustrated in FIGS. 5A, 6, and 19, the lower reference voltage line VRLa described above may not be disposed in an overlapping area between the repair short portion RSP of the repair line RPL and the counter short portion SPb of the extension portion EX.

Meanwhile, as another embodiment, when the lower reference voltage line VRLa overlaps all remaining portions of the repair line RPL except for the repair short portion RSP of the repair line RPL, the overlapping area of the lower reference voltage line VRLa may be varied based on characteristics of the signal applied to the line. For example, when an overlapping area of the lower reference voltage line VRLa overlapping the repair line RPL and the lines such as a pixel electrode (e.g., the third pixel electrode PE3) and/or a data line (e.g., the third data line DL3) that transmit a fluctuating signal (e.g., the data voltage of the data line and the voltage of the pixel electrode) is defined as a first overlapping area, and an overlapping area of the lower reference voltage line VRLa overlapping an overlapping area between the repair line RPL and the lines such as the first upper driving voltage line VDLb, the upper reference voltage line VRLb, the first upper initialization voltage line VIL1b, the second upper initialization voltage line VIL2b, and the second driving voltage line VSL that transmit a power signal maintained at a constant magnitude is defined as a second overlapping area, the second overlapping area may be smaller than the first overlapping area. As a specific example, as illustrated in FIG. 6, the lower reference voltage line VRLa may cover an overlapping area between the first upper driving voltage line VDLb and the repair line RPL in a smaller amount as compared with covering an overlapping area between the third pixel electrode PE3 and the repair line RPL. In this case, the protrusion PP (e.g., another protrusion PP of the lower reference voltage line VRLa) covering the overlapping area between the first upper driving voltage line VDLb and the repair line RPL may have a smaller area than the protrusion PP (e.g., the protrusion PP of the lower reference voltage line VRLa) covering the overlapping area between the third pixel electrode PE3 and the repair line RPL. Accordingly, the capacitance between the power lines may be minimized while the voltage of the pixel electrode is stabilized.

As illustrated in FIGS. 14 to 19, the interlayer insulating layer ITL may be disposed on the third conductive layer such as the first to fifth gate electrodes GE1 to GE5. The interlayer insulating layer ITL may have a greater thickness than the gate insulating layer GTI. Here, the thickness may mean the size in the third direction DR3.

The interlayer insulating layer ITL may include an inorganic layer, for example, a silicon nitride layer, a silicon oxynitride layer, a silicon oxide layer, a titanium oxide layer, or an aluminium oxide layer. Meanwhile, the interlayer insulating layer ITL may include a plurality of inorganic layers.

A fourth conductive layer (see FIG. 10) may be disposed on the interlayer insulating layer ITL. For example, as illustrated in FIGS. 10 and 14 to 19, the second data line DL2, the first upper driving voltage line VDLb, the third data line DL3, the pixel connection electrode PCE, the extension portion EX, the first gate connection electrode GCE1, the second gate connection electrode GCE2, the third gate connection electrode GCE3, the fourth gate connection electrode GCE4, the fifth gate connection electrode GCE5, the first line connection electrode ECE1, the third line connection electrode ECE3, and the fifth line connection electrode ECE5 may be disposed on the interlayer insulating layer ITL.

As illustrated in FIG. 14, one side of the first gate connection electrode GCE1 may be connected to the second electrode of the second transistor T2 and the second electrode E32 of the third transistor T3 through the first contact hole CT1 penetrating the interlayer insulating layer ITL, and the other side of the first gate connection electrode GCE1 may be connected to the first lower capacitor electrode C1a through the second contact hole CT2 penetrating the interlayer insulating layer ITL and the buffer layer BF. At this time, the second contact hole CT2 may pass through the hole 30 of the first semiconductor layer ACT1. In other words, in plan view, the second contact hole CT2 may be surrounded by the hole 30 of the first semiconductor layer ACT1. In addition, as illustrated in FIG. 15, the other side of the first gate connection electrode GCE1 may be connected to the first gate electrode GE1 of the first transistor T1 through the third contact hole CT3 penetrating the interlayer insulating layer ITL.

Meanwhile, as illustrated in FIG. 6, one side of the second gate connection electrode GCE2 may be connected to the first scan line GWL through an eighth contact hole CT8 penetrating the interlayer insulating layer ITL and the buffer layer BF, and the other side of the second gate connection electrode GCE2 may be connected to the second gate electrode GE2 of the second transistor T2 through a ninth contact hole CT9 penetrating the interlayer insulating layer ITL.

As illustrated in FIG. 6, one side of the third gate connection electrode GCE3 may be connected to the third scan line GRL through a contact hole penetrating the interlayer insulating layer ITL and the buffer layer BF, and the other side of the third gate connection electrode GCE3 may be connected to the third gate electrode GE3 of the third transistor T3 through a contact hole penetrating the interlayer insulating layer ITL.

As illustrated in FIG. 6, one side of the fourth gate connection electrode GCE4 may be connected to the second scan line GIL through a contact hole penetrating the interlayer insulating layer ITL and the buffer layer BF, and the other side of the fourth gate connection electrode GCE4 may be connected to the fourth gate electrode GE4 of the fourth transistor T4 through a contact hole penetrating the interlayer insulating layer ITL.

As illustrated in FIG. 6, one side of the fifth gate connection electrode GCE5 may be connected to the emission control line EML through a contact hole penetrating the interlayer insulating layer ITL and the buffer layer BF, and the other side of the fifth gate connection electrode GCE5 may be connected to the fifth gate electrode GE5 of the fifth transistor T5 through a contact hole penetrating the interlayer insulating layer ITL.

As illustrated in FIG. 6, the third data line DL3 may be connected to the first electrode of the second transistor T2 through a seventh contact hole CT7 penetrating the interlayer insulating layer ITL. The first and second data lines DL2 may also be connected to the first electrodes E21 of the second transistors T2 provided in corresponding pixels in the same manner as the first data line DL1.

As illustrated in FIGS. 15 and 16, one side of the pixel connection electrode PCE may be connected to the first electrode E11 of the first transistor T1 through a fifth contact hole CT5 penetrating the interlayer insulating layer ITL, and the other side of the pixel connection electrode PCE may be connected to the first counter gate electrode Gb1 of the first transistor T1 through a sixth contact hole CT6 penetrating the interlayer insulating layer ITL and the buffer layer BF. Meanwhile, the other side of the pixel connection electrode PCE may be connected to the third pixel electrode PE3 to be described later.

As illustrated in FIGS. 6 and 18, one side of the first line connection electrode ECE1 may be connected to the first lower driving voltage line VDLa through a tenth contact hole CT10 penetrating the interlayer insulating layer ITL and the buffer layer BF, and the other side of the first line connection electrode ECE1 may be connected to the first electrode E51 of the fifth transistor T5 through an eleventh contact hole CT11 penetrating the interlayer insulating layer ITL.

As illustrated in FIG. 6, one side of the third line connection electrode ECE3 may be connected to the second lower initialization voltage line VIL2a through a contact hole penetrating the interlayer insulating layer ITL and the buffer layer BF, and the other side of the third line connection electrode ECE3 may be connected to the second electrode E41 of the fourth transistor T4 through a contact hole penetrating the interlayer insulating layer ITL.

As illustrated in FIG. 6, one side of the fifth line connection electrode ECE5 may be connected to the first lower reference voltage line VRLa (e.g., a shielding line) through a contact hole penetrating the interlayer insulating layer ITL, and the other side of the fifth line connection electrode ECE5 may be connected to the first electrode E31 of the third transistor T3 through a contact hole penetrating the interlayer insulating layer ITL. Meanwhile, as described above, the first electrode of the third transistor T3 may be connected to the first upper reference voltage line VRLb instead of the first lower reference voltage line VRLa. For example, the third transistor included in the first pixel circuit of FIG. 5A may be connected to the first upper reference voltage line VRLb. In this case, the first upper reference voltage line VRLb may be connected to the first electrode E31 of the third transistor T3 through a contact hole penetrating the interlayer insulating layer ITL.

As illustrated in FIG. 5A, one side of the second line connection electrode ECE2 may be connected to the first lower initialization voltage line VIL1a through a contact hole penetrating the interlayer insulating layer ITL and the buffer layer BF, and the other side of the second line connection electrode ECE2 may be connected to the second electrode E42 of the fourth transistor T4 (e.g., the fourth transistor T4 of the second pixel circuit PC2) through a contact hole penetrating the interlayer insulating layer ITL.

As illustrated in FIG. 5A, one side of the fourth line connection electrode ECE4 may be connected to the second lower initialization voltage line VIL2a through a contact hole penetrating the interlayer insulating layer ITL and the buffer layer BF, and the other side of the fourth line connection electrode ECE4 may be connected to the second electrode E42 of the fourth transistor T4 (e.g., the fourth transistor T4 of the first pixel circuit PC1) through a contact hole penetrating the interlayer insulating layer ITL.

As illustrated in FIGS. 6 and 18, the first upper driving voltage line VDLb may be connected to the first lower driving voltage line VDLa through a twelfth contact hole CT12 penetrating the interlayer insulating layer ITL and the buffer layer BF.

Meanwhile, although not illustrated, a first upper initialization voltage line may be connected to the first lower initialization voltage line VILla through a contact hole penetrating the interlayer insulating layer ITL and the buffer layer BF, and a second upper initialization voltage line may be connected to the second lower initialization voltage line VIL2a through a contact hole penetrating the interlayer insulating layer ITL and the buffer layer BF.

As illustrated in FIGS. 14 to 19, a planarization layer VIA may be disposed on the fourth conductive layer such as the second data line DL2, the first upper driving voltage line VDLb, the third data line DL3, the pixel connection electrode PCE, the extension portion EX, the first gate connection electrode GCE1, the second gate connection electrode GCE2, the third gate connection electrode GCE3, the fourth gate connection electrode GCE4, the fifth gate connection electrode GCE5, the first line connection electrode ECE1, the third line connection electrode ECE3, and the fifth line connection electrode ECE5 described above. The planarization layer VIA may include an organic layer such as acryl resin, epoxy resin, phenolic resin, polyamide resin, polyimide resin and the like.

As illustrated in FIGS. 14 to 19, the light emitting element layer EMTL including a fifth conductive layer may be disposed on the planarization layer VIA. For example, the light emitting element layer EMTL may be disposed on the thin film transistor layer TFTL. The light emitting element layer EMTL may include the light emitting elements LEL and a bank PDL.

The light emitting elements may include, for example, a first light emitting element connected to the first pixel circuit PC1, a second light emitting element connected to the second pixel circuit PC2, and the third light emitting element LEL connected to the third pixel circuit PC3. The first light emitting element may include the first pixel electrode PE1, the first light emitting layer, and the common electrode CM, the second light emitting element may include the second pixel electrode PE2, a second light emitting layer, and the common electrode CM, and the third light emitting element LEL may include the third pixel electrode PE3, the light emitting layer EL, and the common electrode CM. Hereinafter, a description of the light emitting elements will describe a representative example of the third light emitting element LEL connected to the third pixel circuit PC3.

The third light emitting element LEL may include the third pixel electrode PE3, the light emitting layer EL, and the common electrode CM. The emission area EA, in which the third pixel electrode PE3, the light emitting layer EL, and the common electrode CM are sequentially stacked, indicates an area in which holes from the third pixel electrode PE3 and electrons from the common electrode CM are combined with each other in the light emitting layer to emit light. In this case, the third pixel electrode PE3 may be an anode electrode of the light emitting element LEL, and the common electrode CM may be a cathode electrode of the third light emitting element LEL.

The third pixel electrode PE3 may be disposed on the planarization layer VIA. As illustrated in FIG. 16, the third pixel electrode PE3 may be connected to the pixel connection electrode PCE through the fourth contact hole CT4 penetrating the planarization layer VIA. Meanwhile, the first pixel electrode PE1 and the second pixel electrode PE2 may also be disposed on the planarization layer.

In a top emission structure that emits light toward the common electrode CM with respect to the light emitting layer EL, the pixel electrode may be formed of a single layer of molybdenum (Mo), titanium (Ti), copper (Cu), or aluminium (Al), or may be formed to have a laminated structure of aluminium and titanium (Ti/Al/Ti), a laminated structure of aluminium and ITO (ITO/Al/ITO), an APC alloy, or a laminated structure of APC alloy and ITO (ITO/APC/ITO) to increase the reflectivity. The APC alloy is an alloy of silver (Ag), palladium (Pd) and copper (Cu).

The bank PDL (or pixel defining layer) serves to define the emission areas EA of display pixels. To this end, the bank PDL may be disposed to expose a partial area of the third pixel electrode PE3 on the planarization layer VIA. The bank PDL may cover an edge of the third pixel electrode PE3. Meanwhile, although not illustrated, the bank PDL may be disposed in the fourth contact hole CT4 penetrating the planarization layer VIA. Accordingly, the fourth contact hole CT4 penetrating the planarization layer VIA may be filled by the bank PDL. The bank PDL may be formed of an organic layer such as acryl resin, epoxy resin, phenolic resin, polyamide resin, polyimide resin and the like.

A spacer SPC may be disposed on the bank PDL. The spacer SPC may serve to support a mask during a process of manufacturing the light emitting layer EL. The spacer SPC may be formed of an organic layer such as acryl resin, epoxy resin, phenolic resin, polyamide resin, polyimide resin and the like.

The light emitting layer EL may be formed on the third pixel electrode PE3. The light emitting layer EL may include an organic material to emit light in a predetermined color. For example, the light emitting layer EL may include a hole transporting layer, an organic material layer, and an electron transporting layer. The organic material layer may include a host and a dopant. The organic material layer may include a material that emits predetermined light, and may be formed using a phosphorescent material or a fluorescent material.

For example, the organic material layer of the first light emitting layer of the first emission area emitting the light of the first color may be a phosphorescent material including a host material including carbazole biphenyl (CBP) or mCP (1,3-bis(carbazol-9-yl), and a dopant including at least one selected from the group consisting of PIQIr(acac)(bis(1-phenylisoquinoline)acetylacetonate iridium), PQIr(acac)(bis(1-phenylquinoline)acetylacetonate iridium), PQIr(tris(1-phenylquinoline)iridium)) and PtOEP (octaethylporphyrin platinum). Alternatively, the organic material layer of the first light emitting layer of the first emission area may be a fluorescent material including PBD:Eu(DBM)3(Phen) or Perylene, but the present disclosure is not limited thereto.

The organic material layer of the second light emitting layer of the second emission area emitting the light of the second color may be a phosphorescent material including a host material including CBP or mCP, and a dopant material including Ir(ppy)3(fac tris(2-phenylpyridine)iridium. Alternatively, the organic material layer of the second light emitting layer of the second emission area emitting the light of the second color may be a fluorescent material including tris(8-hydroxyquinolino)aluminium (Alq3), but the present disclosure is not limited thereto.

The organic material layer of the light emitting layer EL of the third emission area EA emitting the light of the third color may be a phosphorescent material including a host material including CBP or mCP, and a dopant material including (4,6-F2ppy)2Irpic or L2BD111, but the present disclosure is not limited thereto.

The common electrode CM may be disposed on the first, second, and third light emitting layers EL. The common electrode CM may be disposed to cover the first, second, and third light emitting layers EL. The common electrode CM may be a common layer commonly disposed in the first to third light emitting layers EL. A capping layer may be formed on the common electrode CM.

In the top emission structure, the common electrode CM may be formed of a transparent conductive material (TCO) such as ITO or IZO capable of transmitting light or a semi-transmissive conductive material such as magnesium (Mg), silver (Ag), or an alloy of magnesium (Mg) and silver (Ag). When the common electrode CM is formed of a semi-transmissive conductive material, the light emission efficiency can be increased due to a micro-cavity effect.

The encapsulation layer ENC may be formed on the light emitting element layer EMTL. The encapsulation layer ENC may include at least one inorganic layer TFE1 and TFE3 to prevent oxygen or moisture from permeating into the light emitting element layer EMTL. In addition, the encapsulation layer ENC may include at least one organic layer to protect the light emitting element layer EMTL from foreign substances such as dust. For example, the encapsulation layer ENC may include a first inorganic encapsulation layer TFE1, an organic encapsulation layer TFE2, and a second inorganic encapsulation layer TFE3.

The first inorganic encapsulation layer TFE1 may be disposed on the common electrode CM, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may be formed of multiple layers in which one or more inorganic layers of a silicon nitride layer, a silicon oxynitride layer, a silicon oxide layer, a titanium oxide layer and an aluminium oxide layer are alternately stacked. The encapsulation organic layer TFE2 may be an organic layer such as acryl resin, epoxy resin, phenolic resin, polyamide resin, polyimide resin or the like.

Meanwhile, a repair process for a defective pixel may be performed in the following order. For example, when the light emitting element is not turned on due to a defect in the third pixel circuit PC3 of FIG. 6, first, as illustrated in FIGS. 6 and 16, laser may be radiated from the lower portion of the substrate SUB in the third direction DR3 to cut a part of the pixel connection electrode PCE. Specifically, a part of the pixel connection electrode PCE between the sixth contact hole CT6 and the fourth contact hole CT4 may be cut along a cutting line 888. Accordingly, an electrical connection between the third pixel electrode PE3 and the third pixel circuit PC3 may be blocked. Meanwhile, during the laser cutting process, a part of the first counter gate electrode Gb1 positioned below the pixel connection electrode PCE and overlapping the pixel connection electrode PCE may be cut.

Then, as illustrated in FIG. 17, laser is irradiated from the lower portion of the substrate SUB in the third direction DR3 along an arrow 999, so that the repair line RPL and the counter short portion SPb of the pixel connection electrode PCE may be connected to each other. Specifically, laser is irradiated from the lower portion of the substrate SUB toward the repair short portion RSP of the repair line RPL, and the repair short portion RSP and the counter short portion SPb disposed to overlap the repair short portion RSP may be in contact with each other. Accordingly, the third pixel electrode PE3 may receive a voltage supplied from the dummy pixel to the repair line RPL. Accordingly, the light emitting element including the third pixel electrode PE3 may emit light normally.

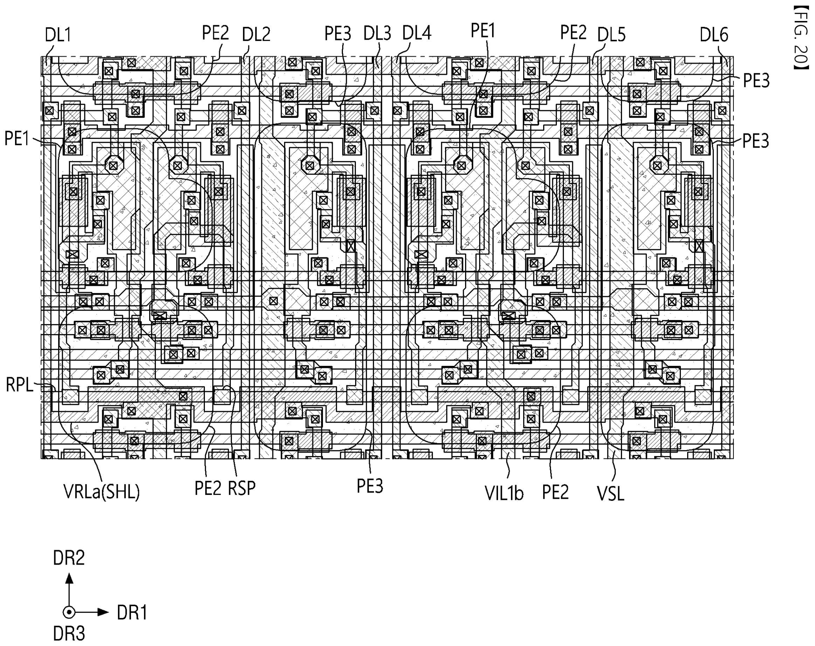

FIG. 20 is a plan view of an array in which a plurality of unit pixels of FIG. 5A are disposed.

FIG. 20 is a view illustrating the disposition of a plurality of unit pixels of FIG. 5A described above, and as illustrated in FIG. 20, the first upper initialization voltage line VIL1b may be disposed, for example, between the fourth data line DL4 and the fifth data line DL5.

The first upper initialization voltage line VIL1b may be connected to the first lower initialization voltage line VILla through a contact hole penetrating the interlayer insulating layer ITL and the buffer layer BF.

In addition, the first upper initialization voltage line VIL1b may overlap the repair line RPL and the lower reference voltage line VRLa.

As illustrated in FIG. 20, the repair line RPL and the lower reference voltage line VRLa may overlap a plurality of second pixel electrodes PE2 and a plurality of third pixel electrodes PE3 arranged along the first direction DR1.

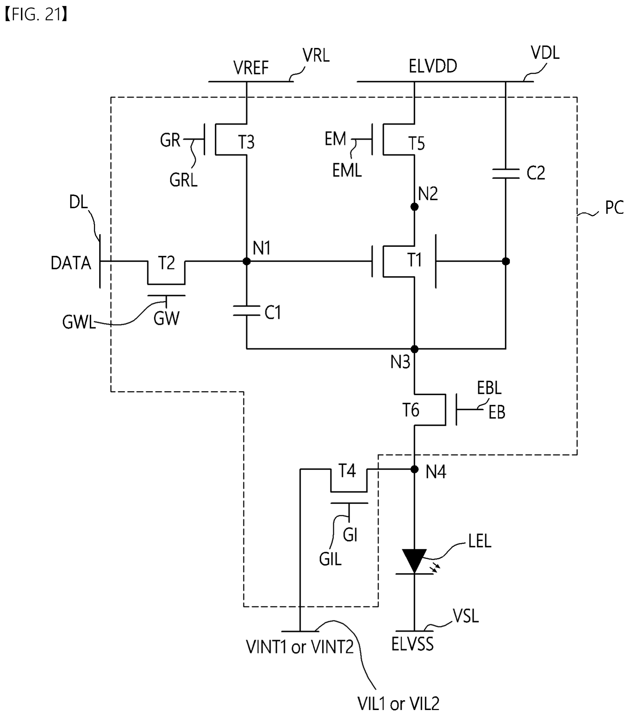

FIG. 21 is a diagram illustrating a pixel circuit and a light emitting element of a pixel according to one embodiment of the present disclosure.

Referring to FIG. 21, the pixel PX may include the light emitting element LEL (e.g., an organic light emitting diode) as a display element and the pixel circuit PC connected to the light emitting element LEL.

The pixel circuit PC may include the first to sixth transistors T1 to T6 and the first and second capacitors C1 and C2. The first transistor T1 may be a driving transistor in which a size of a source-drain current is determined according to a gate-source voltage, and the second to fifth transistors T2 to T6 may be a switching transistor that is turned on/off according to the gate-source voltage, substantially a gate voltage. The first to sixth transistors T1 to T6 may be implemented as thin film transistors. According to the type (p-type or n-type) and/or the operating condition of the transistor, the first electrode of each of the first to sixth transistors T1 to T6 may be a source electrode or a drain electrode, and the second electrode may be an electrode different from the first electrode. For example, when the first electrode is the source electrode, the second electrode may be the drain electrode.

The pixel PX may be connected to the first scan line GWL that transmits the first scan signal GW, the second scan line GIL that transmits the second scan signal GI, the third scan line GRL that transmits the third scan signal GR, a fourth scan line EBL that transmits the fourth scan signal EB, the emission control line EML that transmits the emission control signal EM, and the data line DL that transmits the data signal DATA. The first driving voltage line VDL may transmit the first driving voltage ELVDD to the first transistor T1. An initialization voltage line VIL1 or VIL2 may transmit an initialization voltage VINT1 or VINT2 to the light emitting element LEL (e.g., an organic light emitting diode). The reference voltage line VRL may transmit the reference voltage VREF to the gate electrode of the first transistor T1.

The plurality of first to sixth transistors T1 to T6 may include an oxide semiconductor material.

Since the first to fifth transistors T1 to T5 of FIG. 21 are substantially the same as the first to fifth transistors T1 to T5 of FIGS. 3 and 6 described above, the description of the first to fifth transistors T1 to T5 of FIG. 21 refers to the description of FIGS. 3 and 6.

The sixth transistor T6 may include a sixth gate electrode GE6 connected to the fourth scan line EBL, a first electrode connected to the third node N3, and a second electrode connected to the fourth node N4. Meanwhile, according to FIG. 21, the first electrode of the fourth transistor T4 may be connected to the third node N3 via the sixth transistor T6.

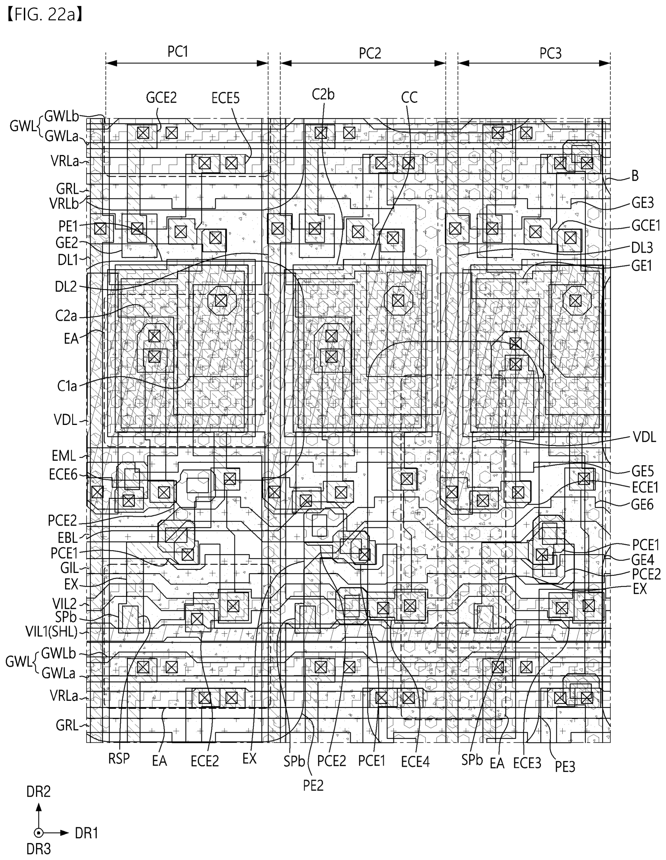

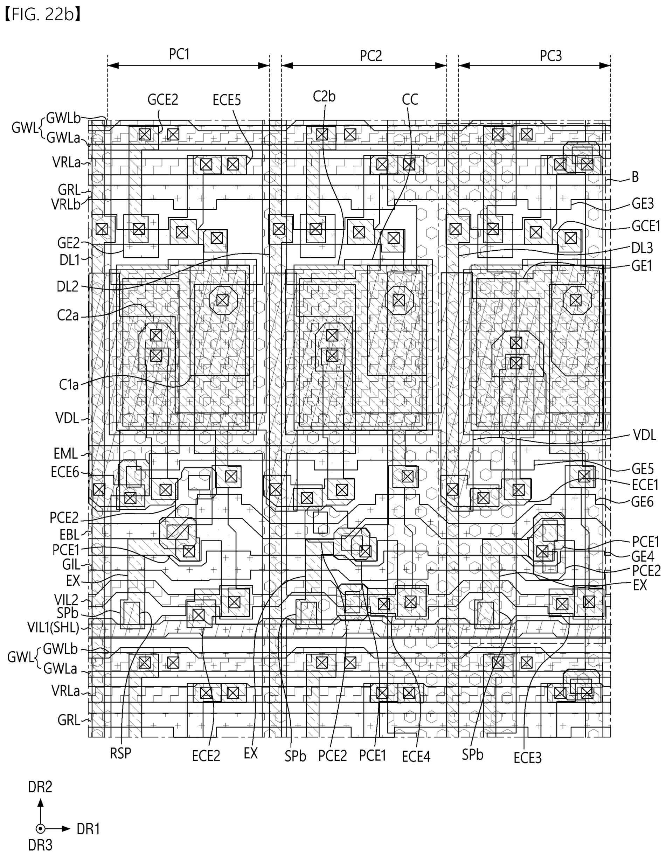

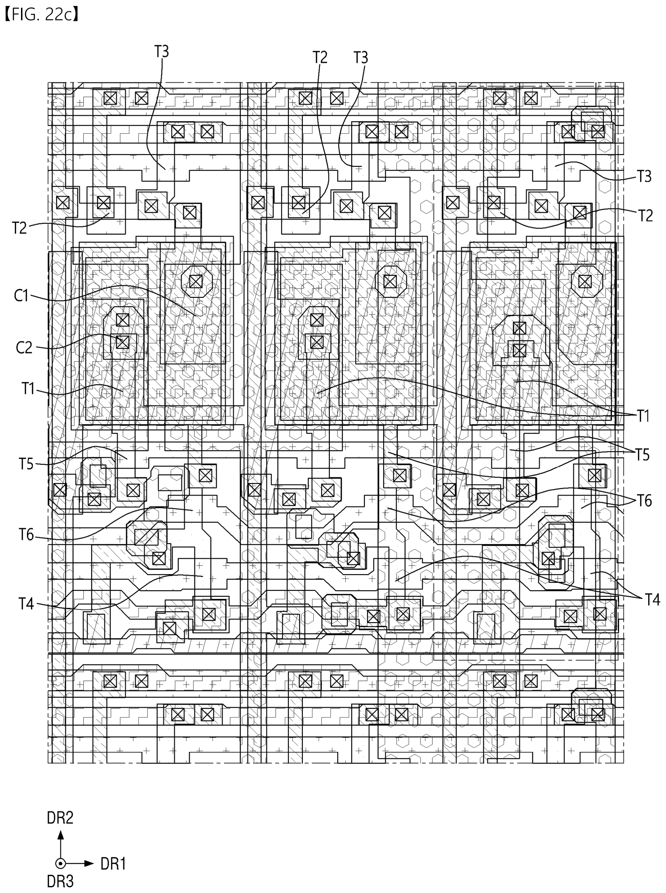

FIG. 22A is a plan view of a pixel array of a display device according to one embodiment of the present disclosure including the pixel circuit of FIG. 21, FIG. 22B is a plan view of FIG. 22A in which pixel electrodes and emission areas are removed, and FIG. 22C is a plan view of FIG. 22A in which except for the reference numerals of the transistors and the reference numerals of the capacitors, the remaining reference numerals are removed.

As illustrated in FIGS. 22A to 22C, the display device 1 according to one embodiment of the present disclosure may include the first to third pixel circuits PC1 to PC3 and the first to third pixel electrodes PE1 to PE3 respectively connected to the first to third pixel circuits PC1 to PC3.

Here, the first pixel circuit PC1 and the first pixel electrode PE1 may be the pixel circuit and the pixel electrode of the first pixel PX1, the second pixel circuit PC2 and the second pixel electrode PE2 may be the pixel circuit and the pixel electrode of the second pixel PX2, and the third pixel circuit PC3 and the third pixel electrode PE3 may be the pixel circuit and the pixel electrode of the third pixel PX3. Meanwhile, the first to third pixels PX1 to PX3 may form one unit pixel.

The first to third pixels PX1 to PX3 of the unit pixel may include light emitting layers providing light of different wavelengths. For example, the first pixel PX1 may include a light emitting layer that provides light of a first wavelength (e.g., light of a red wavelength), the second pixel PX2 may include a light emitting layer that provides light of a second wavelength (e.g., light of a green wavelength), and the third pixel PX3 may include a light emitting layer that provides light of a third wavelength (e.g., light of a blue wavelength).

Each of the pixel circuits PC1 to PC3 of the pixels PX1 to PX3 may include the first to sixth transistors T1 to T6, the first capacitor C1, and the second capacitor C2. For example, the pixel circuits PC1 to PC3 of the first to third pixels PX1 to PX3 will be described in detail.

The first pixel circuit PC1 may include, for example, the first to sixth transistors T1 to T6, the first capacitor C1, and the second capacitor C2 disposed in a defined area surrounded by the first data line DL1, the second data line DL2, the first scan line GWL, and the first initialization voltage line VIL1 (or the repair line RPL). The first pixel circuit PC1 may be connected to, for example, the first pixel electrode PE1, the first data line DL1, the first scan line GWL, the second scan line GIL, the third scan line GRL, the fourth scan line EBL, the first driving voltage line VDL, the reference voltage line VRL, and the first initialization voltage line VIL1. Here, the first scan line GWL may include a first lower scan line GWLa and a first upper scan line GWLb connected to each other through the contact hole of the insulating layer, and the reference voltage line VRL may include the upper reference voltage line VRLb and the lower reference voltage line VRLa connected to each other through the contact hole of the insulating layer.

The first initialization voltage line VIL1 may perform a function as a shielding line as well as performing a function of transmitting a first initialization voltage.

The second pixel circuit PC2 may include, for example, the first to sixth transistors T1 to T6, the first capacitor C1, and the second capacitor C2 disposed in a defined area surrounded by the second data line DL2, the third data line DL3, the first scan line GWL, and the first initialization voltage line VIL1 (or the repair line RPL). The second pixel circuit PC2 may be connected to, for example, the second pixel electrode PE2, the second data line DL2, the first scan line GWL, the second scan line GIL, the third scan line GRL, the fourth scan line EBL, the first driving voltage line VDL, the reference voltage line VRL, and the second initialization voltage line VIL2.

The third pixel circuit PC3 may include, for example, the first to sixth transistors T6, the first capacitor C1, and the second capacitor C2 disposed in a defined area surrounded by the third data line DL3, the fourth data line DL4, the first scan line GWL, and the first initialization voltage line VIL1 (or the repair line RPL). The third pixel circuit PC3 may be connected to, for example, the third pixel electrode PE3, the third data line DL3, the first scan line GWL, the second scan line GIL, the third scan line GRL, the fourth scan line EBL, the first driving voltage line VDL, the reference voltage line VRL, and the second initialization voltage line VIL2.

A part of each of the first pixel electrode PE1, the second pixel electrode PE2, and the third pixel electrode PE3 may be exposed by a bank. For example, the bank may include a first opening (hereinafter referred to as a first emission area) exposing a part of the first pixel electrode PE1, a second opening (hereinafter referred to as a second emission area) exposing a part of the second pixel electrode PE2, and a third opening (hereinafter referred to as a third emission area) exposing a part of the third pixel electrode PE3. Each of the emission areas may correspond to a part excluding an edge of a corresponding pixel electrode.

Among pixel electrodes included in one unit pixel, the third pixel electrode PE3 may have the largest area. In other words, among the three pixels of one unit pixel, the third pixel (e.g., the pixel including the third pixel circuit PC3) may include the pixel electrode having the largest area (e.g., the third pixel electrode PE3).

The first lower scan line GWLa may extend along the first direction DR1.

The first upper scan line GWLb may extend along the first direction DR1. The first upper scan line GWLb may overlap the first lower scan line GWLa. The first upper scan line GWLb may be connected to the second transistor T2 of each of the pixel circuits. For example, the first upper scan line GWLb may be connected to the second gate electrode GE2 of the second transistor T2 through the second gate connection electrode GCE2.

The lower reference voltage line VRLa may extend along the first direction DR1. The lower reference voltage line VRLa may be connected to the third transistor T3 of each of the pixel circuits PC1 to PC3. For example, the lower reference voltage line VRLa may be connected to the first electrode (source electrode or drain electrode) of the third transistor T3 through the fifth line connection electrode ECE5.

The third scan line GRL may extend along the first direction DR1. The third scan line GRL may be connected to the third transistor T3 of each of the pixel circuits PC1 to PC3. For example, a part of the third scan line GRL may be the third gate electrode GE3 of the third transistor T3.

The first driving voltage line VDL may extend along the first direction DR1 and the second direction DR2. The first driving voltage line VDL may be connected to the fifth transistor T5 of each of the pixel circuits PC1 to PC3. For example, the first driving voltage line VDL may be connected to the first electrode (e.g., a source electrode or a drain electrode) of the fifth transistor T5 through the first line connection electrode ECE1 and a sixth line connection electrode ECE6.

The first lower capacitor electrode C1a may constitute the first capacitor C1 together with the common capacitor electrode CC. For example, a portion of the common capacitor electrode CC overlapping the first lower capacitor electrode C1a may correspond to the first upper capacitor electrode C1b of the first capacitor C1. Meanwhile, the first capacitor C1 may also be formed between the first driving voltage line VDL and the common capacitor electrode CC overlapping each other.

The second lower capacitor electrode C2a together with the common capacitor electrode CC, the first gate electrode GE1, and the second upper capacitor electrode C2b may constitute the second capacitor C2. For example, the second capacitor C2 may be formed between the second lower capacitor electrode C2a and the common capacitor electrode CC that overlap each other, between the common capacitor electrode CC and the first gate electrode GE1 that overlap each other, and between the first gate electrode GE1 and the second upper capacitor electrode C2b that overlap each other, respectively. Meanwhile, the second lower capacitor electrode C2a may be integrally formed with the first driving voltage line VDL described above.

The emission control line EML may extend along the first direction DR1. The emission control line EML may be connected to the fifth transistor T5 of each of the pixel circuits PC1 to PC3. For example, a part of the emission control line EML may be the fifth gate electrode GE5 of the fifth transistor T5.

The fourth scan line EBL may extend along the first direction DR1. The fourth scan line EBL may be connected to the sixth transistor T6 of each of the pixel circuits. For example, a part of the fourth scan line EBL may be the sixth gate electrode GE6 of the sixth transistor T6.

The second scan line GIL may extend along the first direction DR1. The second scan line GIL may be connected to the fourth transistor T4 of each of the pixel circuits. For example, a part of the second scan line GIL may be the fourth gate electrode GE4 of the fourth transistor T4.

The second initialization voltage line VIL2 may extend along the first direction DR1. The second initialization voltage line VIL2 may be connected to the fourth transistor T4 of each of the second and third pixel circuits PC2 and PC3. For example, the second initialization voltage line VIL2 may be connected to the first electrode (e.g., a source electrode or a drain electrode) of the fourth transistor T4 provided in the second pixel circuit PC2 through each fourth line connection electrode ECE4. Further, the second initialization voltage line VIL2 may be connected to the first electrode (e.g., a source electrode or a drain electrode) of the fourth transistor T4 provided in the third pixel circuit PC3 through the third line connection electrode ECE3. As described above, the second initialization voltage line VIL2 may be connected to pixels of two or more colors among the three pixels. For example, the second initialization voltage line VIL2 may be connected to the fourth transistor T4 of a green pixel (e.g., a second pixel including the second pixel circuit PC2) providing light corresponding to a green wavelength and to the fourth transistor T4 of a blue pixel (e.g., a third pixel including the third pixel circuit PC3) providing light corresponding to a blue wavelength.

The first initialization voltage line VIL1 may extend along the first direction DR1. The first initialization voltage line VIL1 may be connected to the fourth transistor T4 of the first pixel circuit PC1. For example, the first initialization voltage line VIL1 may be connected to the first electrode (e.g., a source electrode or a drain electrode) of the fourth transistor T4 through the second line connection electrode ECE2. As described above, the first initialization voltage line VIL1 may be connected to a pixel of any one color among the three pixels. For example, the first initialization voltage line VIL1 may be connected to the fourth transistor T4 of a red pixel (e.g., a first pixel including the first pixel circuit PC1) providing light corresponding to a red wavelength. Here, the first initialization voltage line VIL1 may be utilized as a shielding line.

The repair line RPL may extend along the first direction DR1. The repair line RPL may be overlapped by a shielding line (e.g., the first initialization voltage line VIL1). The repair line RPL will be described in more detail below.

The first data line DL1 may extend along the second direction DR2. The first data line DL1 may be connected to the second transistor T2 of the first pixel circuit PC1. For example, the first data line DL1 may be connected to a first electrode (e.g., a source electrode or a drain electrode) of the second transistor T2 through the contact hole of the insulating layer.

The second data line DL2 may extend along the second direction DR2. The second data line DL2 may be connected to the second transistor T2 of the second pixel circuit PC2. For example, the second data line DL2 may be connected to a first electrode (e.g., a source electrode or a drain electrode) of the second transistor T2 through the contact hole of the insulating layer.

The third data line DL3 may extend along the second direction DR2. The third data line DL3 may be connected to the second transistor T2 of the third pixel circuit PC3. For example, the third data line DL3 may be connected to a first electrode (e.g., a source electrode or a drain electrode) of the second transistor T2 through the contact hole of the insulating layer.

The upper reference voltage line VRLb may extend along the second direction DR2. The upper reference voltage line VRLb may be connected to the lower reference voltage line VRLa described above through the contact hole of the insulating layer. Here, the reference voltage line VRL may be defined by a plurality of lower reference voltage lines VRLa extending along the first direction DR1 and arranged along the second direction DR2 and a plurality of upper reference voltage lines VRLb extending along the second direction DR2 intersecting the lower reference voltage line VRLa and arranged along the first direction DR1. The reference voltage line VRL may have a mesh shape.

The first pixel connection electrode PCE1 of each of the pixels PX1 to PX3 may include the extension portion EX extending in a reverse direction of the second direction DR2 (hereinafter referred to as a second reverse direction), so that each extension portion EX may overlap the repair line RPL. For example, an end of each of the extension portion EX of the first pixel connection electrode PCE1 connected to the first pixel electrode PE1, the extension portion EX of the first pixel connection electrode PCE1 connected to the second pixel electrode PE2, and the extension portion EX of the first pixel connection electrode PCE1 connected to the third pixel electrode PE3 may include the counter short portion SPb, so that in order to overlap each of the repair short portions RSP of the repair line RPL, the counter short portion SPb of each of the extension portions EX may be disposed on the corresponding repair short portion RSP. As an example, the counter short portion SPb of each of the extension portions EX may be disposed on the corresponding repair short portion RSP of the repair line RPL.

The repair line RPL may extend along the first direction DR1. The repair line RPL may be overlapped by the first initialization voltage line VIL1 adjacent thereto in the third direction DR3. For example, the first initialization voltage line VIL1 may be disposed above the repair line RPL to overlap the repair line RPL.

The first initialization voltage line VIL1 may extend along the first direction DR1.

At least a part of the first initialization voltage line VIL1 may be disposed on the repair line RPL to overlap at least a part of the repair line RPL in plan view, for example. As an example, at least a part of the first initialization voltage line VIL1 may be disposed between the repair line RPL and the second and third pixel electrodes PE2 and PE3. In other words, in order to be positioned in an overlapping area between the repair line RPL and the pixel electrodes (e.g., PE2 and PE3), at least a part of the first initialization voltage line VIL1 may be disposed between the repair line RPL and the pixel electrodes PE2 and PE3.

Meanwhile, the first initialization voltage line VIL1 may transmit the first initialization voltage VINT1 as, for example, a constant power (e.g., a constant voltage).

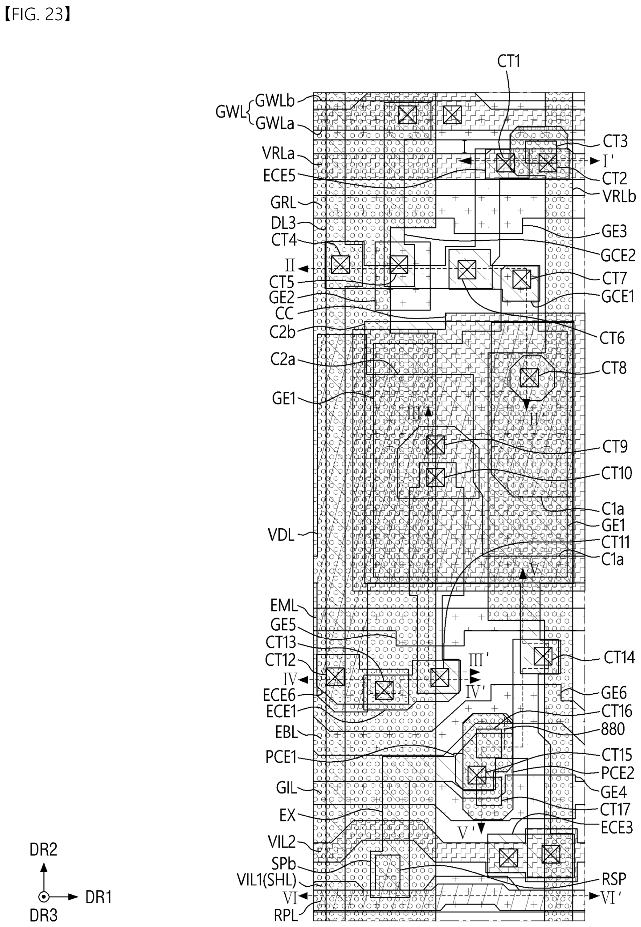

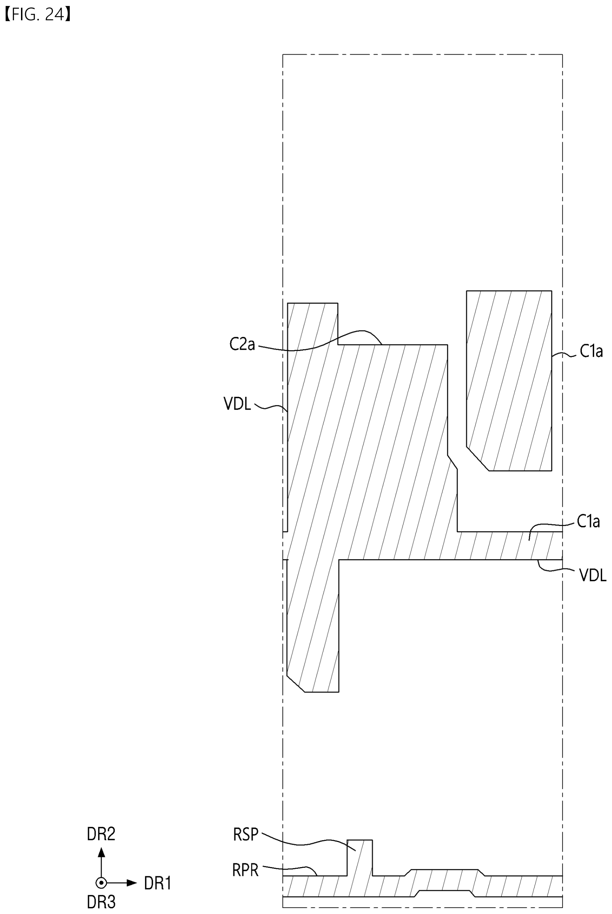

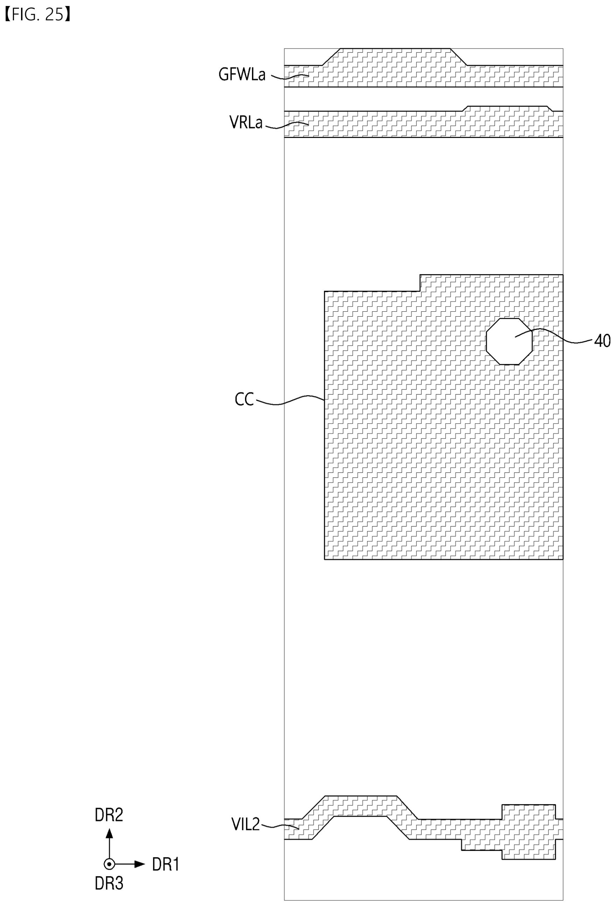

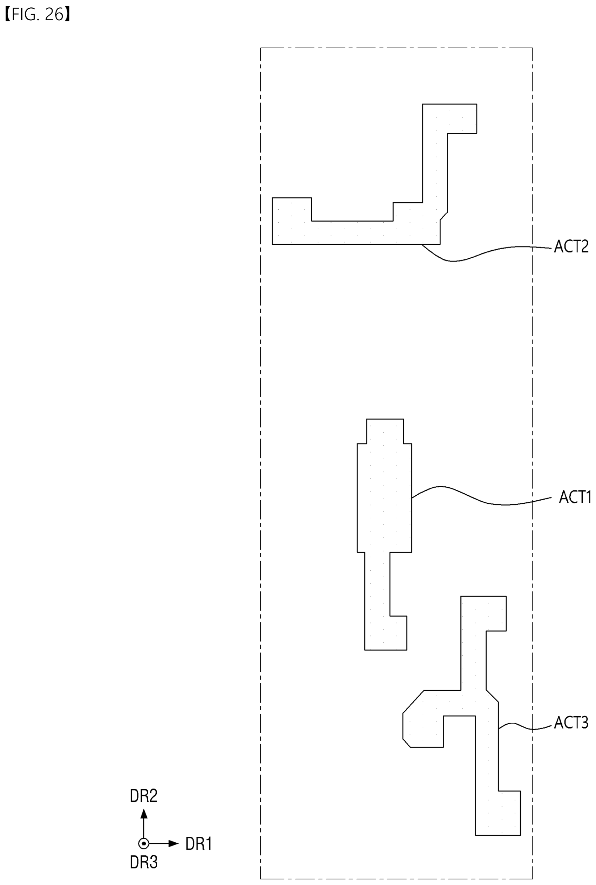

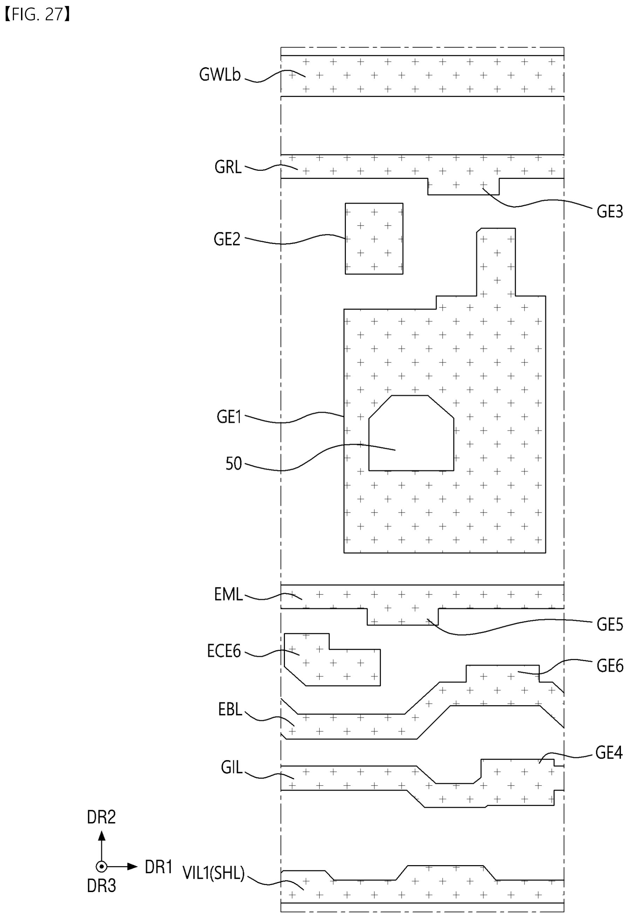

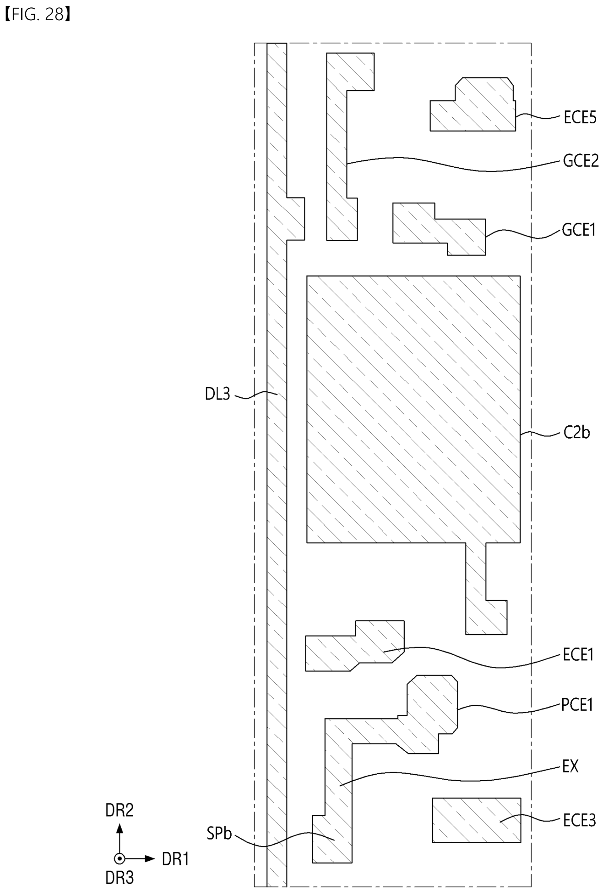

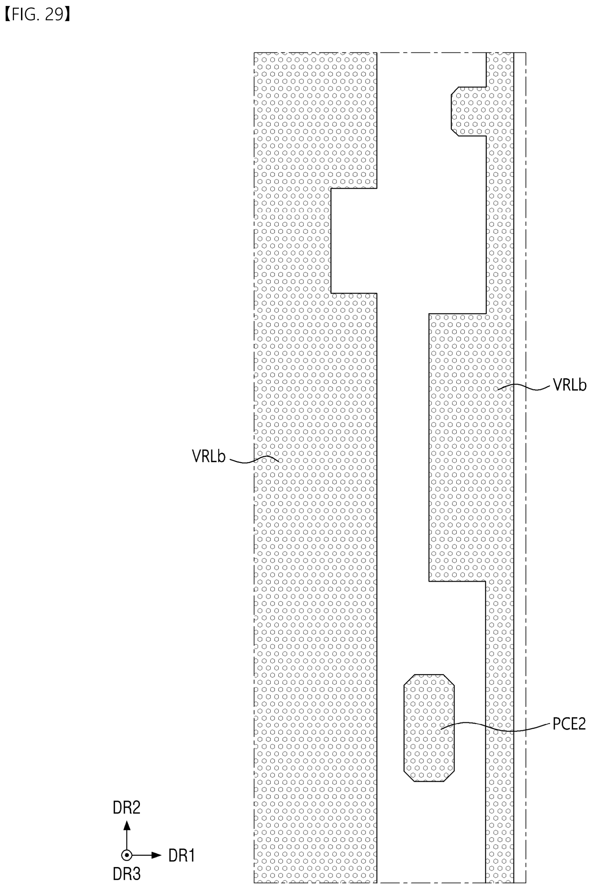

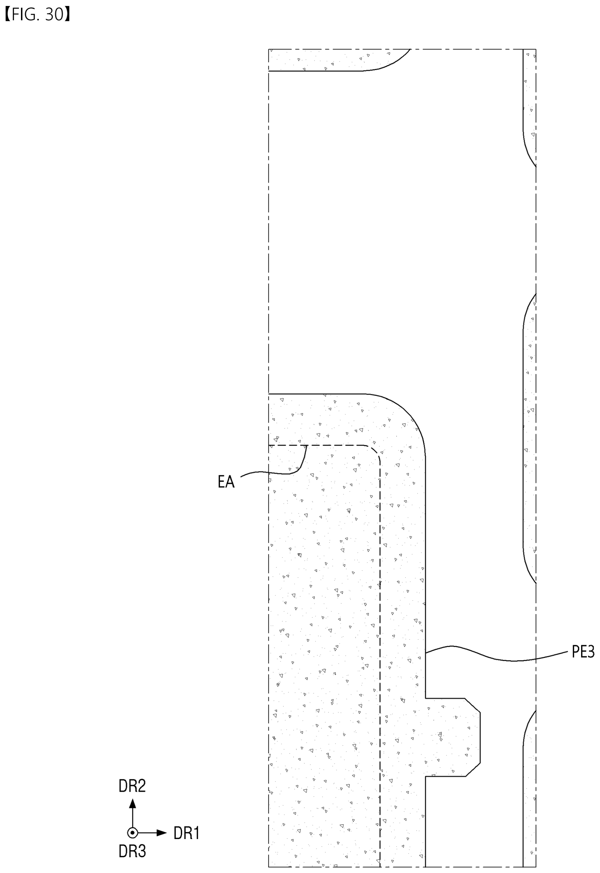

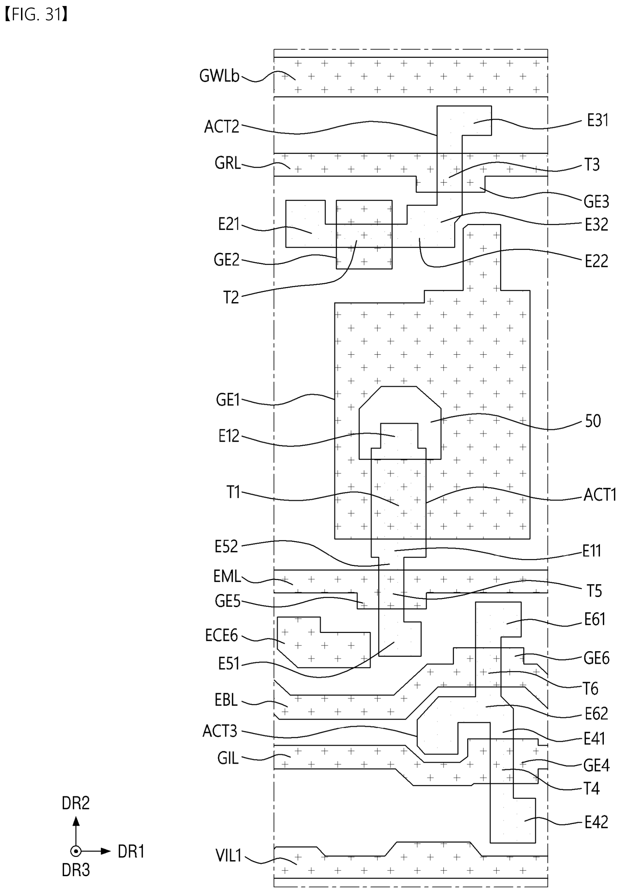

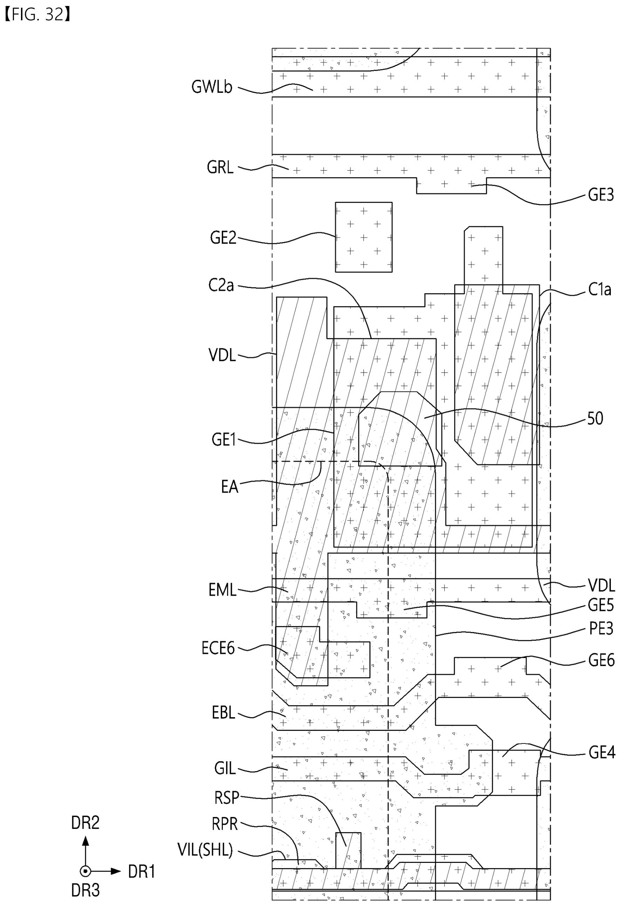

FIG. 23 is an enlarged view of part B of FIG. 22A. For example, FIG. 23 is an enlarged view of a third pixel including the third pixel circuit PC3 and the third pixel electrode PE3 of FIG. 22A. FIG. 24 is a plan view selectively showing only the first conductive layer among the components of FIG. 23, FIG. 25 is a plan view selectively showing only the second conductive layer among the components of FIG. 23, FIG. 26 is a plan view selectively showing only the third conductive layer among the components of FIG. 23, FIG. 27 is a plan view selectively showing only the fourth conductive layer among the components of FIG. 23, FIG. 28 is a plan view selectively showing only the fifth conductive layer among the components of FIG. 23, FIG. 29 is a plan view selectively showing only the sixth conductive layer among the components of FIG. 23, FIG. 30 is a plan view selectively showing only the seventh conductive layer among the components of FIG. 23, FIG. 31 is a plan view selectively showing only the third and fourth conductive layers among the components of FIG. 23, and FIG. 32 is a plan view selectively illustrating only the first, third, and seventh conductive layers among the components of FIG. 23.

The first conductive layer illustrated in FIGS. 23 and 24 may be disposed on the substrate SUB along the third direction DR3. The first conductive layer may serve as a voltage line for transmitting a voltage, serve as the first lower capacitor electrode C1a, and serve as the second lower capacitor electrode C2a. On the other hand, among components included in the first conductive layer, the repair line RPL may be used to normalize defective pixels.

As illustrated in FIGS. 23 and 24, the first conductive layer may include the first driving voltage line VDL, the first lower capacitor electrode C1a, the second lower capacitor electrode C2a, and the repair line RPL.

The first driving voltage line VDL may extend along the first direction DR1 and the second direction DR2 (and/or a second reverse direction). Meanwhile, the second lower capacitor electrode C2a may be integrally formed with the first driving voltage line VDL.

The electrode of the first capacitor C1 may be disposed adjacent to the electrode of the second capacitor C2.

The repair line RPL may extend along the first direction DR1. The repair line RPL may include the repair short portion RSP protruding along the second direction DR2.

The first conductive layer may be made of the same material as the first conductive layer of FIG. 5A.

The second conductive layer illustrated in FIGS. 23 and 25 may be disposed on the first conductive layer along the third direction DR3, so that an insulating layer may be disposed between the first conductive layer and the second conductive layer.

As illustrated in FIGS. 23 and 25, the second conductive layer may include the first lower scan line GWLa, the lower reference voltage line VRLa, the common capacitor electrode CC, and the second initialization voltage line VIL2.

The first lower scan line GWLa may be applied with the first scan line GWL, and the lower reference voltage line VRLa may be applied with the reference voltage VREF.

The common capacitor electrode CC may include each of the electrodes of the first capacitor C1 and the second capacitor C2. Meanwhile, the common capacitor electrode CC may have a hole 40 penetrating it.

The second conductive layer may be made of the same material as the first conductive layer of FIG. 5A. Alternatively, the second conductive layer may be made of, for example, titanium aluminide (TiAl).

The third conductive layer illustrated in FIGS. 23 and 26 may be disposed on a second conductive layer along the third direction DR3, so that an insulating layer may be disposed between the second conductive layer and the third conductive layer.

The third conductive layer may be a semiconductor layer, and as illustrated in FIGS. 23 and 26, may include the first semiconductor layer ACT1, the second semiconductor layer ACT2, and the third semiconductor layer ACT3.

The first semiconductor layer ACT1 may provide the channel regions, the first electrodes (e.g., E11 in FIG. 31), and the second electrodes (e.g., E12 in FIG. 31) of the first transistor T1 and the fifth transistor T5. For example, the first semiconductor layer ACT1 may include the first channel region of the first transistor T1, the fifth channel region of the fifth transistor T5, the first electrode E11 of the first transistor T1, the second electrode E12 of the first transistor T1, the first electrode E51 of the fifth transistor T5, and the second electrode E52 of the fifth transistor T5.

The second semiconductor layer ACT2 may provide the channel regions, the first electrodes (e.g., E21 and E31), and the second electrodes (e.g., E22 and E32) of the second transistor T2 and the third transistor T3. For example, the second semiconductor layer ACT2 may include the second channel region of the second transistor T2, the third channel region of the third transistor T3, the first electrode E21 of the second transistor T2, the second electrode E22 of the second transistor T2, the first electrode E31 of the third transistor T3, and the second electrode E32 of the third transistor T3.

The third semiconductor layer ACT3 may provide the channel regions, the first electrodes (e.g., E41 and E61), and the second electrodes (e.g., E42 and E62) of the fourth transistor T4 and the sixth transistor T6. For example, the second semiconductor layer ACT2 may include the fourth channel region of the fourth transistor T4, the sixth channel region of the sixth transistor T6, the first electrode E41 of the fourth transistor T4, the second electrode E42 of the fourth transistor T4, the first electrode E61 of the sixth transistor T6, and the second electrode E62 of the sixth transistor T6.

The fourth conductive layer illustrated in FIGS. 23 and 27 may be disposed on the third conductive layer along the third direction DR3, so that an insulating layer may be disposed between the third conductive layer and the fourth conductive layer.

As illustrated in FIGS. 23 and 27, the fourth conductive layer may include the first upper scan line GWLb, the third scan line GRL, the third gate electrode GE3, the second gate electrode GE2, the first gate electrode GE1, the emission control line EML, the fifth gate electrode GE5, the sixth line connection electrode ECE6, the fourth scan line EBL, the sixth gate electrode GE6, the second scan line GIL, the fourth gate electrode GE4, and the first initialization voltage line VIL1. Here, the third gate electrode GE3 may be integrally formed with the third scan line GRL, the fifth gate electrode GE5 may be integrally formed with the emission control line EML, the sixth gate electrode GE6 may be integrally formed with the fourth scan line EBL, and the fourth gate electrode GE4 may be integrally formed with the second scan line GIL.

The first scan signal GW may be applied to the first upper scan line GWLb, the third scan signal GR may be applied to the third scan line GRL, the emission control signal EM may be applied to the emission control line EML, the second scan signal GI may be applied to the second scan line GIL, and the first initialization voltage VINT1 may be applied to the first initialization voltage line VIL1.

Meanwhile, the first gate electrode GE1 may have a hole 50 penetrating it.

The fourth conductive layer may be made of the same material as the third conductive layer of FIG. 5A described above.

The fifth conductive layer illustrated in FIGS. 23 and 28 may be disposed on the fourth conductive layer along the third direction DR3, so that an insulating layer may be disposed between the fourth conductive layer and the fifth conductive layer.

The fifth conductive layer may include the third data line DL3, the first gate connection electrode GCE1, the second gate connection electrode GCE2, the first pixel connection electrode PCE1, the extension portion EX, the counter short portion SPb, the first line connection electrode ECE1, the third line connection electrode ECE3, the fifth line connection electrode ECE5, and the second upper capacitor electrode C2b.

The third data line DL3 may extend along the second direction DR2. A third data signal may be applied.

The second upper capacitor electrode C2b together with the second lower capacitor electrode C2a described above may constitute the second capacitor C2.

The third data line DL3 may be connected to the corresponding second semiconductor layer ACT2 through the contact hole of the insulating layer.

The first gate connection electrode GCE1 may connect the first gate electrode GE1 of the first transistor T1 to the second transistor T2 and the third transistor T3 through the contact holes of the insulating layer.

The second gate connection electrode GCE2 may connect the second gate electrode GE2 of the second transistor T2 to the first upper scan line GWLb through the contact holes of the insulating layer.

The first line connection electrode ECE1 may connect the first electrode E51 (e.g., a source electrode or a drain electrode) of the fifth transistor T5 and the sixth line connection electrode ECE6 to each other through the contact holes of the insulating layer.

The sixth line connection electrode ECE6 may connect the first line connection electrode ECE1 and the first driving voltage line VDL described above to each other through the contact holes of the insulating layer.

The third line connection electrode ECE3 may connect the second electrode E42 (e.g., a source electrode or a drain electrode) of the fourth transistor T4 provided in the third pixel circuit PC3 and the second initialization voltage line VIL2 to each other through the contact holes of the insulating layer.

The fifth line connection electrode ECE5 may connect the first electrode (e.g., a source electrode or a drain electrode) of the third transistor T3 and the lower reference voltage line VRLa to each other through the contact holes of the insulating layer.

Meanwhile, as illustrated in FIG. 22A, the second line connection electrode ECE2 may connect the second electrode E42 (e.g., a source electrode or a drain electrode) of the fourth transistor T4 provided in the first pixel circuit PC1 and the first initialization voltage line VIL1 to each other through the contact holes of the insulating layer.

The first pixel connection electrode PCE1 may include the extension portion EX. An end of the extension portion EX (e.g., the counter short portion SPb of the extension portion EX) may overlap the repair short portion RSP of the repair line RPL.

The sixth conductive layer illustrated in FIGS. 23 and 29 may be disposed on the fifth conductive layer along the third direction DR3, so that an insulating layer may be disposed between the fifth conductive layer and the sixth conductive layer.

The sixth conductive layer may include the upper reference voltage line VRLb and the second pixel connection electrode PCE2.

As illustrated in FIG. 23, the upper reference voltage line VRLb may be connected to the lower reference voltage line VRLa through the contact hole of the insulating layer.

As illustrated in FIG. 23, the second pixel connection electrode PCE2 may be connected to the first pixel connection electrode PCE1 through the contact hole of the insulating layer.

The seventh conductive layer illustrated in FIGS. 23 and 30 may be disposed on the sixth conductive layer along the third direction DR3, so that an insulating layer may be disposed between the sixth conductive layer and the seventh conductive layer.

The seventh conductive layer may include the first to third pixel electrodes PE1 to PE3. FIGS. 23 and 30 illustrate the third pixel electrode PE3 as an example of the seventh conductive layer.

Among the first to third pixel electrodes PE1 to PE3, the third pixel electrode PE3 may have the largest area.

Parts of the first pixel electrode PE1, the second pixel electrode PE2, and the third pixel electrode PE3 may be exposed by the first emission area, the second emission area, and the third emission area of the bank PDL, respectively.

Each of the first to third pixel electrodes PE1 to PE3 may be connected to the corresponding sixth transistor T6 through the corresponding contact hole of the insulating layer, the corresponding second pixel connection electrode PCE2, and the corresponding first pixel connection electrode PCE1. For example, the third pixel electrode PE3 may be connected to the second electrode E62 (e.g., the source electrode or the drain electrode of the sixth transistor T6) of the sixth transistor T6 through the contact hole of the insulating layer, the second pixel connection electrode PCE2, and the first pixel connection electrode PCE1.

As illustrated in FIG. 32, in plan view, the first initialization voltage line VIL1 may be disposed to overlap all remaining portions except for the repair short portion RSP of the repair line RPL.

In addition, the repair line RPL, the first initialization voltage line VIL1 thereabove, and the third pixel electrode PE3 thereabove may overlap each other. In this case, the repair line RPL, the first initialization voltage line VIL1, and the third pixel electrode PE3 may be sequentially disposed along the third direction DR3. In other words, the first initialization voltage line VIL1 may be disposed between the repair line RPL and the third pixel electrode PE3. In particular, the first initialization voltage line VIL1 may overlap most of the repair line RPL in the emission area EA. Accordingly, most of the overlapping area between the repair line RPL and the third pixel electrode PE3 in the emission area EA may be covered by the first initialization voltage line VIL1. Meanwhile, as another embodiment, the first initialization voltage line VIL1 may entirely overlap the repair line RPL positioned in the emission area EA. In this case, the first initialization voltage line VIL1 may entirely cover all the overlapping areas between the repair line RPL and the third pixel electrode PE3 in the emission area EA.

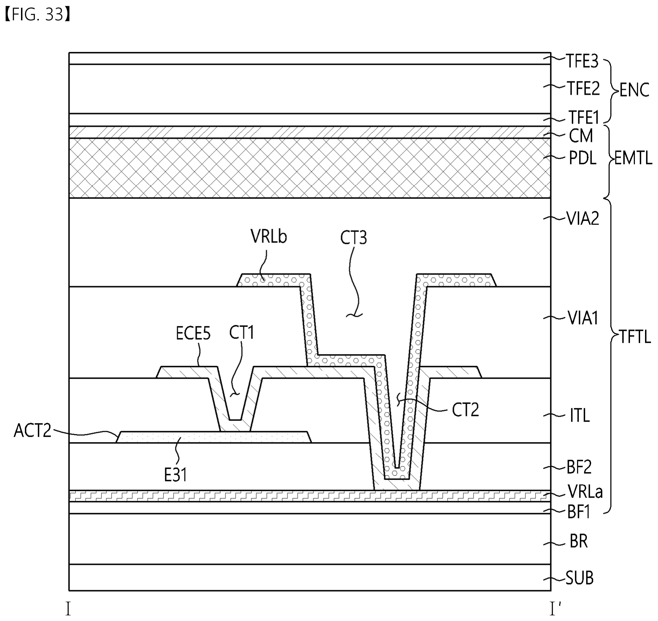

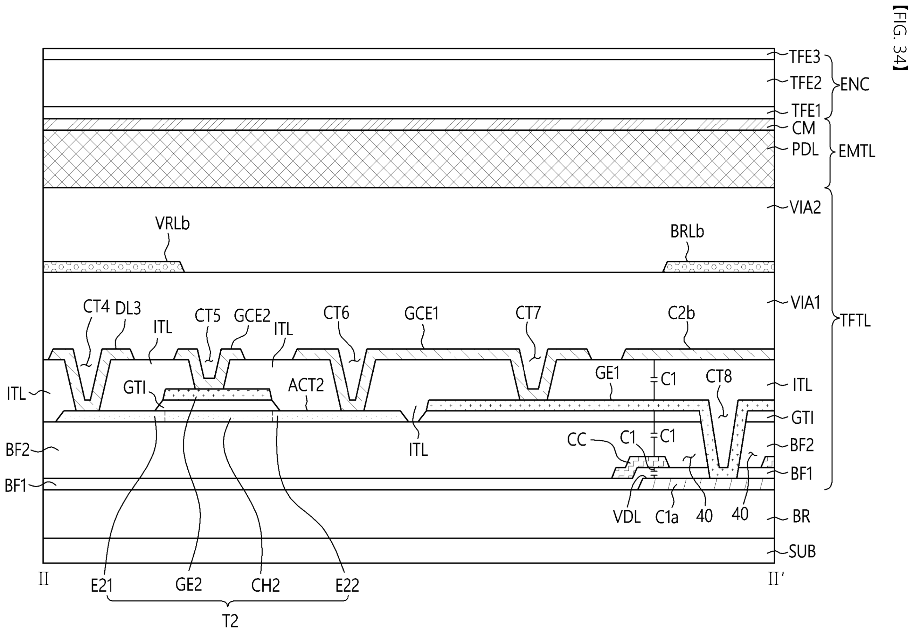

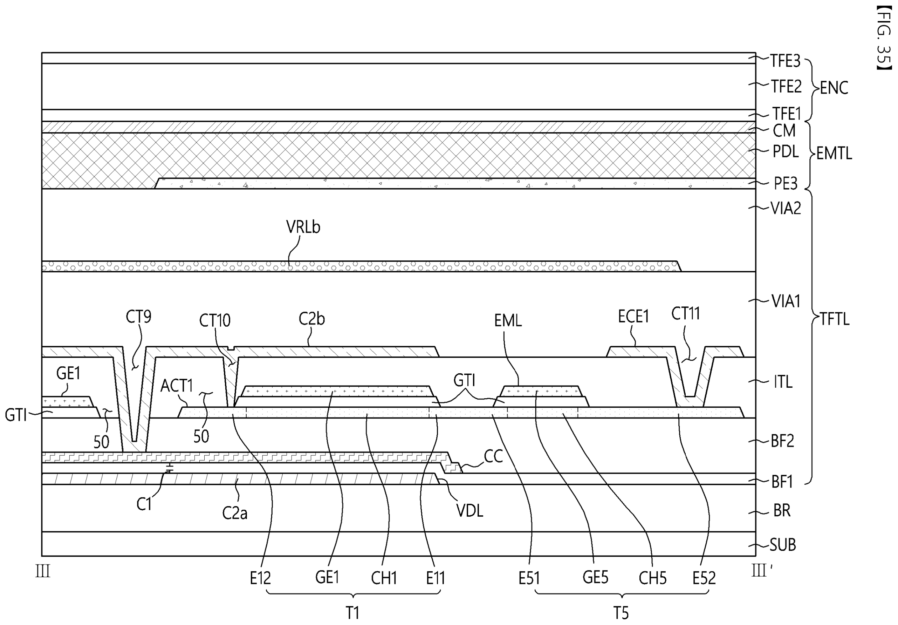

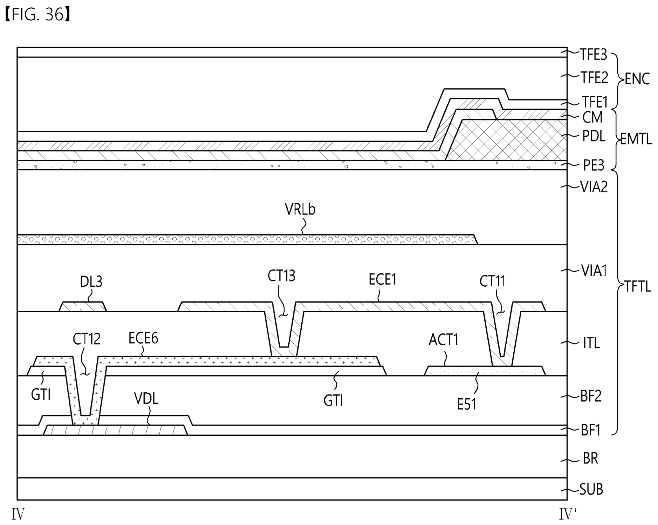

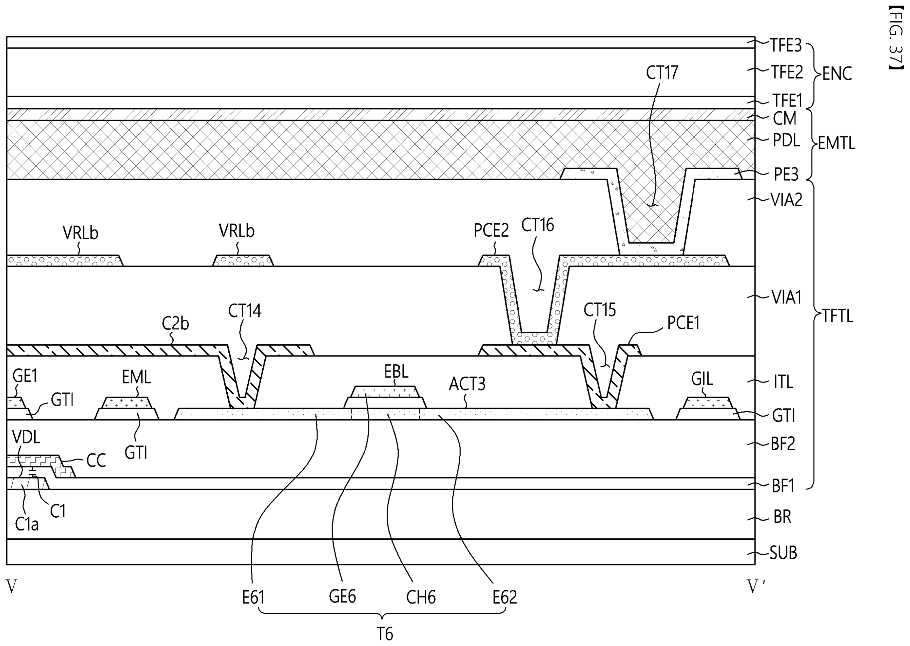

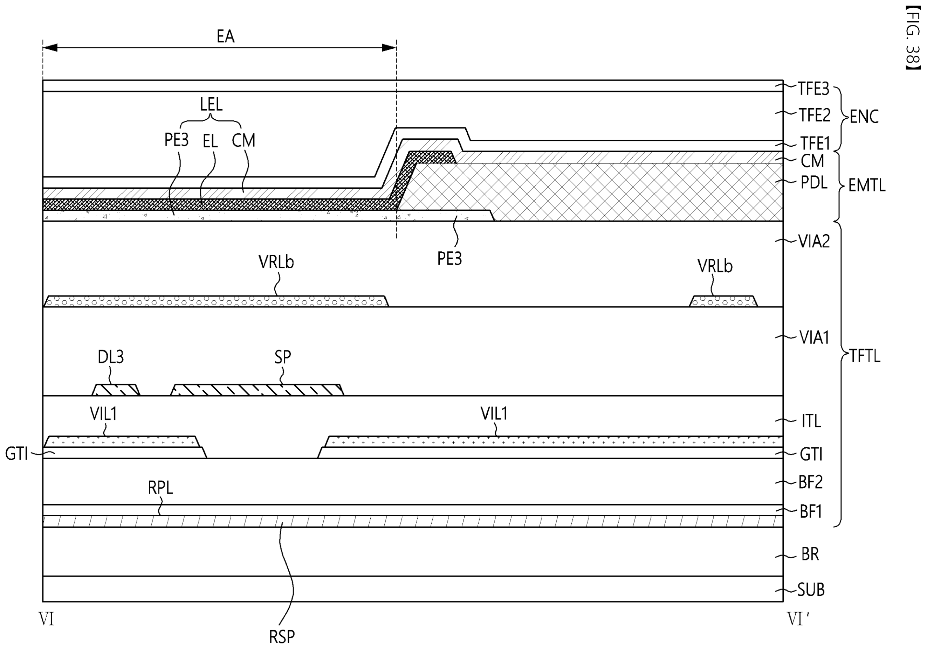

FIG. 33 is a cross-sectional view taken along line I-I' of FIG. 23, FIG. 34 is a cross-sectional view taken along line II-II' of FIG. 23, and FIG. 35 is a cross-sectional view taken along line III-III' of FIG. 23. FIG. 36 is a cross-sectional view taken along line IV-IV' of FIG. 23, FIG. 37 is a cross-sectional view taken along line V-V' of FIG. 23, and FIG. 38 is a cross-sectional view taken along line VI-VI' of FIG. 23.

As illustrated in FIGS. 33 to 38, the display device 1 may include the substrate SUB, the barrier layer BR, the thin film transistor layer TFTL, the light emitting element layer EMTL, and the encapsulation layer ENC. The barrier layer BR, the thin film transistor layer TFTL, the light emitting element layer EMTL, and the encapsulation layer ENC may be sequentially disposed on the substrate SUB along the third direction DR3. Here, the thin film transistor layer TFTL may include the aforementioned pixel circuit (e.g., the third pixel circuit PC3).

The substrate SUB may be made of the same material as the substrate of FIGS. 14 to 19 described above.

As illustrated in FIGS. 33 to 38, the barrier layer BR may be disposed on the substrate SUB. The barrier layer BR may be made of the same material as the barrier layer BR of FIGS. 14 to 19 described above.

The aforementioned first conductive layer, for example, the first driving voltage line VDL, the first lower capacitor electrode C1a, the second lower capacitor electrode C2a, and the repair line RPL may be disposed on the barrier layer BR. For example, each of FIGS. 36, 34, and 35 illustrates an example in which the first driving voltage line VDL, the first lower capacitor electrode C1a, and the second lower capacitor electrode C2a are disposed on the barrier layer. The first conductive layer may be made of the same material as the first conductive layer of FIGS. 14 to 19 described above.

As illustrated in FIGS. 33 to 38, a first buffer layer BF1 may be disposed on the first conductive layer. The first buffer layer BF1 may be made of the same material as the buffer layer BF of FIGS. 14 to 19 described above.

The aforementioned second conductive layer, for example, the first lower scan line GWLa, the lower reference voltage line VRLa, the common capacitor electrode CC, and the second initialization voltage line VIL2 may be disposed on the first buffer layer BF1. For example, each of FIGS. 33 and 34 illustrates an example in which the lower reference voltage line VRLa and the common capacitor electrode CC are disposed on the first buffer layer BF1. The second conductive layer may be made of the same material as the first conductive layer of FIGS. 14 to 19 described above. In addition, for another example, the second conductive layer may be made of, for example, titanium aluminide (TiAl).

Meanwhile, as illustrated in FIG. 34, the first capacitor C1 may be formed in an area in which the first lower capacitor electrode C1a and the common capacitor electrode CC overlap. As illustrated in FIG. 35, the second capacitor C2 may be formed in an area in which the second lower capacitor electrode C2a and the common capacitor electrode CC overlap. In addition, as illustrated in FIG. 37, the first capacitor C1 may be formed in an area in which the first lower capacitor electrode C1a of the first driving voltage line VDL and the common capacitor electrode CC overlap.

As illustrated in FIGS. 33 to 38, the second buffer layer BF2 may be disposed on the first lower scan line GWLa, the lower reference voltage line VRLa, the common capacitor electrode CC, and the second initialization voltage line VIL2. The second buffer layer BF2 may be made of the same material as the first buffer layer BF1 described above.

The aforementioned third conductive layer, for example, the first semiconductor layer ACT1, the second semiconductor layer ACT2, and the third semiconductor layer ACT3 may be disposed on the second buffer layer BF2. The third conductive layer may be made of the same material as the second conductive layer of FIGS. 14 to 19 described above. For example, each of FIGS. 35, 34, and 37 illustrates an example in which the first semiconductor layer ACT1, the second semiconductor layer ACT2, and the third semiconductor layer ACT3 are disposed on the second buffer layer BF2.

As illustrated in FIGS. 33 to 38, the gate insulating layer GTI may be disposed on the first semiconductor layer ACT1, the second semiconductor layer ACT2, and the third semiconductor layer ACT3. As described above, the gate insulating layer GTI may be patterned to have the same shape as the fourth conductive layer to be described later. For example, the gate insulating layer GTI may have the same shape as the first upper scan line GWLb, the third scan line GRL, the third gate electrode GE3, the second gate electrode GE2, the first gate electrode GE1, the emission control line EML, the fifth gate electrode GE5, the sixth line connection electrode ECE6, the fourth scan line EBL, the sixth gate electrode GE6, the second scan line GIL, the fourth gate electrode GE4, and the first initialization voltage line VIL1. The gate insulating layer GTI may be formed of the same material as the gate insulating layer GTI of FIGS. 14 to 19 described above.

The fourth conductive layer, for example, the first upper scan line GWLb, the third scan line GRL, the third gate electrode GE3, the second gate electrode GE2, the first gate electrode GE1, the emission control line EML, the fifth gate electrode GE5, the sixth line connection electrode ECE6, the fourth scan line EBL, the sixth gate electrode GE6, the second scan line GIL, the fourth gate electrode GE4, and the first initialization voltage line VIL1 may be disposed on the gate insulating layer GTI. For example, FIG. 34 illustrates an example in which the first gate electrode GE1 and the second gate electrode GE2 are disposed on the gate insulating layer GTI, FIG. 35 illustrates an example in which the first gate electrode GE1 and the fifth gate electrode GE5, and the emission control line EML are disposed on the gate insulating layer GTI, FIG. 36 illustrates an example in which the sixth line connection electrode ECE6 is disposed on the gate insulating layer GTI, and FIG. 37 illustrates an example in which the first gate electrode GE1, the emission control line EML, the fourth scan line EBL, and the second scan line GIL are disposed on the gate insulating layer GTI. The fourth conductive layer may be made of the same material as the third conductive layer of FIGS. 14 to 19 described above.

Meanwhile, as illustrated in FIG. 34, the first gate electrode GE1 may be connected to the first lower capacitor electrode C1a through the eighth contact hole CT8 penetrating the gate insulating layer GTI, the second buffer layer BF2, the hole 40 of the common capacitor electrode CC, and the first buffer layer BF1. In addition, as illustrated in FIG. 34, the first capacitor C1 may be formed in an area in which the first gate electrode GE1 and the common capacitor electrode CC overlap. In addition, as illustrated in FIG. 36, the sixth line connection electrode ECE6 may be connected to the first driving voltage line VDL through the twelfth contact hole CT12 penetrating the gate insulating layer GTI, the second buffer layer BF2, and the first buffer layer BF1. In addition, as illustrated in FIG. 38, the first initialization voltage line VIL1 corresponding to the shielding line may overlap the remaining portion of the repair line RPL except for the repair short portion RSP. In addition, as illustrated in FIG. 38, the first initialization voltage line VIL1 may overlap the third pixel electrode PE3. In other words, the first initialization voltage line VIL1 may be disposed in all areas of the overlapping area between the repair line RPL and the third pixel electrode PE3 except for the repair short portion RSP.

As illustrated in FIGS. 33 to 38, the interlayer insulating layer ITL may be disposed on the first upper scan line GWLb, the third scan line GRL, the third gate electrode GE3, the second gate electrode GE2, the first gate electrode GE1, the emission control line EML, the fifth gate electrode GE5, the sixth line connection electrode ECE6, the fourth scan line EBL, the sixth gate electrode GE6, the second scan line GIL, the fourth gate electrode GE4, and the first initialization voltage line VIL1. The interlayer insulating layer ITL may be made of the same material as the interlayer insulating layer ITL of FIGS. 14 to 19 described above.

The fifth conductive layer described above, for example, the third data line DL3, the first gate connection electrode GCE1, the second gate connection electrode GCE2, the first pixel connection electrode PCE1, the extension portion EX, the counter short portion SPb, the first line connection electrode ECE1, the third line connection electrode ECE3, the fifth line connection electrode ECE5, and the second upper capacitor electrode C2b may be disposed on the interlayer insulating layer ITL. For example, FIG. 33 illustrates an example in which the fifth line connection electrode ECE5 is disposed on the interlayer insulating layer ITL, FIG. 34 illustrates an example in which the third data line DL3, the second gate connection electrode GCE2, the first gate connection electrode GCE1, and the second upper capacitor electrode C2b are disposed on the interlayer insulating layer ITL, FIG. 35 illustrates an example in which the second upper capacitor electrode C2b and the first line connection electrode ECE1 are disposed on the interlayer insulating layer ITL, FIG. 36 illustrates an example in which the third data line DL3 and the first line connection electrode ECE1 are disposed on the interlayer insulating layer ITL, FIG. 37 illustrates an example in which the second upper capacitor electrode C2b and the first pixel connection electrode PCE1 are disposed on the interlayer insulating layer ITL, and FIG. 38 illustrates an example in which the third data line DL3 and the counter short portion SPb of the first pixel connection electrode PCE1 are disposed on the interlayer insulating layer ITL. The fifth conductive layer may be made of the same material as the fourth conductive layer of FIGS. 14 to 19 described above.

Meanwhile, as illustrated in FIG. 33, one side of the fifth line connection electrode ECE5 may be connected to the first electrode E31 of the third transistor T3 through the first contact hole CT1 penetrating the interlayer insulating layer ITL, and the other side of the fifth line connection electrode ECE5 may be connected to the lower reference voltage line VRLa through the second contact hole CT2 penetrating the interlayer insulating layer ITL and the second buffer layer BF2. In addition, as illustrated in FIG. 34, the third data line DL3 may be connected to the first electrode E21 of the second transistor T2 through the fourth contact hole CT4 penetrating the interlayer insulating layer ITL. In addition, as illustrated in FIG. 34, the second gate connection electrode GCE2 may be connected to the second gate electrode GE2 through the fifth contact hole CT5 penetrating the interlayer insulating layer ITL, so that another part of the second gate connection electrode GCE2 may be connected to the first upper scan line GWLb through a contact hole penetrating the interlayer insulating layer ITL. In addition, as illustrated in FIG. 35, one side of the second upper capacitor electrode C2b may be connected to the common capacitor electrode CC through the ninth contact hole CT9 penetrating the interlayer insulating layer ITL, the hole 50 of the first gate electrode GE1, and the second buffer layer BF2, another side of the second upper capacitor electrode C2b may be connected to the second electrode E12 of the first transistor T1 through the tenth contact hole CT10 penetrating the interlayer insulating layer ITL and the hole 50 of the first gate electrode GE1, and as illustrated in FIG. 37, the other side of the second upper capacitor electrode C2b may be connected to the first electrode E61 of the sixth transistor T6 through a fourteenth contact hole CT14 penetrating the interlayer insulating layer ITL. In addition, as illustrated in FIG. 35, one side of the first line connection electrode ECE1 may be connected to the second electrode E52 of the fifth transistor T5 through the eleventh contact hole CT11 penetrating the interlayer insulating layer ITL, and as illustrated in FIG. 36, the other side of the first line connection electrode ECE1 may be connected to the sixth line connection electrode ECE6 through the thirteenth contact hole CT13 penetrating the interlayer insulating layer ITL. In addition, as illustrated in FIG. 37, the first pixel connection electrode PCE1 may be connected to the second electrode of the sixth transistor T6 through a fifteenth contact hole CT15 penetrating the first planarization layer VIA1.

As illustrated in FIGS. 33 to 38, the first planarization layer VIA1 may be disposed on the third data line DL3, the first gate connection electrode GCE1, the second gate connection electrode GCE2, the first pixel connection electrode PCE1, the extension portion EX, the counter short portion SPb, the first line connection electrode ECE1, the third line connection electrode ECE3, the fifth line connection electrode ECE5, and the second upper capacitor electrode C2b. The first planarization layer VIA1 may be formed of the same material as the planarization layer VIA of FIGS. 14 to 19 described above.

As illustrated in FIGS. 33 to 38, the sixth conductive layer described above, for example, the upper reference voltage line VRLb and the second pixel connection electrode PCE2 may be disposed on the first planarization layer VIA1. The sixth conductive layer may be made of the same material as the fourth conductive layer of FIGS. 14 to 19 described above.

Meanwhile, as illustrated in FIG. 33, the upper reference voltage line VRLb may be connected to the fifth line connection electrode ECE5 through the third contact hole CT3 penetrating the first planarization layer VIA1.

In addition, as illustrated in FIG. 37, the second pixel connection electrode PCE2 may be connected to the first pixel connection electrode PCE1 through a sixteenth contact hole CT16 penetrating the first planarization layer VIA1.

As illustrated in FIGS. 33 to 38, a second planarization layer VIA2 may be disposed on the upper reference voltage line VRLb and the second pixel connection electrode PCE2. The second planarization layer VIA2 may be formed of the same material as the planarization layer VIA of FIGS. 14 to 19 described above.

As illustrated in FIGS. 35 to 38, a seventh conductive layer, for example, the third pixel electrode PE3 may be disposed on the second planarization layer VIA2. The seventh conductive layer may be made of the same material as the fifth conductive layer of FIGS. 14 to 19 described above.

Meanwhile, as illustrated in FIG. 37, the third pixel electrode PE3 may be connected to the second pixel connection electrode PCE2 through a seventeenth contact hole CT17 penetrating the second planarization layer VIA2.

The bank PDL, the common electrode CM, the first encapsulation inorganic layer TFE1, the encapsulation organic layer TFE2, and the second encapsulation inorganic layer TFE3 may be sequentially disposed on the second pixel connection electrode PCE2. The bank PDL, the common electrode CM, the first encapsulation inorganic layer TFE1, the encapsulation organic layer TFE2, and the second encapsulation inorganic layer TFE3 refer to the description of corresponding components of FIGS. 14 to 19 described above.

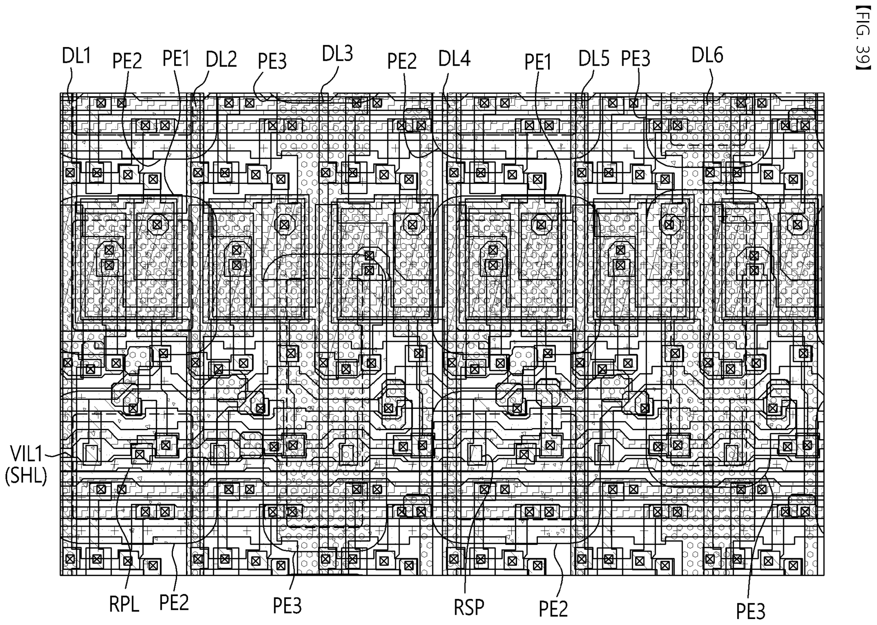

FIG. 39 is a plan view of an array in which a plurality of unit pixels of FIG. 22A are disposed.

FIG. 39 is a diagram illustrating the disposition of a plurality of unit pixels of FIG. 22A described above. For example, the first to third pixel electrodes PE1 to PE3 connected to the first to third data lines DL1 to DL3 through the corresponding pixel circuits may be pixel electrodes of a first unit pixel, and the first to third pixel electrodes PE1 to PE3 respectively connected to the fourth to sixth data lines DL4 to DL6 through the corresponding pixel circuits may be pixel electrodes of a second unit pixel.

As illustrated in FIG. 39, the first initialization voltage line VIL1 corresponding to the shielding line overlaps all remaining portions of the repair line RPL except for the repair short portion RSP, and as a result, the capacitance between all components (e.g., a pixel electrode, a data line, and the like) intersecting the repair line RPL may be minimized.

Meanwhile, during the repair process of the defective pixel in the structure illustrated in FIG. 23, as illustrated in FIG. 23, a part of the third semiconductor layer ACT3 may be cut by irradiating laser from a lower portion of the substrate SUB along the direction of the cutting line 880. Accordingly, the connection between the third pixel circuit PC3 and the third pixel electrode PE3 may be blocked.

Thereafter, the laser is irradiated toward the overlapping portion of the repair short portion RSP of the repair line RPL and the counter short portion SPb of the first pixel connection electrode PCE1 from the lower portion of the substrate SBU, so that the repair line RPL and the first pixel connection electrode PCE1 may be in contact with each other. Accordingly, the third pixel electrode PE3 may receive a voltage supplied from the dummy pixel to the repair line RPL. Accordingly, the light emitting element including the third pixel electrode PE3 may emit light normally.

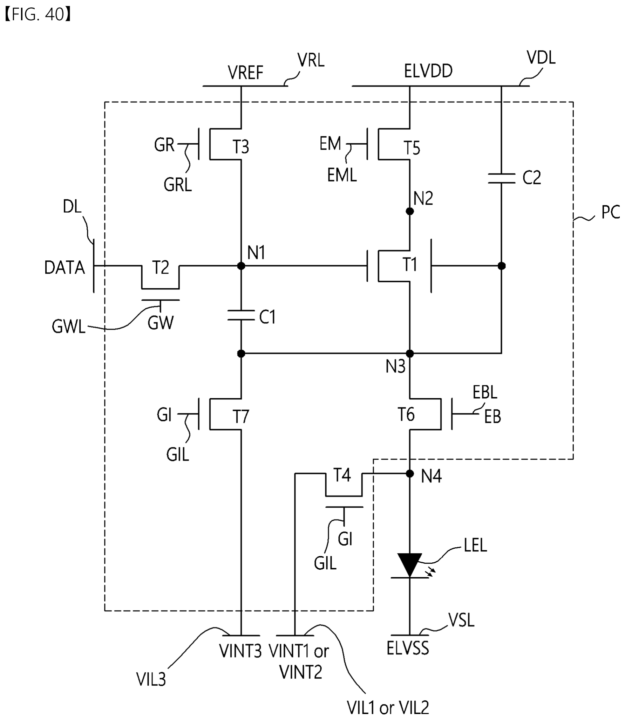

FIG. 40 is a diagram illustrating a pixel circuit and a light emitting element of a pixel according to one embodiment of the present disclosure.

Referring to FIG. 40, the pixel PX may include the light emitting element LEL (e.g., an organic light emitting diode) as a display element and the pixel circuit PC connected to the light emitting element LEL. The pixel circuit PC may include the first to seventh transistors T1 to T7 and the first and second capacitors C1 and C2.

The pixel circuit of FIG. 40 is different from the pixel circuit of FIG. 21 described above in that the seventh transistor T7 is further included, so that the difference will be mainly described as follows. Meanwhile, since the first to sixth transistors T1 to T6 of FIG. 40 are substantially the same as the first to sixth transistors T1 to T6 of FIG. 21 described above, the description of the first to sixth transistors T1 to T6 of FIG. 40 refers to the description of the first to sixth transistors T1 to T6 of FIG. 21.

The seventh transistor T7 may include a seventh gate electrode connected to the second scan line GIL, a first electrode connected to the third node N3, and a second electrode connected to a third initialization voltage line VIL3.

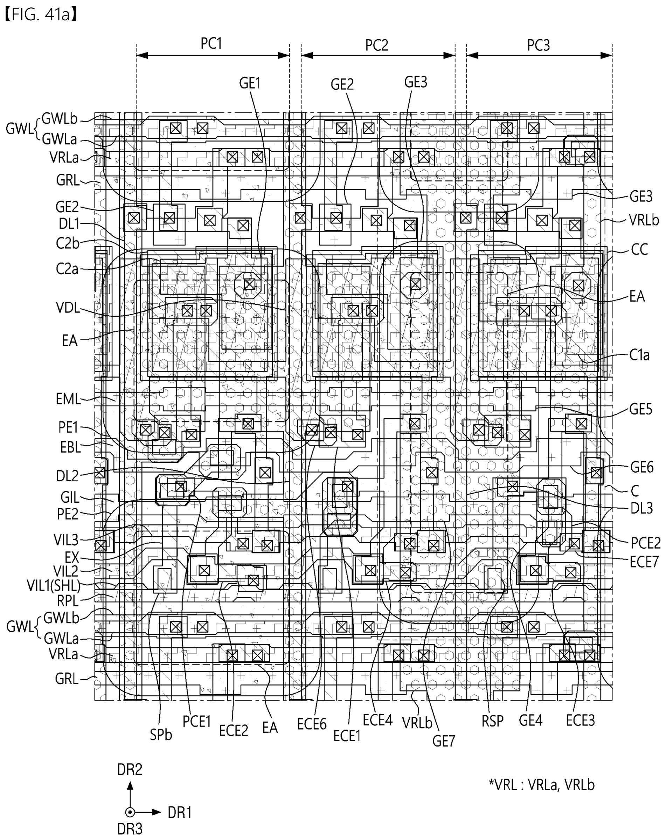

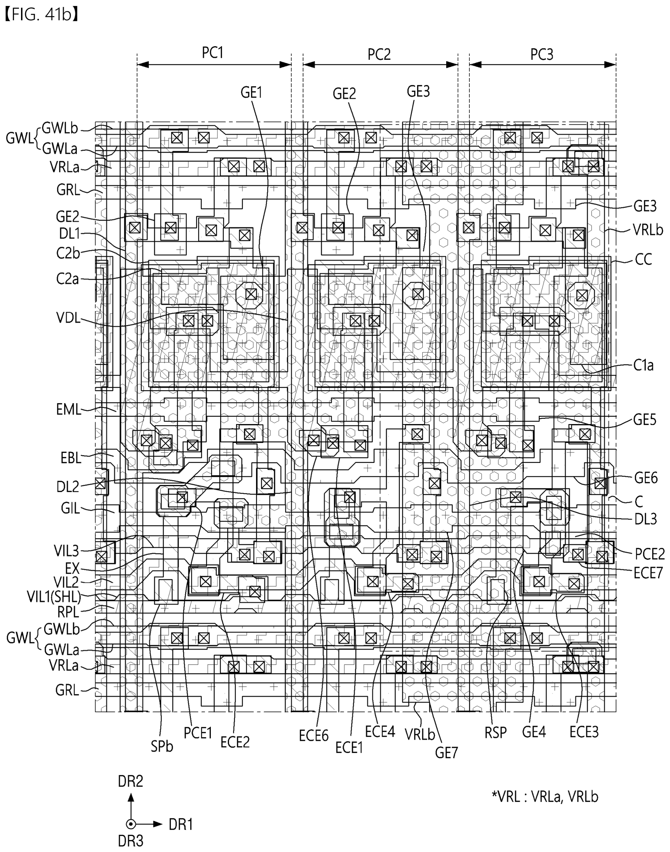

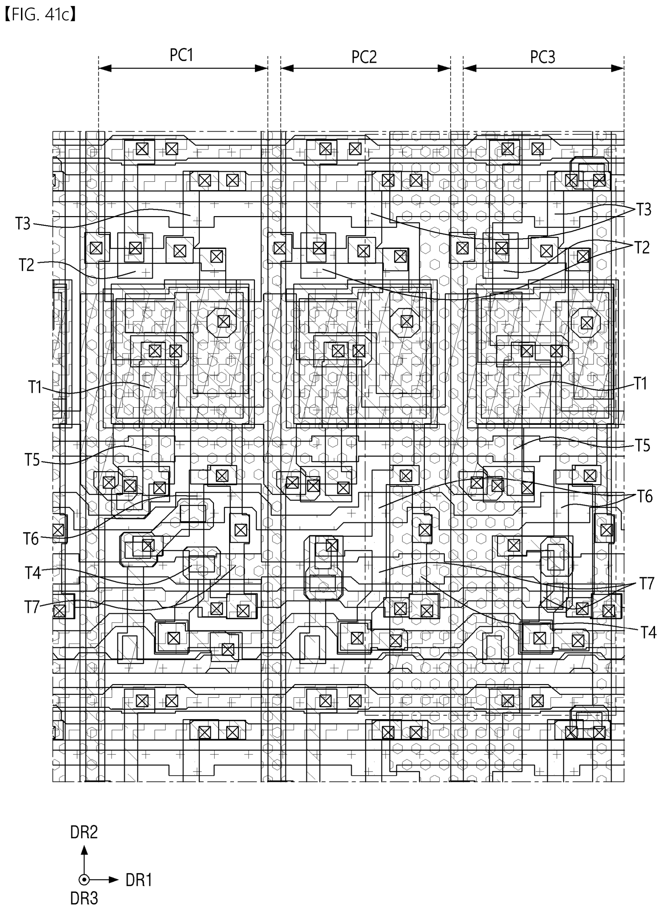

FIG. 41A is a plan view of a pixel array of a display device according to one embodiment of the present disclosure including the pixel circuit of FIG. 40, FIG. 41B is a plan view of FIG. 41A in which pixel electrodes and emission areas are removed, and FIG. 41C is a plan view of FIG. 41A in which except for the reference numerals of the transistors and the reference numerals of the capacitors, the remaining reference numerals are removed.

As illustrated in FIGS. 41A to 41C, the display device 1 according to one embodiment of the present disclosure may include the first to third pixel circuits PC1 to PC3 and the first to third pixel electrodes PE1 to PE3 respectively connected to the first to third pixel circuits PC1 to PC3.

Here, the first pixel circuit PC1 and the first pixel electrode PE1 may be the pixel circuit and the pixel electrode of the first pixel PX1, the second pixel circuit PC2 and the second pixel electrode PE2 may be the pixel circuit and the pixel electrode of the second pixel PX2, and the third pixel circuit PC3 and the third pixel electrode PE3 may be the pixel circuit and the pixel electrode of the third pixel PX3. Meanwhile, the first to third pixels PX1 to PX3 may form one unit pixel.

The first to third pixels PX1 to PX3 of the unit pixel may include light emitting layers providing light of different wavelengths. For example, the first pixel PX1 may include a light emitting layer that provides light of a first wavelength (e.g., light of a red wavelength), the second pixel PX2 may include a light emitting layer that provides light of a second wavelength (e.g., light of a green wavelength), and the third pixel PX3 may include a light emitting layer that provides light of a third wavelength (e.g., light of a blue wavelength).

Each of the pixel circuits PC1 to PC3 of the pixels PX1 to PX3 may include the first to seventh transistors T1 to T7, the first capacitor C1, and the second capacitor C2. For example, each of the pixel circuits PC1 to PC3 of the first to third pixels PX1 to PX3 will be described in detail.

The first pixel circuit PC1 may include, for example, the first to seventh transistors T1 to T7, the first capacitor C1, and the second capacitor C2 disposed in a defined area surrounded by the first data line DL1, the second data line DL2, the first scan line GWL, and the first initialization voltage line VIL1 (or the repair line RPL). The first pixel circuit PC1 may be connected to, for example, the first pixel electrode PE1, the first data line DL1, the first scan line GWL, the second scan line GIL, the third scan line GRL, the fourth scan line EBL, the first driving voltage line VDL, the reference voltage line VRL, the first initialization voltage line VIL1, and the third initialization voltage line VIL3. Here, the first scan line GWL may include a first lower scan line GWLa and a first upper scan line GWLb connected to each other through the contact hole of the insulating layer, and the reference voltage line VRL may include the upper reference voltage line VRLb and the lower reference voltage line VRLa connected to each other through the contact hole of the insulating layer. Meanwhile, the first initialization voltage line VIL1 may perform a function of transmitting the first initialization voltage VINT1 and a function as a shielding line. The third initialization voltage line VIL3 may transmit a third initialization voltage VINT3. The third initialization voltage VINT3 may be, for example, equal to the first initialization voltage VINT1, or less than or greater than the first initialization voltage VINT1.

The second pixel circuit PC2 may include, for example, the first to seventh transistors T1 to T7, the first capacitor C1, and the second capacitor C2 disposed in a defined area surrounded by the second data line DL2, the third data line DL3, the first scan line GWL, and the first initialization voltage line VIL1 (or the repair line RPL). The second pixel circuit PC2 may be connected to, for example, the second pixel electrode PE2, the second data line DL2, the first scan line GWL, the second scan line GIL, the third scan line GRL, the fourth scan line EBL, the first driving voltage line VDL, the reference voltage line VRL, the second initialization voltage line VIL2, and the third initialization voltage line VIL3.

The third pixel circuit PC3 may include, for example, the first to seventh transistors T1 to T7, the first capacitor C1, and the second capacitor C2 disposed in a defined area surrounded by the third data line DL3, the fourth data line DL4, the first scan line GWL, and the first initialization voltage line VIL1 (or the repair line RPL). The third pixel circuit PC3 may be connected to, for example, the third pixel electrode PE3, the third data line DL3, the first scan line GWL, the second scan line GIL, the third scan line GRL, the fourth scan line EBL, the first driving voltage line VDL, the reference voltage line VRL, the second initialization voltage line VIL2, and the third initialization voltage line VIL3.

A part of each of the first pixel electrode PE1, the second pixel electrode PE2, and the third pixel electrode PE3 may be exposed by the bank PDL. For example, the bank PDL may include the emission area EA exposing a part of the first pixel electrode PE1, the emission area EA exposing a part of the second pixel electrode PE2, and the emission area EA exposing a part of the third pixel electrode PE3. Each of the emission areas EA may correspond to a part excluding an edge of a corresponding pixel electrode.

Among the pixel electrodes PE1 to PE3 included in one unit pixel, the third pixel electrode PE3 may have the largest area. In other words, among the three pixels of one unit pixel, the third pixel (e.g., the pixel including the third pixel circuit PC3) may include the pixel electrode having the largest area (e.g., the third pixel electrode PE3).

Meanwhile, the array structure of FIG. 41A is different from the array structure of FIG. 22A described above in that the seventh transistor T7 and the third initialization voltage line VIL3 connected thereto are further included, so that the difference will be mainly described as follows.

A seventh gate electrode GE7 of the seventh transistor T7 may be connected to the second scan line GIL, a first electrode of the seventh transistor T7 may be connected to the third initialization voltage line VIL3, and a second electrode of the seventh transistor T7 may be connected to the first capacitor C1, the second capacitor C2, the first transistor T1, and the sixth transistor T6.

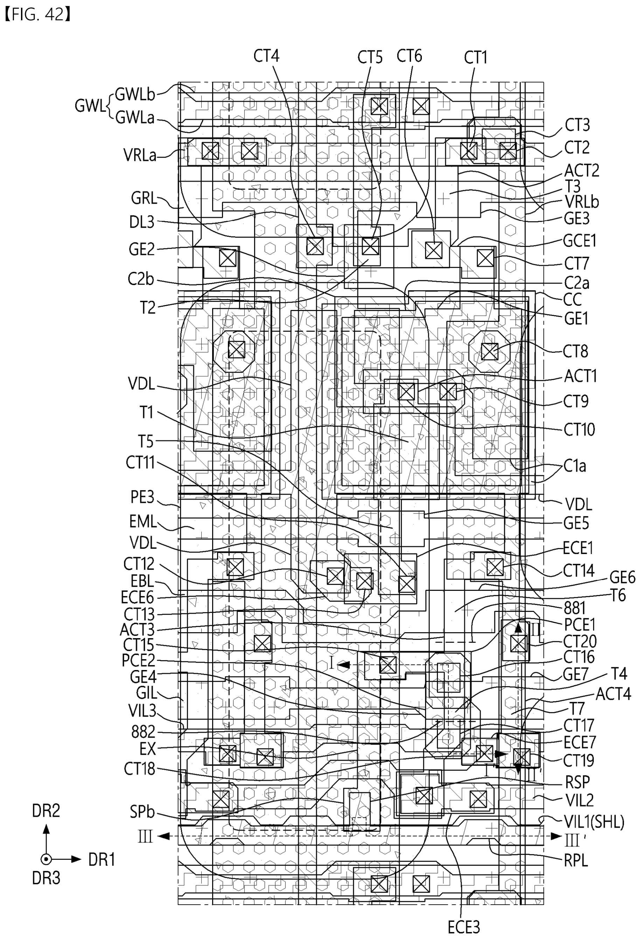

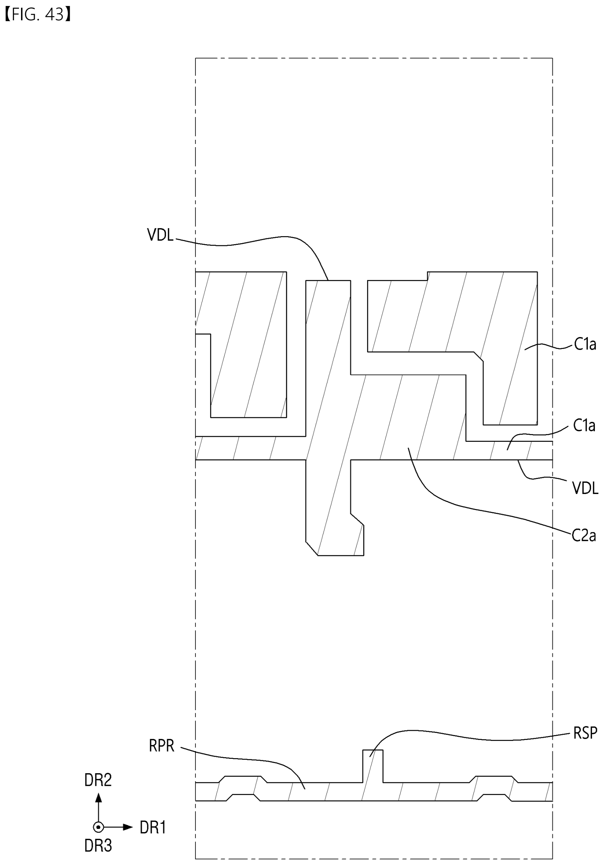

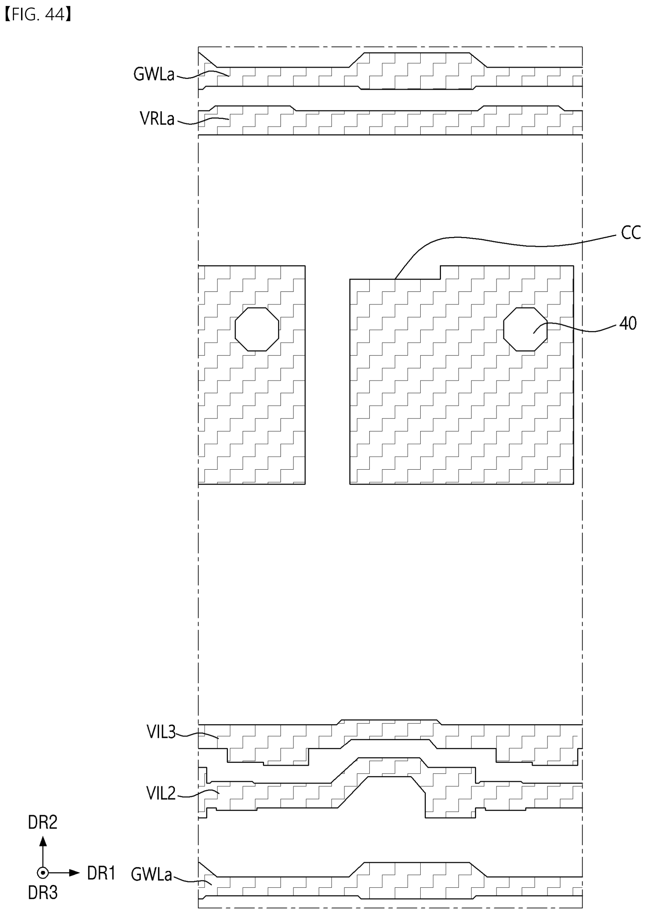

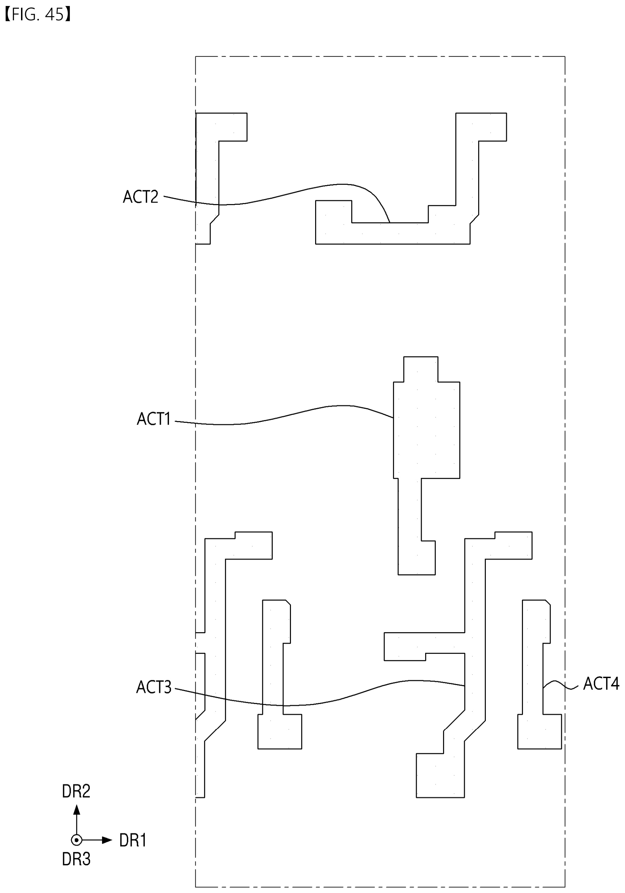

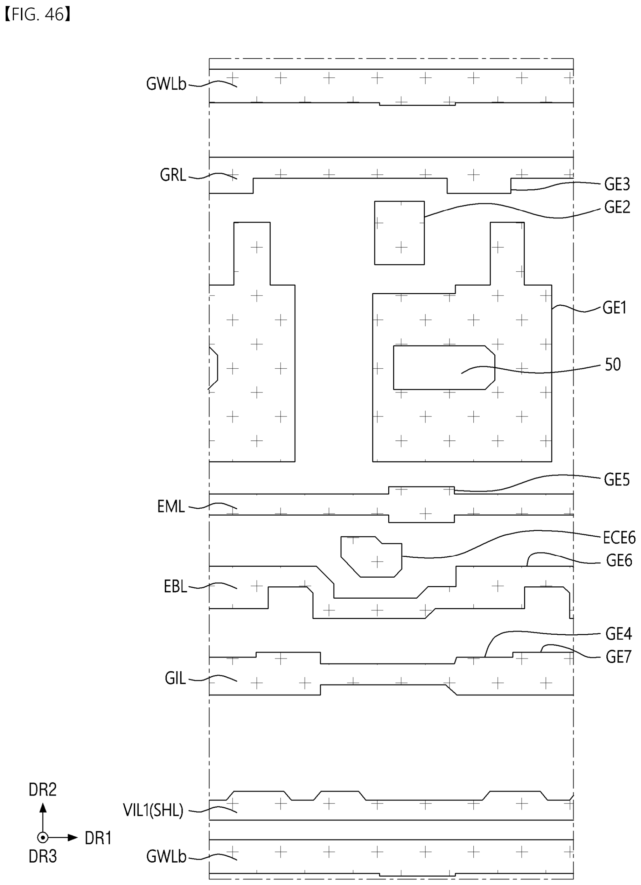

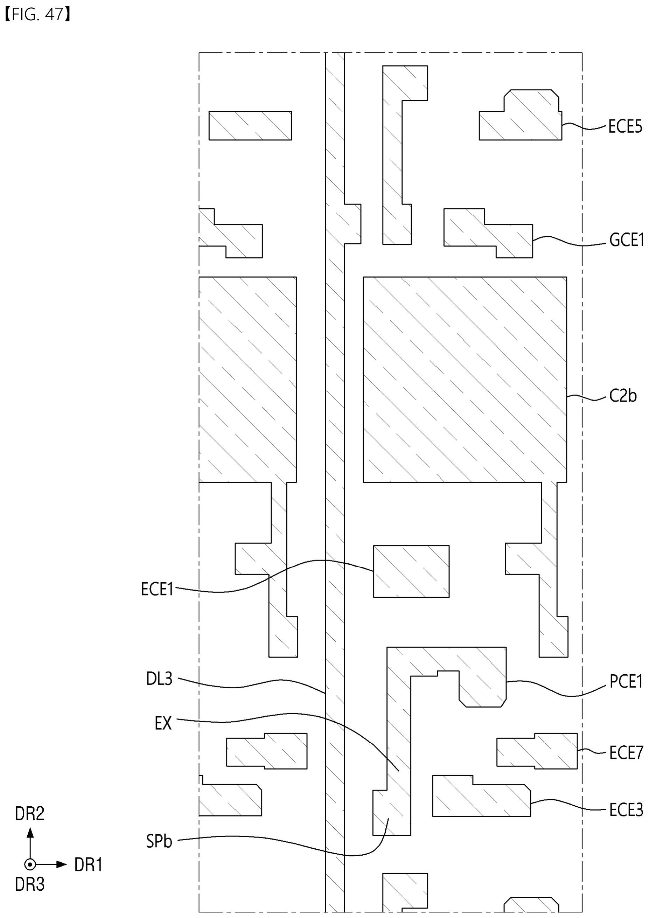

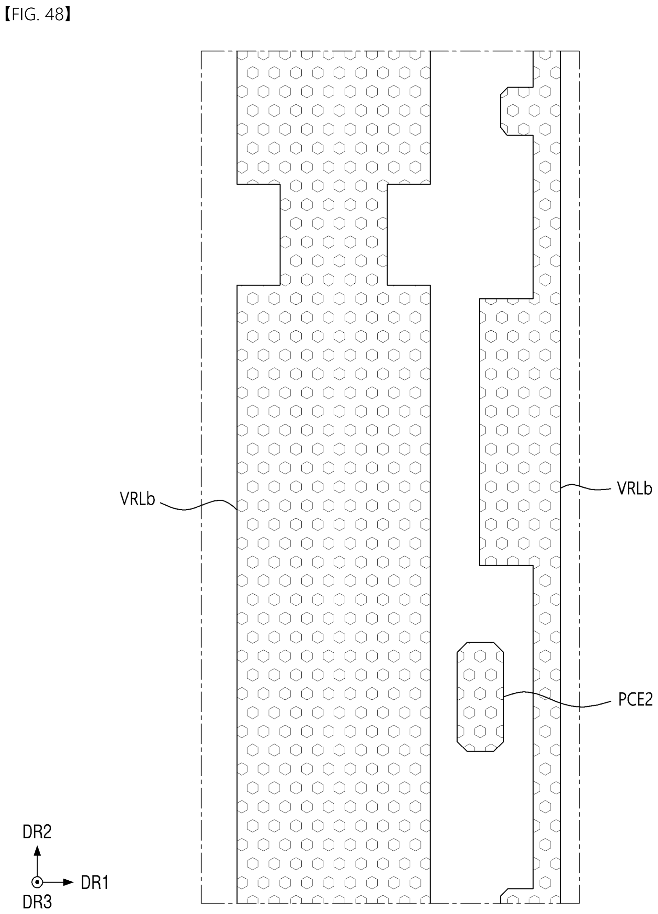

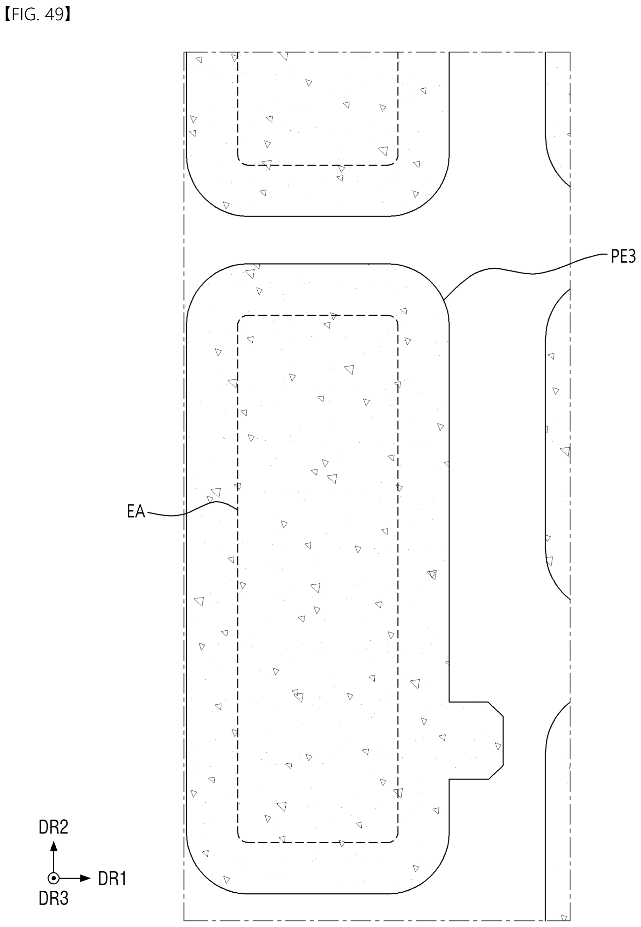

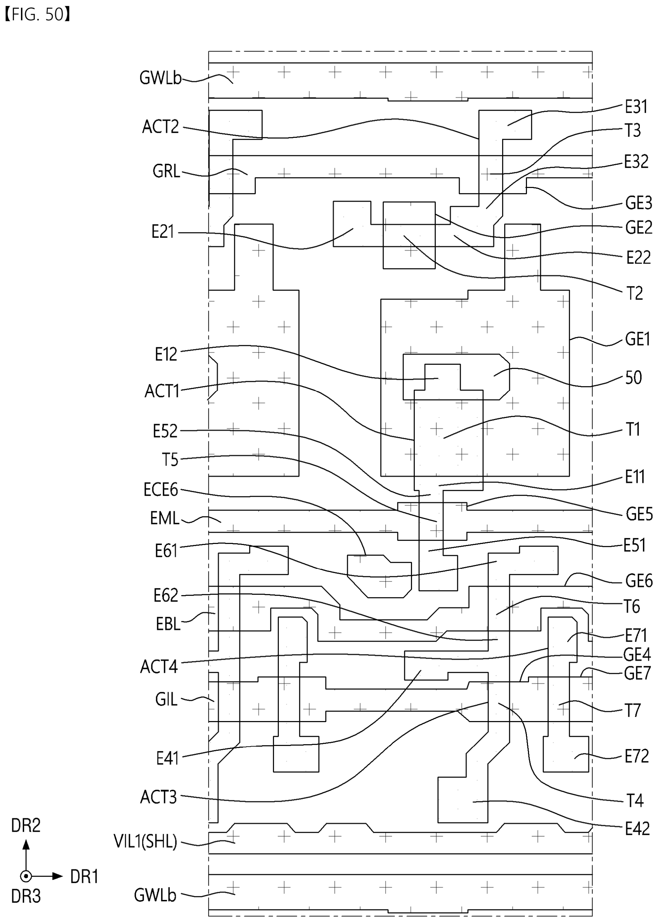

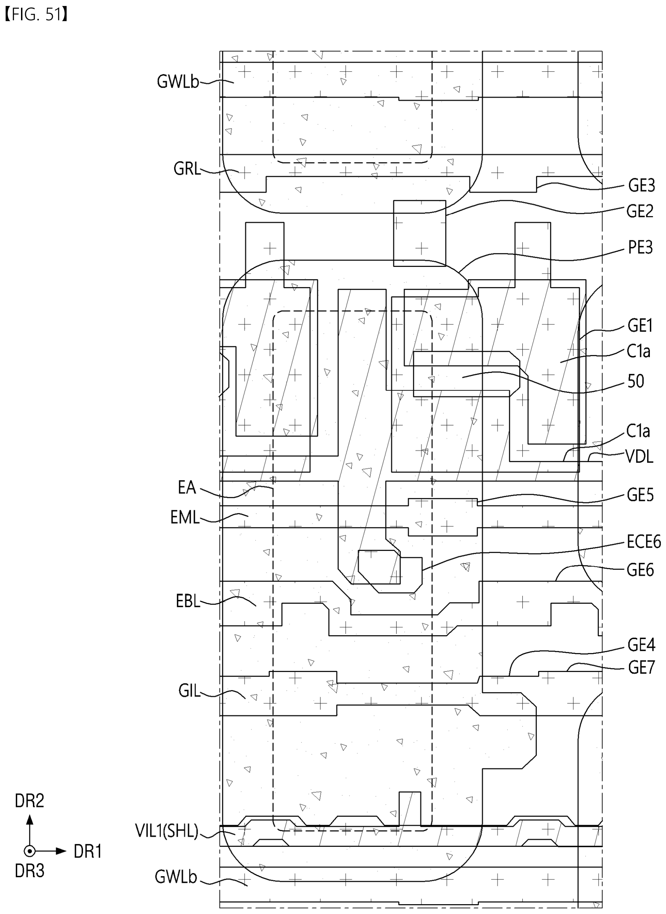

FIG. 42 is an enlarged view of part C of FIG. 41A. For example, FIG. 42 is an enlarged view of a third pixel including the third pixel circuit PC3 and the third pixel electrode PE3 of FIG. 41A. FIG. 43 is a plan view selectively showing only the first conductive layer among the components of FIG. 42, FIG. 44 is a plan view selectively showing only the second conductive layer among the components of FIG. 42, FIG. 45 is a plan view selectively showing only the third conductive layer among the components of FIG. 42, FIG. 46 is a plan view selectively showing only the fourth conductive layer among the components of FIG. 42, FIG. 47 is a plan view selectively showing only the fifth conductive layer among the components of FIG. 42, FIG. 48 is a plan view selectively showing only the sixth conductive layer among the components of FIG. 42, FIG. 49 is a plan view selectively showing only the seventh conductive layer among the components of FIG. 42, FIG. 50 is a plan view selectively showing only the third and fourth conductive layers among the components of FIG. 42, and FIG. 51 is a plan view selectively illustrating only the first, third, and seventh conductive layers among the components of FIG. 42.

In FIGS. 42 to 48, the first to sixth transistors T1 to T6, the first conductive layer (e.g., the first driving voltage line VDL, the first lower capacitor electrode C1a, the second lower capacitor electrode C2a, and repair line RPL), the second conductive layer (e.g., the first lower scan line GWLa, the lower reference voltage line VRLa, the common capacitor electrode CC, and the second initialization voltage line VIL2), the third conductive layer (e.g., the first semiconductor layer ACT1, the second semiconductor layer ACT2, and the third semiconductor layer ACT3), the fourth conductive layer (e.g., the first upper scan line GWLb, the third scan line GRL, the third gate electrode GE3, the second gate electrode GE2, the first gate electrode GE1, the emission control line EML, the fifth gate electrode GE5, the sixth line connection electrode ECE6, the fourth scan line EBL, the sixth gate electrode GE6, the second scan line GIL, the fourth gate electrode GE4, and the first initialization voltage line VIL1), the fifth conductive layer (e.g., the third data line DL3, the first gate connection electrode GCE1, the second gate connection electrode GCE2, the first pixel connection electrode PCE1, the extension portion EX, the counter short portion SPb, the first line connection electrode ECE1, the third line connection electrode ECE3, the fifth line connection electrode ECE5, and the second upper capacitor electrode C2b), the sixth conductive layer (e.g., the upper initialization voltage line and the second pixel connection electrode PCE2), and the seventh conductive layer (e.g., the third pixel electrode PE3) are substantially the same as the first to sixth transistors T1 to T6 and the first to seventh conductive layers of FIGS. 22A to 32 described above, so that the description of the first to seventh conductive layers of FIGS. 42 to 48 refers to the description related to FIGS. 22 to 32. Hereinafter, the seventh transistor T7 and the third initialization voltage line VIL3 connected thereto will be described as differences other than the same points.

For example, as illustrated in FIG. 44, the second conductive layer may further include the third initialization voltage line VIL3. A third initialization voltage may be applied to the third initialization voltage line VIL3. The third initialization voltage line VIL3 may extend along the first direction DR1. The third initialization voltage line VIL3 may be disposed between, for example, the common capacitor electrode CC and the second initialization voltage line VIL2. Meanwhile, the third initialization voltage line VIL3 may be made of, for example, the same material as the first initialization voltage line VIL1.

In addition, as illustrated in FIG. 45, the third conductive layer may further include a fourth semiconductor layer ACT4. As illustrated in FIGS. 45 and 50, the fourth semiconductor layer ACT4 may provide a channel region of the seventh transistor T7, a first electrode E71, and a second electrode E72. For example, the fourth semiconductor layer ACT4 may include the seventh channel region of the seventh transistor T7, the first electrode E71 of the seventh transistor T7, and the second electrode E72 of the seventh transistor T7. Meanwhile, the fourth semiconductor layer ACT4 may be made of the same material as the first to third semiconductor layers ACT1 to ACT3 described above.

In addition, as illustrated in FIG. 46, the fourth conductive layer may further include the seventh gate electrode GE7. For example, the seventh gate electrode GE7 may be included in the second scan line GIL of the fourth conductive layer. In other words, the seventh gate electrode GE7 may be integrally formed with the second scan line GIL.

In addition, as illustrated in FIG. 47, the fifth conductive layer may further include a seventh line connection electrode ECE7. The seventh line connection electrode ECE7 may connect the second electrode E72 of the seventh transistor T7 to the third initialization voltage line VIL3 through contact holes of the insulating layer.

As illustrated in FIG. 51, in plan view, the first initialization voltage line VIL1 may be disposed to overlap all remaining portions except for the repair short portion RSP of the repair line RPL. Meanwhile, a detailed description of the repair line RPL of FIG. 51 refers to FIG. 32 and related descriptions.

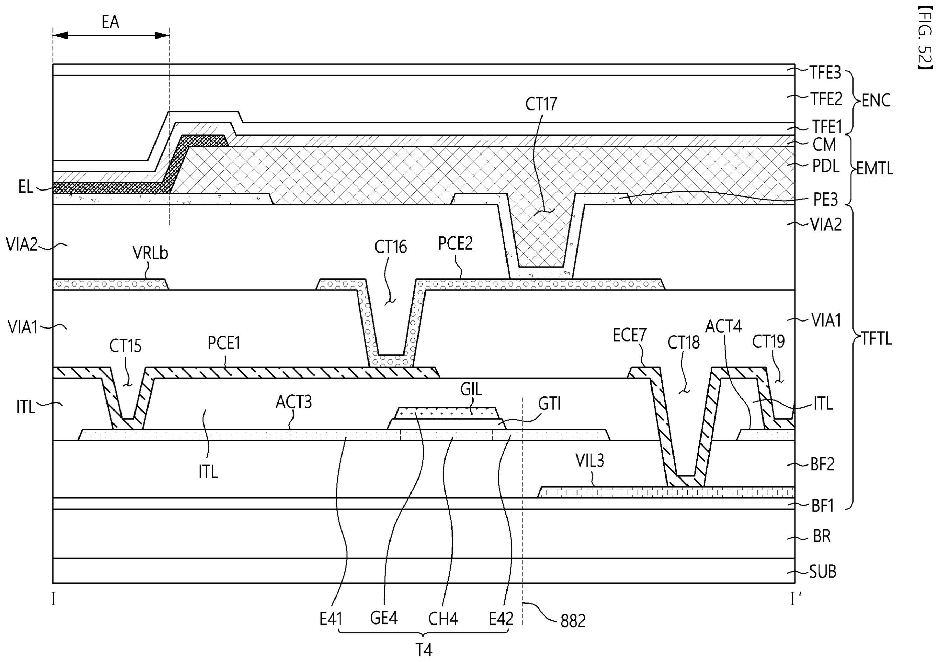

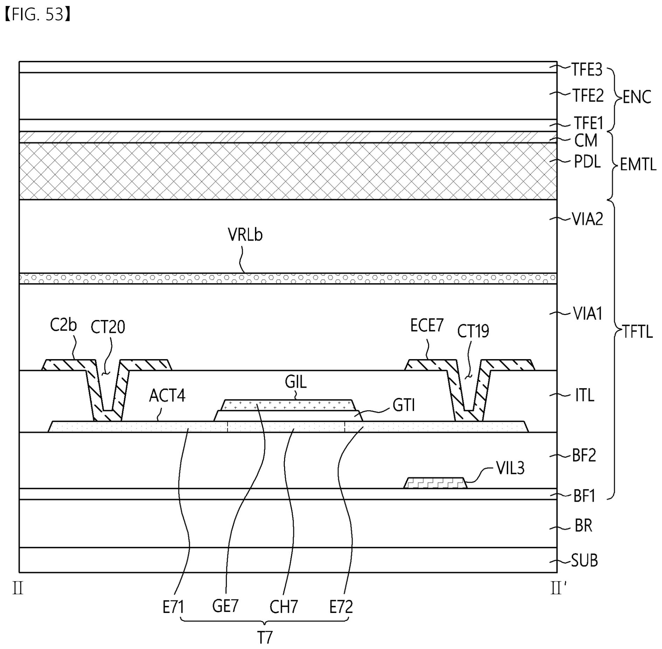

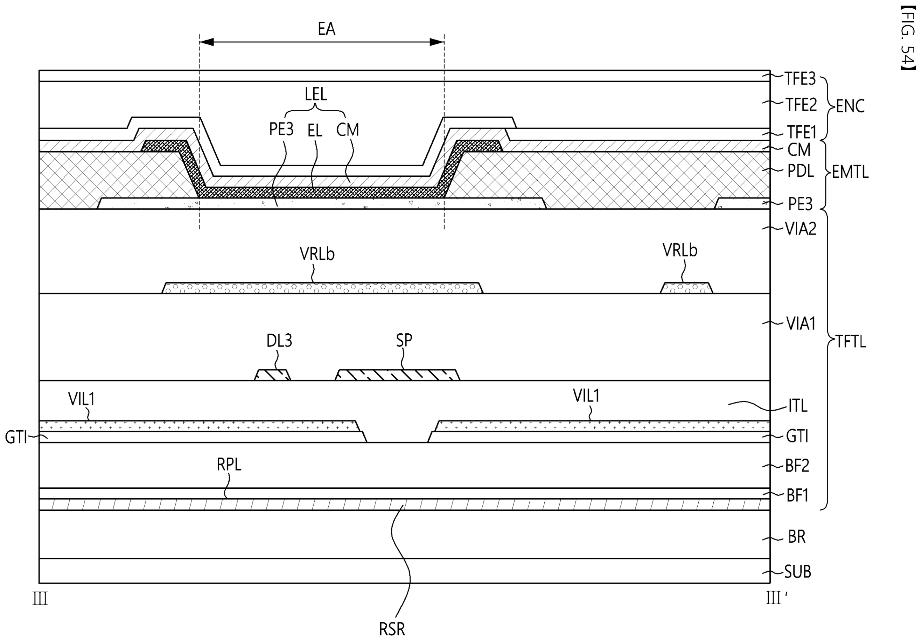

FIG. 52 is a cross-sectional view taken along line I-I' of FIG. 42, FIG. 53 is a cross-sectional view taken along line II-II' of FIG. 42, and FIG. 54 is a cross-sectional view taken along line III-III' of FIG. 42.

As illustrated in FIGS. 52 to 54, the display device 1 may include the substrate SUB, the barrier layer BR, the thin film transistor layer TFTL, the light emitting element layer EMTL, and the encapsulation layer ENC. The barrier layer BR, the thin film transistor layer TFTL, the light emitting element layer EMTL, and the encapsulation layer ENC may be sequentially disposed on the substrate SUB along the third direction DR3. Here, the thin film transistor layer TFTL may include the aforementioned pixel circuit (e.g., the third pixel circuit PC3).

Meanwhile, the cross-sectional structure of FIGS. 52 to 54 is different from the cross-sectional structure of FIGS. 33 to 38 described above in that the seventh transistor T7 and the third initialization voltage line VIL3 connected thereto are further included, so that the difference will be mainly described as follows.

As illustrated in FIG. 52, one side of the seventh line connection electrode ECE7 may be connected the third initialization voltage line VIL3 through an eighteenth contact hole CT18 penetrating the interlayer insulating layer ITL and the second buffer layer BF2.

As illustrated in FIG. 53, the seventh transistor T7 may include the seventh gate electrode GE7, a seventh channel region CH7, the first electrode E71, and the second electrode E72. Here, the seventh channel region CH7, the first electrode E71, and the second electrode E72 may be part of the fourth semiconductor layer ACT4.

Here, the fourth semiconductor layer ACT4 may be disposed on the second buffer layer BF2, the seventh gate electrode GE7 may be disposed on the gate insulating layer GTI to overlap the fourth semiconductor layer ACT4, and the seventh line connection electrode ECE7 may be disposed on the interlayer insulating layer ITL.

The second upper capacitor electrode C2b may be connected to the first electrode E71 of the seventh transistor T7 through a twentieth contact hole CT20 penetrating the interlayer insulating layer ITL, and the seventh line connection electrode ECE7 may be connected to the second electrode E72 of the seventh transistor T7 through a nineteenth contact hole CT19 penetrating the interlayer insulating layer ITL.

Meanwhile, as illustrated in FIG. 54, the first initialization voltage line VIL1 corresponding to the shielding line may overlap the remaining portion of the repair line RPL except for the repair short portion RSP. In addition, as illustrated in FIG. 54, the first initialization voltage line VIL1 may overlap the third pixel electrode PE3. In other words, the first initialization voltage line VIL1 may be disposed in all areas of the overlapping area between the repair line RPL and the third pixel electrode PE3 except for the repair short portion RSP.

Meanwhile, during the repair process of the defective pixel in the structure illustrated in FIG. 42, as illustrated in FIG. 42, laser is respectively irradiated (e.g., irradiated individually twice) along the directions of the first cutting line 881 and the second cutting line 882 from the lower portion of the substrate SUB, so that a part of the third semiconductor layer ACT3 may be cut. Accordingly, the connection between the third pixel circuit PC3 and the third pixel electrode PE3 may be blocked.

Thereafter, the laser is irradiated toward the overlapping portion of the repair short portion RSP of the repair line RPL and the counter short portion SPb of the pixel connection electrode PCE from the lower portion of the substrate SUB, so that the repair line RPL and the pixel connection electrode PCE may be in contact with each other. Accordingly, the third pixel electrode PE3 may receive a voltage supplied from the dummy pixel to the repair line RPL. Accordingly, the light emitting element including the third pixel electrode PE3 may emit light normally.

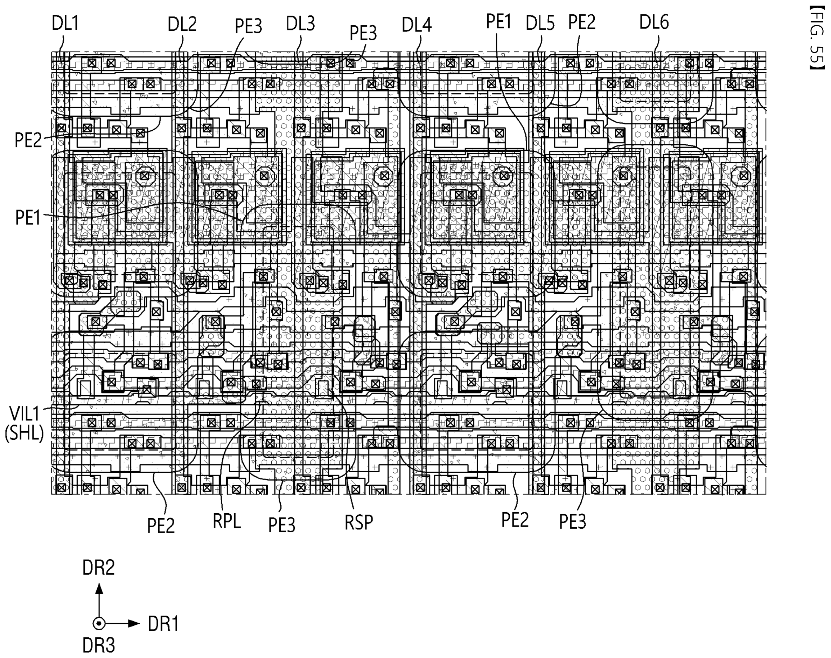

FIG. 55 is a plan view of an array in which a plurality of unit pixels of FIG. 41A are disposed.

FIG. 55 is a view illustrating the disposition of a plurality of unit pixels of FIG. 41A described above. For example, the first to third pixel electrodes PE1 to PE3 connected to the first to third data lines DL1 to DL3 through the corresponding pixel circuits may be pixel electrodes of a first unit pixel, and the first to third pixel electrodes PE1 to PE3 respectively connected to the fourth to sixth data lines DL4 to DL6 through the corresponding pixel circuits may be pixel electrodes of a second unit pixel.

As illustrated in FIG. 55, the first initialization voltage line VIL1 corresponding to the shielding line overlaps all remaining portions of the repair line RPL except for the repair short portion RSP, and as a result, the capacitance between all components (e.g., a pixel electrode, a data line, and the like) intersecting the repair line RPL may be minimized.

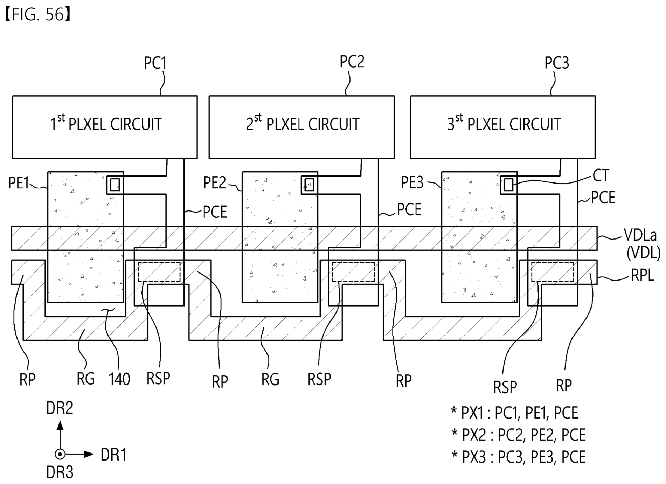

FIG. 56 is a view illustrating three pixels included in one unit pixel of a display device according to one embodiment of the present disclosure.

One unit pixel may include, for example, the first pixel PX1, the second pixel PX2, and the third pixel PX3.

Each of the pixels PX1 to PX3 may include a light emitting element and the pixel circuits PC1 to PC3 connected to the light emitting element (e.g., an anode electrode of the light emitting element corresponding to a pixel electrode). For example, the first pixel PX1 may include the first pixel circuit PC1 and the first pixel electrode PE1 of a light emitting element connected to the first pixel circuit PC1, the second pixel PX2 may include the second pixel circuit PC2 and the second pixel electrode PE2 of a light emitting element connected to the second pixel circuit PC2, and the third pixel PX3 may include the third pixel circuit PC3 and the third pixel electrode PE3 of a light emitting element connected to the third pixel circuit PC3.

The pixel electrodes PE1 to PE3 may be connected to the pixel circuits PC1 to PC3, respectively. For example, the pixel electrodes PE1 to PE3 may be connected to the pixel circuits PC1 to PC3 through the pixel connection electrodes PCE of the pixel circuits PC1 to PC3, respectively. For example, the first pixel electrode PE1 may be connected to the first pixel circuit PC1 through the pixel connection electrode PCE of the first pixel circuit PC1, the second pixel electrode PE2 may be connected to the second pixel circuit PC2 through the pixel connection electrode PCE of the second pixel circuit PC2, and the third pixel electrode PE3 may be connected to the third pixel circuit PC3 through the pixel connection electrode PCE of the third pixel circuit PC3. In this case, each of the pixel electrodes PE1 to PE3 may be connected to the corresponding pixel circuit through the corresponding contact hole.

One side (or one end) of each of the pixel connection electrodes PCE may be connected to some components (e.g., the first transistor T1 and/or the fourth transistor T4) of each of the pixel circuits PC1 to PC3 and be connected to each of the pixel electrodes through the corresponding contact hole, and the other side (or the other end) of each of the pixel connection electrodes PCE may be disposed on the corresponding repair short portion RSP to overlap the corresponding repair short portion RSP of the repair line RPL. For example, one side (or one end) of the pixel connection electrode PCE provided in the first pixel circuit PC1 may be connected to some components (e.g., the first transistor T1 and/or the fourth transistor T4) of the first pixel circuit PC1 and be connected to the first pixel electrode PE1 through the corresponding contact hole, and the other side (or the other end) of the pixel connection electrode PCE provided in the first pixel circuit PC1 may be disposed on the corresponding repair short portion RSP to overlap the corresponding repair short portion RSP of the repair line RPL.

For example, the repair line RPL may have a shape bypassing at least one pixel electrode not to overlap the at least one pixel electrode. For example, in plan view as illustrated in FIG. 56, the repair line RPL may have a concavo-convex shape (or a bent shape or a curved shape), so that the first, second, and third pixel electrodes PE1 to PE3 may be disposed in respective concave portions RG of the repair line RPL. In other words, the repair line may include at least one concave portion RG and at least one convex portion RP that are alternately disposed, so that in this case, each of the convex portions RP of the repair line RPL may be disposed between the adjacent pixel electrodes PE1 to PE3, and each of the concave portions RG of the repair line RPL may bypass (or avoid) the pixel electrode and connect the adjacent convex portions RP to each other. To this end, for example, the concave portion RG of the repair line RPL may have a curved shape (e.g., a U shape) not to intersect the pixel electrode.

At least a part of each of the pixel electrodes PE1 to PE3 may be disposed inside a U-shaped groove 140 defined by the corresponding concave portion RG. For example, the entire lower side surface of the first pixel electrode PE1, a part of the right side surface of the first pixel electrode PE1, and a part of the left side surface of the first pixel electrode PE1 may be disposed in the groove 140 defined by the concave portion RG. Here, the left side surface and right side surface of the first pixel electrode may be surfaces facing each other in the first direction.

Meanwhile, the repair short portion RSP of the repair line RPL may be disposed in each of the convex portions RP of the repair line RPL, for example. The counter short portion SPb of each of the pixel connection electrodes PCE described above may overlap the counter short portion SPb of the corresponding convex portion RP.

As such, since the repair line RPL has a concavo-convex shape, the overlap between the repair line RPL and the pixel electrodes PE1 to PE3 may be prevented, and thus the parasitic capacitance between the repair line RPL and the pixel electrodes may be minimized, so that voltage fluctuations of the repair line RPL and consequent voltage fluctuations of the pixel electrode may be prevented.

Meanwhile, each of the repair lines RPL in FIGS. 4, 5A, 22A, and 41A described above may have the same structure as the repair line RPL of FIG. 56.

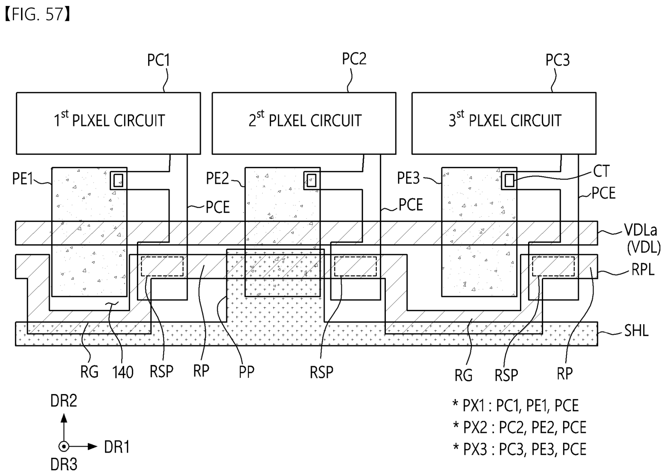

FIG. 57 is a view illustrating three pixels included in one unit pixel of a display device according to one embodiment of the present disclosure.

The repair line RPL illustrated in FIG. 57 may have a concavo-convex shape (or a bent shape or a curved shape) like the repair line RPL of FIG. 56 described above, so that some pixel electrodes PE1 and PE3 of a plurality of pixel electrodes PE1 and PE3 may be disposed in the respective concave portions RG, and the remaining pixel electrode PE2 may overlap the convex portion RP. For example, as illustrated in FIG. 57, the first pixel electrode PE1 and the third pixel electrode PE3 may be respectively disposed in the U-shaped grooves 140 defined by the concave portions RG of the repair line RPL, and at least a part of the second pixel electrode PE2 may overlap the convex portion RP of the repair line RPL. As described above, a part of the repair line RPL may not overlap the pixel electrode, and another part of the repair line RPL may overlap the pixel electrode.

Meanwhile, the shielding line SHL may cover at least a part of the repair line RPL overlapping the pixel electrode (e.g., the second pixel electrode PE2). For example, the shielding line SHL may be disposed between the convex portion RP of the repair line RPL and the second pixel electrode PE2 overlapping the convex portion RP. In other words, as in the example described above, the shielding line SHL may include the line portion LP extending along the first direction DR1 (or an extension direction of the scan line) and at least one protrusion PP protruding from the line portion LP in the second direction DR2 (or the extension direction of the data line), so that the protrusion PP of the shielding line SHL may be positioned in an overlapping area of the convex portion RP of the repair line RPL and the second pixel electrode PE2. For example, as illustrated in FIG. 57, the protrusion PP of the shielding line SHL may be disposed between the repair line RPL and the second pixel electrode PE2 to entirely overlap the overlapping area between the repair line RPL and the second pixel electrode PE2.

Meanwhile, the repair short portion RSP of the repair line RPL may be disposed in each of the convex portions RP of the repair line RPL, for example. The counter short portion SPb of each of the pixel connection electrodes PCE described above may overlap the counter short portion SPb of the corresponding convex portion RP.

As described above, the overlap between the repair line RPL and the pixel electrodes PE1 to PE3 may be prevented by the repair line RPL having a concavo-convex shape and the shielding line SHL, and thus the parasitic capacitance between the repair line RPL and the pixel electrode may be minimized, so that voltage fluctuations of the repair line RPL and consequent voltage fluctuations of the pixel electrodes may be prevented.

Meanwhile, each of the repair lines RPL in FIGS. 4, 5A, 22A, and 41A described above may have the same structure as the repair line RPL of FIG. 56. Additionally or alternatively, each of the shielding lines SHL in FIGS. 4, 5A, 22A, and 41A described above may have the same structure as the shielding line SHL of FIG. 56.

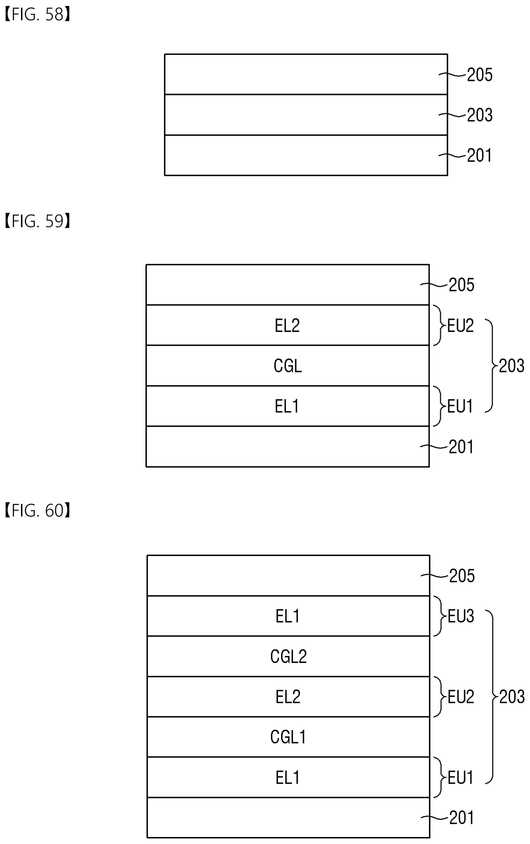

Meanwhile, referring to FIGS. 58 to 65, another structure of the light emitting element (e.g., LEL of FIGS. 16, 36, and 52) will be described.

FIG. 58 is a cross-sectional view illustrating a structure of a display element according to one embodiment of the present disclosure, and FIGS. 59 to 62 are cross-sectional views illustrating a structure of a light emitting element according to one embodiment.

Referring to FIG. 58, a light emitting element (e.g., an organic light emitting diode) according to one embodiment may include a pixel electrode 201, a common electrode 205, and an intermediate layer 203 between the pixel electrode 201 and the common electrode 205 described above.

The pixel electrode 201 may include a light-transmitting conductive oxide such as indium tin oxide (ITO), indium zinc oxide (IZO), zinc oxide (ZnO), indium oxide (In₂O₃), indium gallium oxide (IGO), or aluminium zinc oxide (AZO). The pixel electrode 201 may include a reflective layer containing silver (Ag), magnesium (Mg), aluminium (Al), platinum (Pt), palladium (Pd), gold (Au), nickel (Ni), neodymium (Nd), iridium (Ir), chromium (Cr) or a compound thereof. For example, the pixel electrode 201 may have a three-layer structure of ITO/Ag/ITO.

The common electrode 205 may be disposed on the intermediate layer 203. The common electrode 205 may include a low work function metal, an alloy, an electrically conductive compound, or any combination thereof. For example, the common electrode 205 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The common electrode 205 may be a transmissive electrode, a semi-transmissive electrode, or a reflective electrode.

The intermediate layer 203 may include a high molecular material or a low molecular material that emits light of a predetermined color. In addition to various organic materials, the intermediate layer 203 may further include metal-containing compounds such as organometallic compounds, inorganic materials such as quantum dots, and the like.

In one embodiment, the intermediate layer 203 may include one light emitting layer and a first functional layer and a second functional layer respectively disposed below and above the one light emitting layer. The first functional layer may include, for example, a hole transport layer HTL or may include the hole transport layer and a hole injection layer HIL. The second functional layer is a component disposed on the light emitting layer and is optional. For example, the intermediate layer 203 may include or may not include the second functional layer. The second functional layer may include an electron transport layer ETL and/or an electron injection layer EIL.

In one embodiment, the intermediate layer 203 may include two or more emitting units that are sequentially stacked between the pixel electrode 201 and the common electrode 205, and a charge generation layer CGL disposed between the two emitting units. When the intermediate layer 203 includes an emitting unit and a charge generation layer, a light emitting element (e.g., an organic light emitting diode) may be a tandem light emitting element. A light emitting element (e.g., an organic light emitting diode) may improve color purity and luminous efficiency by having a stacked structure of a plurality of emitting units.

One emitting unit may include a light emitting layer and a first functional layer and a second functional layer respectively disposed below and above the light emitting layer. The charge generation layer CGL may include a negative charge generation layer and a positive charge generation layer. The luminous efficiency of an organic light emitting diode, which is a tandem light emitting element having a plurality of light emitting layers, may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

In one embodiment, as illustrated in FIG. 59, a light emitting element (e.g., an organic light emitting diode) may include a first emitting unit EU1 including a first light emitting layer EL1 and a second emitting unit EU2 including a second light emitting layer EL2 that are sequentially stacked. The charge generation layer CGL may be disposed between the first emitting unit EU1 and the second emitting unit EU2. For example, a light emitting element (e.g., an organic light emitting diode) may include the pixel electrode 201, the first light emitting layer EL1, the charge generation layer CGL, the second light emitting layer EL2, and the common electrode 205 that are sequentially stacked. The first functional layer and the second functional layer may be disposed on and under the first light emitting layer EL1, respectively. The first functional layer and the second functional layer may be included below and above the second light emitting layer EL2, respectively. The first light emitting layer EL1 may be a blue light emitting layer, and the second light emitting layer EL2 may be a yellow light emitting layer.

In one embodiment, as illustrated in FIG. 60, a light emitting element (e.g., an organic light emitting diode) may include the first emitting unit EU1 and the third emitting unit EU3 including the first light emitting layer EL1, and the second emitting unit EU2 including the second light emitting layer EL2. The first charge generation layer CGL1 may be disposed between the first emitting unit EU1 and the second emitting unit EU2, and the second charge generation layer CGL2 may be disposed between the second emitting unit EU2 and the third emitting unit EU3. For example, a light emitting element (e.g., an organic light emitting diode) may include the pixel electrode 201, the first light emitting layer EL1, the first charge generation layer CGL1, the second light emitting layer EL2, the second charge generation layer CGL2, the first light emitting layer EL1, and the common electrode 205 that are sequentially stacked. The first functional layer and the second functional layer may be disposed on and under the first light emitting layer EL1, respectively. The first functional layer and the second functional layer may be disposed on and below the second light emitting layer EL2, respectively. The first light emitting layer EL1 may be a blue light emitting layer, and the second light emitting layer EL2 may be a yellow light emitting layer.

In one embodiment, in a light emitting element (e.g., an organic light emitting diode), the second emitting unit EU2 may further include a third light emitting layer EL3 and/or a fourth light emitting layer EL4 directly in contact with the second light emitting layer EL2 below and/or above the second light emitting layer EL2, in addition to the second light emitting layer EL2. Here, direct contact may mean that no other layer is disposed between the second light emitting layer EL2 and the third light emitting layer EL3 and/or between the second light emitting layer EL2 and the fourth light emitting layer EL4. The third light emitting layer EL3 may be a red light emitting layer, and the fourth light emitting layer EL4 may be a green light emitting layer.

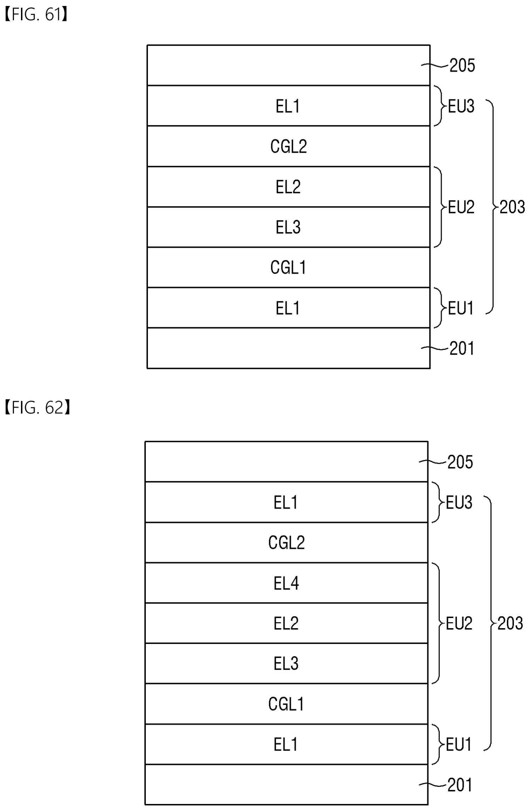

For example, as illustrated in FIG. 61, a light emitting element (e.g., an organic light emitting diode) may include the pixel electrode 201, the first light emitting layer EL1, the first charge generation layer CGL1, the third light emitting layer EL3, the second light emitting layer EL2, the second charge generation layer CGL2, the first light emitting layer EL1, and the common electrode 205 that are sequentially stacked. Alternatively, as illustrated in FIG. 62, a light emitting element (e.g., an organic light emitting diode) may include the pixel electrode 201, the first light emitting layer EL1, the first charge generation layer CGL1, the third light emitting layer EL3, the second light emitting layer EL2, the fourth light emitting layer EL4, the second charge generation layer CGL2, the first light emitting layer EL1, and the common electrode 205 that are sequentially stacked.

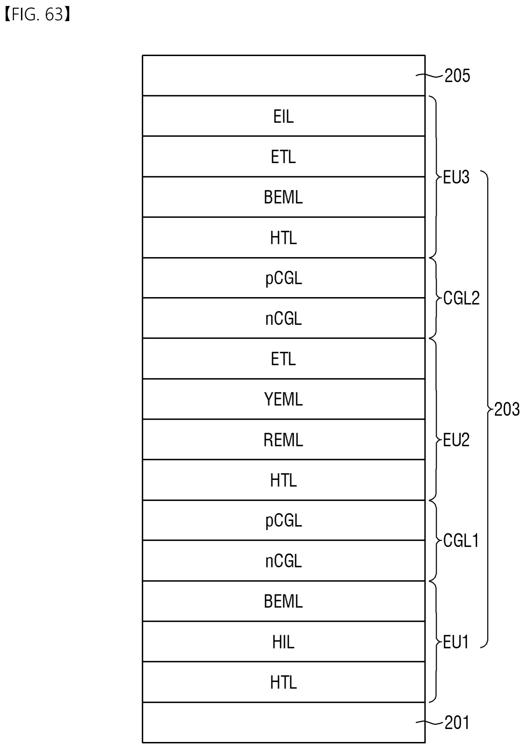

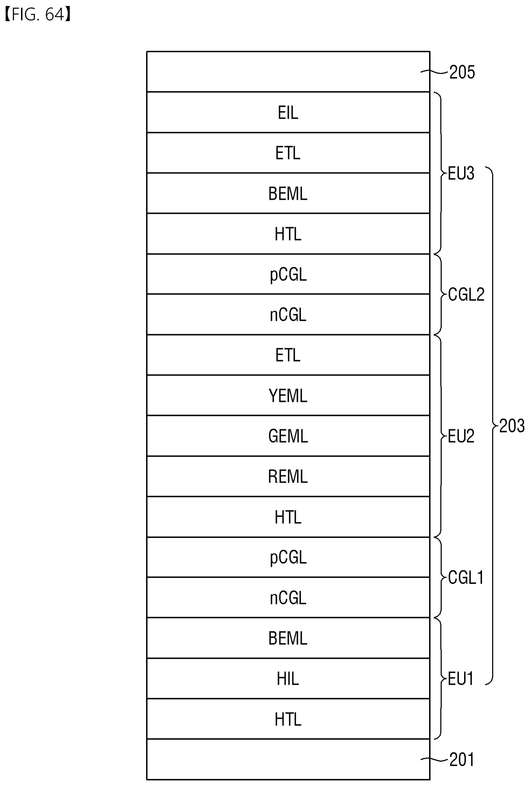

FIG. 63 is a cross-sectional view illustrating an example of the organic light emitting diode of FIG. 61, and FIG. 64 is a cross-sectional view illustrating an example of the organic light emitting diode of FIG. 62.

Referring to FIG. 63, a light emitting element (e.g., an organic light emitting diode) may include the first emitting unit EU1, the second emitting unit EU2, and the third emitting unit EU3 that are sequentially stacked. The first charge generation layer CGL1 may be disposed between the first emitting unit EU1 and the second emitting unit EU2, and the second charge generation layer CGL2 may be disposed between the second emitting unit EU2 and the third emitting unit EU3. The first charge generation layer CGL1 and the second charge generation layer CGL2 may include a negative charge generation layer nCGL and a positive charge generation layer pCGL, respectively.

The first emitting unit EU1 may include a blue light emitting layer BEML. The first emitting unit EU1 may further include the hole injection layer HIL and the hole transport layer HTL between the pixel electrode 201 and the blue light emitting layer BEML. In one embodiment, a p-doped layer may be further included between the hole injection layer HIL and the hole transport layer HTL. The P-doped layer may be formed by doping the hole injection layer HIL with a p-type doping material. In one embodiment, at least one of a blue light auxiliary layer, an electron blocking layer, or a buffer layer may be further included between the blue light emitting layer BEML and the hole transport layer HTL. The blue light auxiliary layer may increase light emission efficiency of the blue light emitting layer BEML. The blue light auxiliary layer may increase light emission efficiency of the blue light emitting layer BEML by adjusting hole charge balance. The electron blocking layer may prevent electron injection into the hole transport layer HTL. The buffer layer may compensate for a resonance distance according to a wavelength of light emitted from the light emitting layer.

The second emitting unit EU2 may include a yellow light emitting layer YEML and a red light emitting layer REML directly in contact with the yellow light emitting layer YEML below the yellow light emitting layer YEML. The second emitting unit EU2 may further include the hole transport layer HTL between the positive charge generation layer pCGL of the first charge generation layer CGL1 and the red light emitting layer REML, and may further include the electron transport layer ETL between the yellow light emitting layer YEML and the negative charge generation layer nCGL of the second charge generation layer CGL2.

The third emitting unit EU3 may include the blue light emitting layer BEML. The third emitting unit EU3 may further include the hole transport layer HTL between the positive charge generation layer pCGL of the second charge generation layer CGL2 and the blue light emitting layer BEML. The third emitting unit EU3 may further include the electron transport layer ETL and the electron injection layer EIL between the blue light emitting layer BEML and the common electrode 205. The electron transport layer ETL may have a single layer or a multilayer. In one embodiment, at least one of a blue light auxiliary layer, an electron blocking layer, or a buffer layer may be further included between the blue light emitting layer BEML and the hole transport layer HTL. At least one of a hole blocking layer or a buffer layer may be further included between the blue light emitting layer BEML and the electron transport layer ETL. The hole blocking layer may prevent hole injection into the electron transport layer ETL.

A light emitting element (e.g., an organic light emitting diode) illustrated in FIG. 64 is different from the light emitting element (e.g., an organic light emitting diode) illustrated in FIG. 63 in the stacked structure of the second emitting unit EU2, and other configurations are the same. Referring to FIG. 64, the second emitting unit EU2 may include the yellow light emitting layer YEML, the red light emitting layer REML directly in contact with the yellow light emitting layer YEML below the yellow light emitting layer YEML, and a green light emitting layer GEML directly in contact with the yellow light emitting layer YEML above the yellow light emitting layer YEML. The second emitting unit EU2 may further include the hole transport layer HTL between the positive charge generation layer pCGL of the first charge generation layer CGL1 and the red light emitting layer REML, and may further include the electron transport layer ETL between the green light emitting layer GEML and the negative charge generation layer nCGL of the second charge generation layer CGL2.

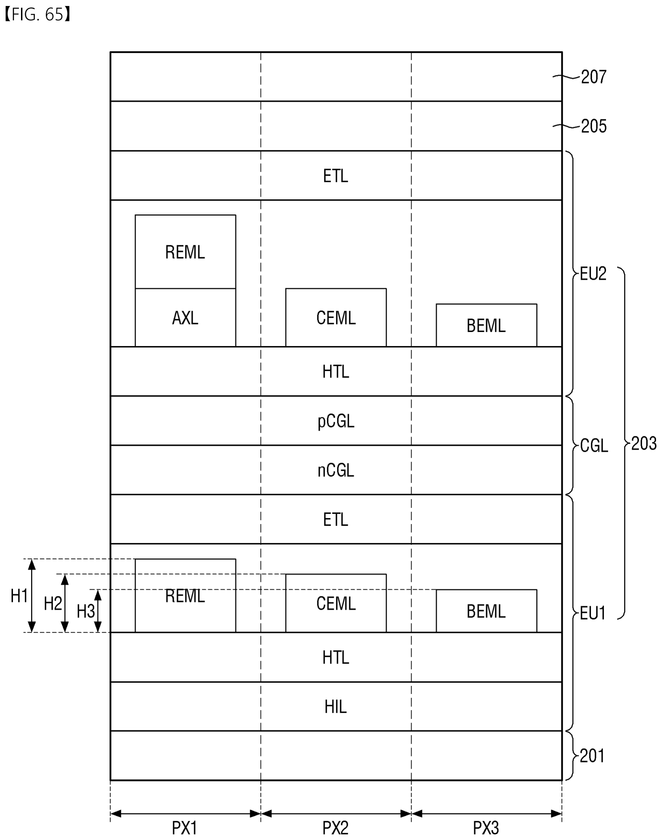

FIG. 65 is a cross-sectional view illustrating a structure of a pixel of a display device according to one embodiment of the present disclosure.

Referring to FIG. 65, the display panel 1000 of the display device 1 may include a plurality of pixels (e.g., the sub-pixels described above). The plurality of pixels may include the first pixel PX1, the second pixel PX2, and the third pixel PX3. Each of the first pixel PX1, the second pixel PX2, and the third pixel PX3 may include the pixel electrode 201, the common electrode 205, and the intermediate layer 203. In one embodiment, the first pixel PX1 may be a red pixel, the second pixel PX2 may be a green pixel, and the third pixel PX3 may be a blue pixel.

The pixel electrode 201 may be independently provided in each of the first pixel PX1, the second pixel PX2, and the third pixel PX3.

The intermediate layer 203 of each of the first pixel PX1, the second pixel PX2, and the third pixel PX3 may include the first emitting unit EU1 and the second emitting unit EU2 that are sequentially stacked, and the charge generation layer CGL between the first emitting unit EU1 and the second emitting unit EU2. The charge generation layer CGL may include the negative charge generation layer nCGL and the positive charge generation layer pCGL. The charge generation layer CGL may be a common layer continuously formed in the first pixel PX1, the second pixel PX2, and the third pixel PX3.

The first emitting unit EU1 of the first pixel PX1 may include the hole injection layer HIL, the hole transport layer HTL, the red light emitting layer REML, and the electron transport layer ETL that are sequentially stacked on the pixel electrode 201. The first emitting unit EU1 of the second pixel PX2 may include the hole injection layer HIL, the hole transport layer HTL, the green light emitting layer GEML, and the electron transport layer ETL that are sequentially stacked on the pixel electrode 201. The first emitting unit EU1 of the third pixel PX3 may include the hole injection layer HIL, the hole transport layer HTL, the blue light emitting layer BEML, and the electron transport layer ETL that are sequentially stacked on the pixel electrode 201. Each of the hole injection layer HIL, the hole transport layer HTL, and the electron transport layer ETL of the first emitting unit EU1 may be a common layer continuously formed in the first pixel PX1, the second pixel PX2, and the third pixel PX3.

The second emitting unit EU2 of the first pixel PX1 may include the hole transport layer HTL, an auxiliary layer AXL, the red light emitting layer REML, and the electron transport layer ETL that are sequentially stacked on the charge generation layer CGL. The second emitting unit EU2 of the second pixel PX2 may include the hole transport layer HTL, the green light emitting layer GEML, and the electron transport layer ETL that are sequentially stacked on the charge generation layer CGL. The second emitting unit EU2 of the third pixel PX3 may include the hole transport layer HTL, the blue light emitting layer BEML, and the electron transport layer ETL that are sequentially stacked on the charge generation layer CGL. Each of the hole transport layer HTL and the electron transport layer ETL of the first emitting unit EU1 may be a common layer continuously formed in the first pixel PX1, the second pixel PX2, and the third pixel PX3. In one embodiment, at least one of a hole blocking layer or a buffer layer may be further included between the light emitting layer and the electron transport layer ETL in the second emitting unit EU2 of the first pixel PX1, the second pixel PX2, and the third pixel PX3.

A thickness H1 of the red light emitting layer REML, a thickness H2 of the green light emitting layer GEML, and a thickness H3 of the blue light emitting layer BEML may be determined according to the resonance distance. The auxiliary layer AXL may be a layer added to adjust the resonance distance, and may include a resonance auxiliary material. For example, the auxiliary layer AXL may include the same material as the hole transport layer HTL.

In FIG. 65, the auxiliary layer AXL may be disposed only in the first pixel PX1, but the embodiment of the present disclosure is not limited thereto. For example, the auxiliary layer AXL may be disposed in at least one of the first pixel PX1, the second pixel PX2, or the third pixel PX3 to adjust the resonance distance of each of the first pixel PX1, the second pixel PX2, and the third pixel PX3.

The display panel 1000 of the display device 1 may further include a capping layer 207 disposed outside the common electrode 205. The capping layer 207 may serve to improve luminous efficiency by the principle of constructive interference. Accordingly, the light extraction efficiency of a light emitting element (e.g., an organic light emitting diode) may be increased, so that the luminous efficiency of the light emitting element (e.g., the organic light emitting diode) may be improved.

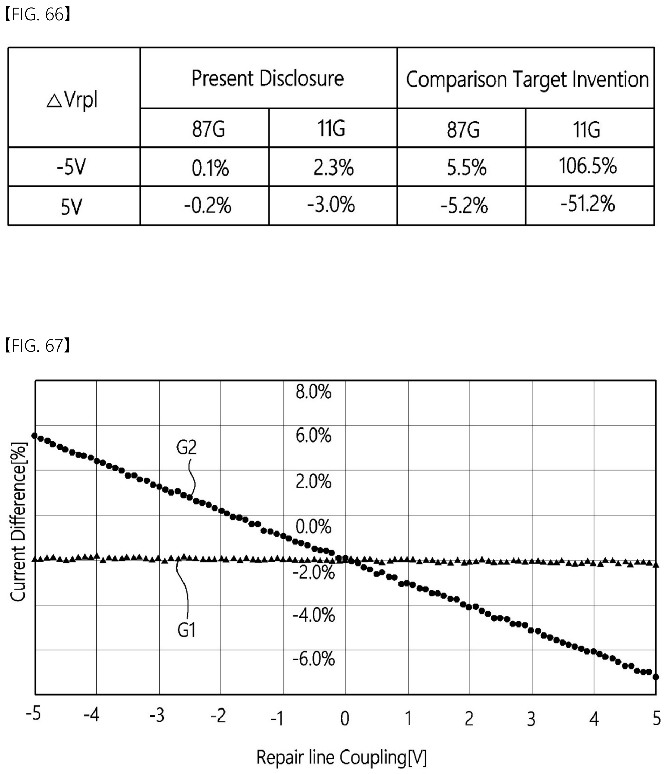

FIGS. 66 to 68 are diagrams for explaining the effects of the present disclosure.

For example, when a repair voltage fluctuating from -5 V to +5 V is applied to the repair line, it is confirmed that the current difference between the light emitting elements in the display device including the shielding line of the present disclosure almost does not fluctuate.

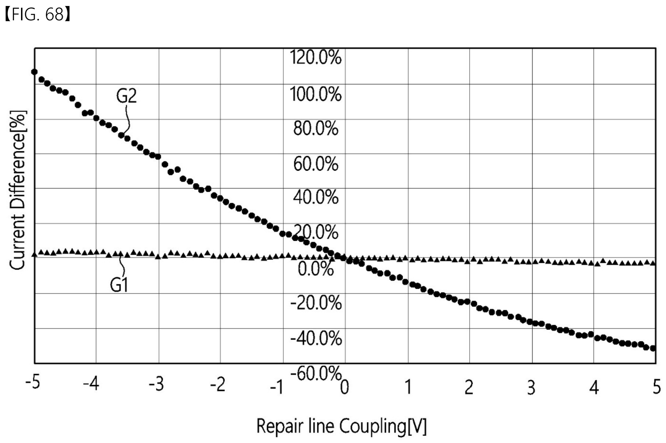

For example, as illustrated in the table of FIG. 66, the first graph of FIG. 67, and the first graph of FIG. 68, in the display device of the present disclosure, the current difference between the light emitting elements according to the coupling of the repair line at the 87th grayscale or 11th grayscale level approaches close to zero. On the other hand, as illustrated in the table of FIG. 66, the second graph of FIG. 67, and the second graph of FIG. 68, in the comparison target invention that does not include a shielding line, the current difference of the light emitting elements greatly fluctuates according to the coupling of the repair line.

Accordingly, in the display device including the shielding line of the present disclosure, the fluctuation of the current flowing through the light emitting element may be minimized despite the voltage fluctuation of the repair line.

Those skilled in the art to which this specification pertains will understand that the present specification can be embodied in other specific forms without altering the technical spirit or essential characteristics thereof. Therefore, the embodiments described above should be understood as illustrative in every aspect and not restrictive. The scope of the present specification is defined not by the foregoing detailed description but by the claims set forth below, and all changes or modifications derived from the meaning and scope of the claims and their equivalent concepts should be construed as being included within the scope of the present specification.

Meanwhile, the preferred embodiments of the present specification have been disclosed herein with the accompanying drawings. Although specific terms have been used, they are employed in a general sense to facilitate the description and understanding of the invention and are not intended to limit the scope of the specification. Beyond the embodiments disclosed herein, other modifications based on the technical spirit of the present specification will be apparent to those skilled in the art to which this specification pertains.

## Claims

1. A display device comprising:
a pixel electrode;
a pixel circuit connected to the pixel electrode;
a repair line overlapping at least a part of the pixel circuit; and
a shielding line overlapping at least a part of the repair line and connected to a constant power source.

2. The display device of claim 1, wherein the shielding line overlaps at least a part of a remaining portion of the repair line except for a repair short portion of the repair line.

3. The display device of claim 2, wherein the shielding line overlaps all remaining portions of the repair line except for the repair short portion.

4. The display device of claim 1, wherein the shielding line comprises:
a line portion extending along a first direction; and
at least one protrusion extending in a second direction crossing the first direction and overlapping at least a part of the repair line.

5. The display device of claim 4, wherein the protrusion is provided in plurality, wherein a repair short portion of the repair line is disposed between adjacent protrusions of the shielding line.

6. The display device of claim 1, wherein a part of the shielding line further overlaps the pixel electrode.

7. The display device of claim 2, wherein a part of the shielding line is disposed between the repair line and the pixel electrode.

8. The display device of claim 7, wherein a part of the shielding line is disposed between the repair line (RPL) and the pixel electrode in an overlapping area between the repair line (RPL) and the pixel electrode.

9. The display device of claim 1, wherein the shielding line and the repair line are disposed on different layers.

10. The display device of claim 1, further comprising at least one of a data line or a power line connected to the pixel circuit,
wherein at least a part of the shielding line further overlaps at least one of the data line or the power line.

11. The display device of claim 10, wherein the shielding line extends in a direction crossing at least one of the data line or the power line.

12. The display device of claim 1, wherein the constant power source provides one of a reference voltage, an initialization voltage, a first driving voltage, and a second driving voltage.

13. The display device of claim 1, wherein the shielding line is connected to the pixel circuit.

14. The display device of claim 1, wherein the pixel circuit comprises a pixel connection electrode connected to the pixel electrode, and
the repair line at least partially overlaps the pixel connection electrode of the pixel circuit.

15. The display device of claim 14, wherein the repair line is connected to the pixel connection electrode of the pixel circuit.

16. A display device comprising:
a pixel electrode;
a pixel circuit connected to the pixel electrode; and
a repair line overlapping at least a part of the pixel circuit,
wherein the repair line surrounds a part of the pixel electrode so as not to overlap the pixel electrode.

17. The display device of claim 16, wherein the repair line has a concavo-convex shape in plan view.

18. The display device of claim 17, wherein the repair line comprises:
a concave portion defining a groove in which the pixel electrode is disposed in plan view; and
a convex portion in which the repair short portion of the repair line is disposed in plan view.

19. The display device of claim 18, wherein the concave portion surrounds a part of a first side surface of the pixel electrode, a part of a second side surface facing the first side surface, and a lower side surface of the pixel electrode in plan view.

20. The display device of claim 18, wherein the groove has a U shape in plan view.

21. The display device of claim 18, wherein each convex portion of the repair line is disposed between adjacent pixel electrodes, and
each concave portion of the repair line has a curved shape to bypass the pixel electrode and connect adjacent convex portions to each other in plan view.

22. A display device comprising:
first and second pixel electrodes;
a repair line overlapping the second pixel electrode without overlapping the first pixel electrode; and
a shielding line overlapping at least a part of the repair line and at least a part of the second pixel electrode and disposed between the repair line and the second pixel electrode.

23. The display device of claim 22, wherein the shielding line is connected to a constant power source.

24. The display device of claim 23, wherein the constant power source provides one of a reference voltage, an initialization voltage, a first driving voltage, and a second driving voltage.

25. The display device of claim 22, further comprising:
a pixel circuit connected to one of the first and second pixel electrodes; and
a data line and a power line connected to the pixel circuit,
wherein a part of the shielding line overlaps the data line and the power line.

26. The display device of claim 25, wherein the shielding line extends in a direction crossing the data line and the power line.

27. The display device of claim 22, wherein the shielding line comprises:
a line portion extending along a first direction; and
at least one protrusion extending in a second direction crossing the first direction and overlapping at least a part of the repair line and at least a part of the second pixel electrode.

28. The display device of claim 27, wherein the protrusion of the shielding line is disposed between the repair line and the second pixel electrode in an overlapping area between the repair line and the second pixel electrode.

29. The display device of claim 20, wherein the repair line surrounds a part of the first pixel electrode so as not to overlap the first pixel electrode.

30. The display device of claim 29, wherein the repair line has a concavo-convex shape in plan view.

31. The display device of claim 30, wherein the repair line comprises:
a concave portion defining a groove in which the first pixel electrode is disposed in plan view; and
a convex portion in which a repair short portion of the repair line is disposed in plan view.

32. The display device of claim 31, wherein each convex portion of the repair line is disposed between a plurality of pixel electrodes comprising the first and second pixel electrodes in plan view, and
each concave portion of the repair line has a curved shape to bypass the first pixel electrode and connect adjacent convex portions to each other in plan view.

33. The display device of claim 31, wherein the second pixel electrode overlaps the convex portion of the repair line.
